# EUROPEAN PATENT APPLICATION

(11) **EP 4 676 202 A1**
(43) Date of publication of application: **07.01.2026**
(21) Application number: 25187276.8
(22) Date of filing: 03.07.2025
(51) Int. Cl.: H10K 59/122, H10K 59/123, H10K 59/80

(54) **DISPLAY PANEL AND ELECTRONIC DEVICE**

(30) Priority: 05.07.2024 KR 20240088559
(71) Applicant: Samsung Display Co., Ltd., Yongin-si, Gyeonggi-do 17113 (KR)
(72) Inventor: KIM, Sunho, 17113 Yongin-si (KR); KIM, Kyungho, 17113 Yongin-si (KR); KO, Yoomin, 17113 Yongin-si (KR); PARK, Juchan, 17113 Yongin-si (KR); CHOI, Chung Sock, 17113 Yongin-si (KR)
(74) Representative: Taor, Simon Edward William

(57) **Abstract**

Disclosed is a display panel including a driving element layer including a pixel driving portion, a first electrode disposed on the driving element layer, a pixel definition layer disposed on the driving element layer, and in which an opening exposing at least a portion of the first electrode is defined, an intermediate layer disposed on the first electrode, and including at least one light emission layer, a second electrode disposed on the intermediate layer, a low-adhesion layer disposed on the second electrode, a capping electrode disposed on the second electrode, and a separator disposed on the pixel definition layer. At least a portion of the low-adhesion layer overlaps the opening of the pixel definition layer. The capping electrode contacts a portion of the second electrode in an area spaced apart from the opening of the pixel definition layer.

## Description

### BACKGROUND

### 1. Technical Field

Embodiments of the disclosure relate to a display panel having an improved contact reliability.

### 2. Description of the Related Art

Multimedia electronic devices, such as televisions, mobile phones, tablets, computers, navigation systems, and game consoles have display panels for displaying images. The display panel includes a light emitting element and a circuit for driving the light emitting element. The light emitting elements included in the display panel emit light according to a voltage applied from the circuit and generate images. Research on a connection of the light emitting element and the circuit is being conducted to improve a reliability of the display panel.

### SUMMARY

Embodiments of the disclosure may provide a display panel having an improved contact reliability.

According to an embodiment, a display panel may include a driving element layer including a pixel driving portion, a first electrode disposed on the driving element layer, a pixel definition layer disposed on the driving element layer, and including an opening exposing at least a portion of the first electrode is defined, an intermediate layer disposed on the first electrode, and including at least one light emission layer, a second electrode disposed on the intermediate layer, a low-adhesion layer disposed on the second electrode, a capping electrode disposed on the second electrode, and a separator disposed on the pixel definition layer, at least a portion of the low-adhesion layer overlaps the opening of the pixel definition layer, and the capping electrode contacts a portion of the second electrode in an area spaced apart from the opening of the pixel definition layer.

The capping electrode may not be disposed on an upper surface of the low-adhesion layer.

The low-adhesion layer may include a fluorocarbon compound.

The capping electrode and the second electrode may include a same material.

The capping electrode may include a metal or an alloy including at least one of silver (Ag), magnesium (Mg), palladium (Pd), and copper (Cu).

The display panel may further include: a capping layer disposed on the low-adhesion layer, wherein the capping layer may cover at least a portion of the capping electrode.

The display panel may further include: a capping layer disposed between the second electrode and the low-adhesion layer, wherein the capping layer may be spaced apart from the capping electrode.

The display panel may further include: a connection electrode disposed on the pixel definition layer, and electrically connected to the pixel driving portion and the second electrode, wherein in a contact area being adjacent to the separator, each of the second electrode and the capping electrode may contact an upper surface of the connection electrode.

The connection electrode may have a ring shape surrounding the opening of the pixel definition layer, and the contact area may surround at least a portion of the opening of the pixel definition layer.

The capping electrode may have a ring shape surrounding the opening of the pixel definition layer, and the low-adhesion layer may be surrounded by the capping electrode.

The connection electrode may include a plurality of connection electrodes, gaps between adjacent ones of the plurality of connection electrodes may overlap the separator.

A through-hole spaced apart from the opening may be defined in the pixel definition layer, and the connection electrode may be electrically connected to the pixel driving portion through the through-hole.

The display panel may further include: a connection line disposed between the driving element layer and the pixel definition layer, and electrically connected to the pixel driving portion and the second electrode, wherein the connection line may include a first layer, a second layer disposed on the first layer, and a third layer disposed on the second layer, and a portion of the third layer may protrude from the second layer to define a tip portion.

In an area being adjacent to the tip portion, the second electrode may contact a side surface of the second layer, and the capping electrode contacts the second electrode.

The display panel may further include: a capping pattern covering a side surface of the second layer in an area being adjacent to the tip portion, wherein in an area being adjacent to the tip portion, the second electrode contacts the capping pattern, and the capping electrode may contact the second electrode.

The intermediate layer may further include a functional layer including a first intermediate functional layer disposed on the first electrode, and a second intermediate functional layer disposed on the light emission layer, and the light emission layer may be disposed between the first intermediate functional layer and the second intermediate functional layer.

The display panel may further include: a first dummy layer disposed on the separator, separator, the first dummy layer and the functional layer including a same material; a second dummy layer disposed on the first dummy layer, the second dummy layer and the second electrode including a same material; and a third dummy layer disposed on the second dummy layer, the third dummy layer and the low-adhesion layer including a same material.

According to an embodiment, a display panel may include a driving element layer including a pixel driving portion, and a light emitting element disposed on the driving element layer, the light emitting element may include a first electrode disposed on the driving element layer, and disposed at least in a light emission area, an intermediate layer disposed on the first electrode, at least including a light emission layer, and in which the light emission layer is disposed at least in the light emission area, a second electrode disposed on the intermediate layer, and disposed in the light emission area, a low-adhesion layer disposed on the second electrode, and disposed at least in the light emission area, and a capping electrode disposed on the second electrode, and the capping electrode contacts a portion of the second electrode in an area spaced apart from the light emission area.

The display panel may further include: a pixel definition layer disposed on the driving element layer, and in which an opening exposing at least a portion of the first electrode is defined; a connection electrode disposed on the pixel definition layer, electrically connected to the pixel driving portion and the second electrode, and including a first edge surrounding the light emission area and a second edge surrounding the first edge; and a separator disposed on the pixel definition layer, and overlapping the second edge of the connection electrode, wherein in a contact area being adjacent to the separator, each of the second electrode and the capping electrode may contact an upper surface of the connection electrode.

The display panel may further include: a pixel definition layer disposed on the driving element layer, and in which an opening exposing at least a portion of the first electrode is defined; a connection line disposed between the driving element layer and the pixel definition layer, and electrically connected to the pixel driving portion and the second electrode; and a separator disposed on the pixel definition layer, wherein the connection line may include a first layer, a second layer disposed on the first layer, and a third layer disposed on the second layer, wherein a portion of the third layer may protrude from the second layer to define a tip portion, and, in an area being adjacent to the tip portion, the second electrode may contact a side surface of the second layer, and the capping electrode contacts the second electrode.

According to an embodiment, an electronic device may include: a display panel folded or unfolded with respect to a folding axis extending in a first direction; an electronic module overlapping the display panel; and a housing accommodating the display panel, wherein the display panel may include: a driving element layer including a pixel driving portion; a first electrode disposed on the driving element layer; a pixel definition layer disposed on the driving element layer, and including an opening exposing at least a portion of the first electrode is defined; an intermediate layer disposed on the first electrode, and including at least one light emission layer; a second electrode disposed on the intermediate layer; a low-adhesion layer disposed on the second electrode; a capping electrode disposed on the second electrode; and a separator disposed on the pixel definition layer, at least a portion of the low-adhesion layer may overlap the opening of the pixel definition layer, and the capping electrode may contacts a portion of the second electrode in an area spaced apart from the opening of the pixel definition layer.

The electronic device may be at least one of a smart watch, a mobile phone, a smartphone, a portable computer, a tablet personal computer (PC), a watch phone, an automotive display, a smart glass, a portable multimedia player (PMP), a navigation system, an ultra-mobile computer (UMPC), a head mounted display (HMD) device, a virtual reality (VR) device, a mixed reality (MR) device, and an augmented reality (AR) device.

According to an aspect, there is provided a display panel as set out in claim 1. Additional features are set out in claims 2 to 11. According to an aspect, there is provided a display panel as set out in claim 12. Additional features are set out in claim 13. According to an aspect, there is provided an electronic device as set out in claim 14. Additional features are set out in claim 15.

### BRIEF DESCRIPTION OF THE DRAWINGS

The above and other objects and features of the disclosure will become apparent by describing in detail embodiments thereof with reference to the accompanying drawings.
FIG. 1 is a schematic block diagram of a display device according to an embodiment of the disclosure.
FIG. 2A is a schematic diagram of an equivalent circuit of a pixel according to an embodiment of the disclosure.
FIG. 2B is a schematic diagram of an equivalent circuit of a pixel according to an embodiment of the disclosure.
FIG. 2C is a schematic diagram of an equivalent circuit of a pixel according to an embodiment of the disclosure.
FIG. 3A is a schematic plan view illustrating a display panel according to an embodiment of the disclosure.
FIG. 3B is a schematic view illustrating a display panel according to an embodiment of the disclosure.
FIG. 4A is an enlarged schematic plan view of a partial area of a display panel according to an embodiment of the disclosure.
FIG. 4B is an enlarged schematic plan view of a partial area of a display panel according to an embodiment of the disclosure.
FIG. 4C is an enlarged schematic plan view of a partial area of a display panel according to an embodiment of the disclosure.
FIG. 4D is an enlarged schematic plan view of a partial area of a display panel according to an embodiment of the disclosure.
FIG. 5 is a schematic cross-sectional view of a display panel according to an embodiment of the disclosure.
FIG. 6A is an enlarged schematic cross-sectional view illustrating a partial area of a display panel according to an embodiment of the disclosure.
FIG. 6B is an enlarged schematic plan view of a partial area of a display panel according to an embodiment of the disclosure.
FIGS. 7A and 7B are schematic cross-sectional views illustrating a light emitting element according to an embodiment of the disclosure.
FIG. 8 is an enlarged schematic cross-sectional view illustrating a partial area of a display panel according to an embodiment of the disclosure.
FIGS. 9A and 9B are schematic cross-sectional views illustrating a light emitting element according to an embodiment of the disclosure.
FIG. 10 is a schematic cross-sectional view of a display panel according to an embodiment of the disclosure.
FIG. 11A is an enlarged schematic plan view of a partial area of a display panel according to an embodiment of the disclosure.
FIG. 11B is an enlarged schematic plan view of a partial area of a display panel according to an embodiment of the disclosure.
FIG. 12 is a schematic cross-sectional view of a display panel according to an embodiment of the disclosure.
FIG. 13A is an enlarged schematic cross-sectional view illustrating a partial area of a display panel according to an embodiment of the disclosure.
FIG. 13B is an enlarged schematic cross-sectional view illustrating a partial area of a display panel according to an embodiment of the disclosure.
FIG. 14A is an enlarged schematic cross-sectional view illustrating a partial area of a display panel according to an embodiment of the disclosure.
FIG. 14B is an enlarged schematic cross-sectional view illustrating a partial area of a display panel according to an embodiment of the disclosure.
FIG. 15A is a schematic cross-sectional view of a display panel according to an embodiment of the disclosure.
FIG. 15B is an enlarged schematic cross-sectional view illustrating a partial area of a display panel according to an embodiment of the disclosure.
FIG. 16 is a schematic perspective view of an electronic device according to an embodiment of the disclosure.
FIG. 17 is a schematic view illustrating a folded state of the electronic device illustrated in FIG. 16.
FIG. 18 is an exploded schematic perspective view of the electronic device illustrated in FIG. 16.
FIG. 19 is a schematic block diagram of the electronic device illustrated in FIG. 18.
FIG. 20 is a schematic view showing an example of a smart watch including a display device according to an embodiment of the disclosure.

### DETAILED DESCRIPTION OF THE EMBODIMENTS

In the disclosure, in case that it is mentioned that a component (or an area, a layer, a part, or the like) is "disposed on", "connected to", or "coupled to" another component, it means that the former component may be directly disposed on, connected to, or coupled to the latter component or a third component may be disposed between the components.

The same reference numerals denote the same components. In the drawings, thicknesses, ratios, dimensions of the components are exaggerated for an effective description of the technical contents. The term "and/or" includes one or more combinations that may be defined by the associated components.

In describing the various components, the terms, such as first and second may be used, but the disclosure is not limited by the terms. The terms are simply for distinguishing the components. For example, a first component may be named a second component, and similarly the second component also may be named the first component while not departing from the scope of the disclosure. A singular expression includes a plural expression unless an exemption is explicitly described in the context.

The terms, such as "under", "below", "on", and "above", are used to describe an associative relationship between the components illustrated in the drawings. The terms are relative concepts, and are described with respect to directions indicated in the drawings.

In case that the terms, such as "comprise" and/or "comprising", is used in the disclosure, it should be understood that they specify presence of the above-mentioned features, numbers, steps, operations, components, parts, and/or combinations thereof, and do not exclude presence or addition of one or more other numbers, steps, operations, components, parts, and/or combinations thereof.

The terms "part" and "unit" refer to a software component or a hardware component that performs a specific function. A hardware component may include, for example, a field-programmable gate array (FPGA) or an application-specific integrated circuit (ASIC). A software component may refer to executable code and/or data used by the executable code in an addressable storage medium. Thus, software components may be, for example, object-oriented software components, class components, and task components, and may include processes, functions, properties, procedures, subroutines, program code segments, drivers, firmware, microcodes, circuits, data, databases, data structures, tables, arrays, or variables.

Unless otherwise defined, all terms, including technical and scientific terms, used herein have the same meaning as commonly understood by those skilled in the art to which the disclosure pertains. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein.

Hereinafter, embodiments of the disclosure will be described with reference to the drawings.

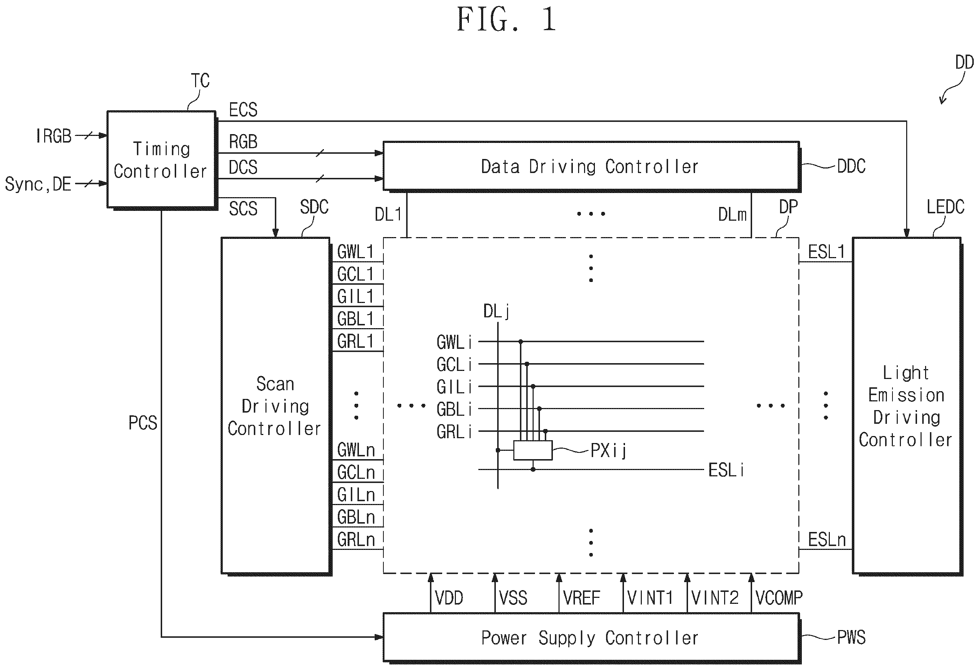

FIG. 1 is a schematic block diagram of a display device DD according to an embodiment of the disclosure.

Referring to FIG. 1, the display device DD may include a display panel DP, a panel driving module including a scan driving controller SDC, a light emission driving controller LEDC, and a data driving controller DDC, a power supply controller PWS, and a timing controller TC. The display panel DP will be described as a light emission type display panel. The light emission type display panel may include an organic light emitting display panel, an inorganic light emitting display panel, or a quantum dot light emitting display panel. In an embodiment that will be described below, an organic light emitting display panel will be described in detail as an example.

The display panel DP may include scan lines GWL1 to GWLn, GCL1 to GCLn, GIL1 to GILn, GBL1 to GBLn, and GRL1 to GRLn, light emission lines ESL1 to ESLn, and data lines DL1 to DLm. The display panel DP may include multiple pixels that are electrically connected to the scan lines GWL1 to GWLn, GCL1 to GCLn, GIL1 to GILn, GBL1 to GBLn, and GRL1 to GRLn, the light emission lines ESL1 to ESLn, and the data lines DL1 to DLm. (Here, "m" and "n" are integers that are greater than 1)

For example, a pixel PXij, (here, "I" and "j" are integers that are greater than 1) that is located on an i-th horizontal line (or an i-th pixel row) and a j-th vertical line (or a j-th pixel column) may be electrically connected to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th light emission line ESLi.

The pixel PXij may include multiple light emitting elements, multiple transistors, and multiple capacitors. The pixel PXij may be supplied with a first power supply voltage VDD, a second power supply voltage VSS, a third power supply voltage (or a reference voltage) VREF, a fourth power supply voltage (or a first initialization voltage) VINT1, a fifth power supply voltage (or a second initialization voltage) VINT2, and a sixth power supply voltage (or a compensation voltage) VCOMP, through the power supply controller PWS.

The first power supply voltage VDD and the second power supply voltage VSS are set such that that current may flow to the light emitting element to cause light emission. For example, the first power supply voltage VDD may be set to a voltage that is higher than the second power supply voltage VSS.

The third power supply voltage VREF may be a voltage for initializing a gate of the driving transistor included in the pixel PXij. The third power supply voltage VREF may be used to implement a specific grayscale by utilizing a voltage difference from a data signal. For this purpose, the third power supply voltage VREF may be set to a specific voltage in a voltage range of the data signal.

The fourth power supply voltage VINT1 may be a voltage for initializing a capacitor included in the pixel PXij. The fourth power supply voltage VINT1 may be set to a voltage that is lower than the third power supply voltage VREF. For example, the fourth power supply voltage VINT1 may be set to a voltage that is lower than a difference between the third power supply voltage VREF and a threshold voltage of the driving transistor. However, embodiments of the disclosure are not limited thereto.

The fifth power supply voltage VINT2 may be a voltage for initializing a cathode of the light emitting element included in the pixel PXij. The fifth power supply voltage VINT2 may be set to a voltage that is lower than the first power supply voltage VDD or the fourth power supply voltage VINT1, or may be set to a voltage that is similar to or the same as the third power supply voltage VREF, but is not limited thereto, and the fifth power supply voltage VINT2 may also be set to a voltage that is similar to or the same as the first power supply voltage VDD.

The sixth power supply voltage VCOMP may supply a specific current to the driving transistor when compensating for a threshold voltage of the driving transistor.

FIG. 1 illustrates that the first to sixth power supply voltages VDD, VSS, VREF, VINT1, VINT2, and VCOMP are all supplied from the power supply controller PWS, but embodiments of the disclosure are not limited thereto. For example, the first power supply voltage VDD and the second power supply voltage VSS may be all supplied regardless of the structure of the pixel PXij, and at least one of the third power supply voltage VREF, the fourth power supply voltage VINT1, the fifth power supply voltage VINT2, and the sixth power supply voltage VCOMP may not be supplied based on a structure of the pixel PXij.

Signal lines electrically connected to the pixel PXij may be set variously based on a circuit structure of the pixel PXij.

The scan driving controller SDC may receive a first control signal SCS from the timing controller TC, and may supply scan signals to the first scan lines GWL1 to GWLn, the second scan lines GCL1 to GCLn, the third scan lines GIL1 to GILn, the fourth scan lines GBL1 to GBLn, and the fifth scan lines GRL1 to GRLn based on the first control signal SCS.

The scan signal may be set to a voltage, at which the transistors that have received the scan signal may be turned on. For example, the scan signal supplied to the P-type transistor may be set to a logic low level, and the scan signal supplied to the N-type transistor may be set to a logic high level. Hereinafter, the meaning of "the scan signal is supplied" may be understood as that the scan signal is supplied at a logic level that turns on the transistor controlled thereby.

For convenience of explanation, FIG. 1 illustrates that the scan driving controller SDC has a single configuration, but embodiments of the disclosure are not limited thereto. According to an embodiment, multiple scan driving controllers may be included to supply the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The light emission driving controller LEDC may supply light emission signals to the light emission lines ESL1 to ESLn based on the second control signal ECS. For example, the light emission signals may be sequentially supplied to the light emission lines ESL1 to ESLn.

The transistors electrically connected to the light emission lines ESL1 to ESLn may be configured as N-type transistors. Then, the light emission signal supplied to the light emission lines ESL1 to ESLn may be set to a gate-off voltage. The transistors receiving the light emission signal may be turned off in case that the light emission signal is supplied, and may be set to a turn-on state in other cases.

The second control signal ECS may include a light emission start signal and clock signals, and the light emission driving controller LEDC may be implemented as a shift register that sequentially shifts the light emission start signal in a pulse form by using the clock signals to sequentially generate and output the light emission signal in a pulse form.

The data driving controller DDC may receive the third control signal DCS and image data RGB from the timing controller TC. The data driving controller DDC may convert image data RGB in a digital form into an analog data signal (i.e., a data signal). The data driving controller DDC may supply the data signal to the data lines DL1 to DLm in response to the third control signal DCS.

The third control signal DCS may include a data enable signal, a horizontal start signal, a data clock signal, and the like that instruct an output of an effective data signal. For example, the data driving controller DDC may include a shift register that shifts a horizontal start signal in synchronization with a data clock signal and may generate a sampling signal, a latch that latches the image data RGB in response to the sampling signal, a digital-to-analog converter (or a decoder) that converts the latched image data (e.g., data in a digital form) into data signals in an analog form, and buffers (or amplifiers) that output the data signals to the data lines DL1 to DLm.

The power supply controller PWS may supply a first power supply voltage VDD, a second power supply voltage VSS, and a third power supply voltage VREF for driving the pixel PXij to the display panel DP. The power supply controller PWS may supply at least one of a fourth power supply voltage VINT1, a fifth power supply voltage VINT2, and a sixth power supply voltage VCOMP to the display panel DP.

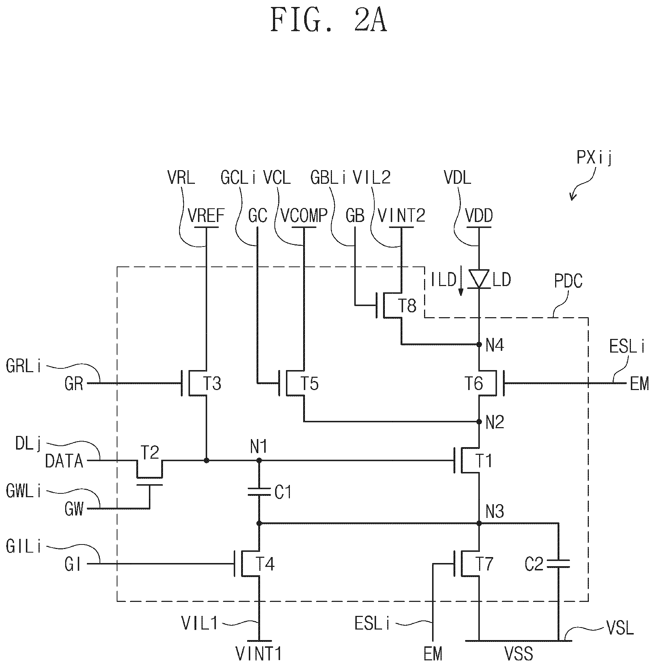

For example, the power supply controller PWS may supply the first power supply voltage VDD, the second power supply voltage VSS, the third power supply voltage VREF, the fourth power supply voltage VINT1, the fifth power supply voltage VINT2, and the sixth power supply voltage VCOMP to the display panel DP via the first power supply line VDL (see FIG. 2A), the second power supply line VSL (see FIG. 2A), the third power supply line (or the reference voltage line VRL) (see FIG. 2A), the fourth power supply line (or the first initialization voltage line VIL1) (see FIG. 2A), the fifth power supply line (or the second initialization voltage line VIL2) (see FIG. 2A), and the sixth power supply line (or the compensation voltage line VCL) (see IG. 2A), which are not illustrated.

The power supply controller PWS may be implemented as a power supply management integrated circuit, but is not limited thereto.

The timing controller TC may generate a first control signal SCS, a second control signal ECS, a third control signal DCS, and a fourth control signal PCS based on input image data IRGB, a synchronous signal Sync (for example, a vertical synchronous signal, a horizontal synchronous signal, and the like.), a data enable signal DE, and a clock signal. The first control signal SCS may be supplied to the scan driving controller SDC, the second control signal ECS may be supplied to the light emission driving controller LEDC, the third control signal DCS may be supplied to the data driving controller DDC, and the fourth control signal PCS may be supplied to the power supply controller PWS. The timing controller TC may rearrange the input image data IRGB in correspondence to the arrangement of pixels PXij in the display panel DP to generate the image data RGB (or frame data).

The scan driving controller SDC, the light emission driving controller LEDC, the data driving controller DDC, the power supply controller PWS, and/or the timing controller TC may be formed (or directly formed) on the display panel DP, or may be provided in the form of a separate driving chip and may be electrically connected to the display panel DP. At least two of the scan driving controller SDC, the light emission driving controller LEDC, the data driving controller DDC, the power supply controller PWS, and the timing controller TC may be provided as one driving chip. For example, the data driving controller DDC and the timing controller TC may be provided as one driving chip.

The display device DD according to an embodiment has been described with reference to FIG. 1, but the display device of embodiments of the disclosure are not limited thereto. Based on the configuration of the pixels, signal lines may be additionally added or omitted. A connection relationship between one pixel and the signal lines may also be changed. In case that one of the signal lines is omitted, another signal line may replace the omitted signal line.

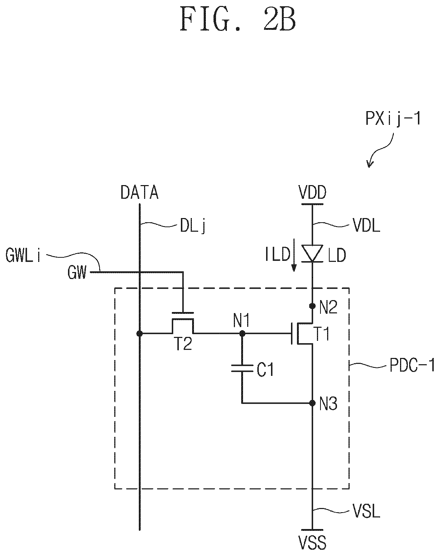

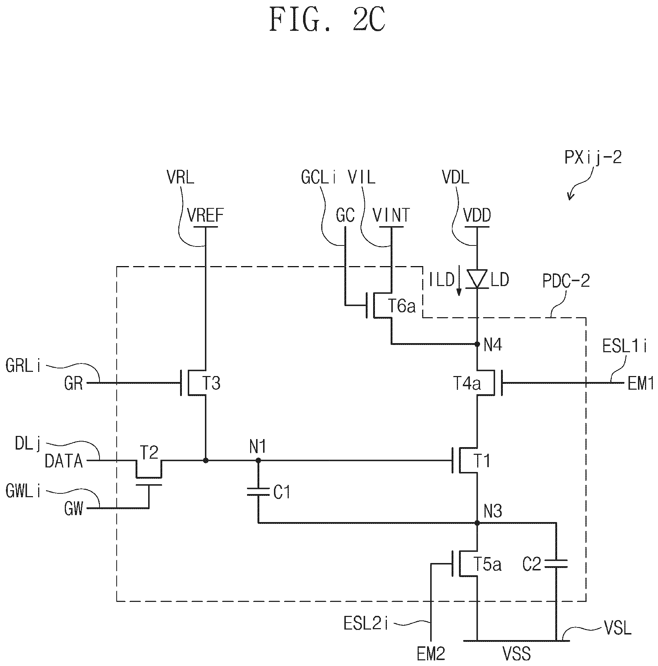

FIGS. 2A, 2B, and 2C are schematic diagrams of an equivalent circuit of the pixels according to an embodiment of the disclosure. FIGS. 2A, 2B, and 2C illustrate, by way of example, equivalent circuits of pixels PXij, PXij-1, and PXij-2 that are electrically connected to an i-th first scan line GWLi, (hereinafter referred to as the first scan line) and electrically connected to a j-th data line DLj (hereinafter, referred to as the data line), respectively.

As illustrated in FIG. 2A, the pixel PXij may include the light emitting element LD and the pixel driving portion PDC. The light emitting element LD may be electrically connected to a first power supply line VDL and the pixel driving portion PDC.

The pixel driving portion PDC may be electrically connected to multiple scan lines GWLi, GCLi, GILi, GBLi, and GRLi, a data line DLj, a light emission line ESLi, and multiple power supply voltage lines VDL, VSL, VIL1, VIL2, VRL, and VCL. The pixel driving portion PDC may include first to eighth transistors T1, T2, T3, T4, T5, T6, T7, and T8, a first capacitor C1, and a second capacitor C2. Hereinafter, a case, in which the first to eighth transistors T1, T2, T3, T4, T5, T6, T7, and T8 are all of an N-type, will be described as an example. However, embodiments of the disclosure are not limited thereto, and some of the first to eighth transistors T1 to T8 may be N-type transistors and the remaining ones may be P-type transistors, and all of the first to eighth transistors T1 to T8 may be a P-type transistor, and embodiments of the disclosure are not limited to any one embodiment.

The gate of the first transistor T1 may be electrically connected to the first node N1. The first electrode of the first transistor T1 may be electrically connected to the second node N2 and the second electrode may be electrically connected to the third node N3. The first transistor T1 may be a driving transistor. The first transistor T1 may control a driving current ILD that flows from the first power supply line VDL to the second power supply line VSL via the light emitting element LD in response to a voltage of the first node N1. Then, the first power supply voltage VDD may be set to a voltage having a potential that is higher than that of the second power supply voltage VSS.

In the disclosure, "electrically connected between a transistor and a signal line or between a transistor and a transistor" means "the source, drain, and gate of the transistor have a shape that is integral with the signal line or are connected through a connection electrode".

A second transistor T2 may include a gate that is electrically connected to the write scan line GWLi, a first electrode that is electrically connected to the data line DLj, and a second electrode that is electrically connected to the first node N1. The second transistor T2 may supply a data signal DATA to the first node N1 in response to a write scan signal GW transmitted through the write scan line GWLi. The second transistor T2 may be turned on in case that a write scan signal GW is supplied to the write scan line GWLi to electrically connect the data line DLj and the first node N1.

A third transistor T3 may be electrically connected between the first node N1 and the reference voltage line VRL. The first electrode of the third transistor T3 may receive a reference voltage VREF through a reference voltage line VRL, and the second electrode of the third transistor T3 may be electrically connected to the first node N1. A gate of the third transistor T3 may receive a reset scan signal GR through an i-th fifth scan line GRLi (hereinafter, referred to as the reset scan line). The third transistor T3 may be turned on in case that the reset scan signal GR is supplied to the reset scan line GRLi to provide the reference voltage VREF to the first node N1.

A fourth transistor T4 may be electrically connected between the third node N3 and a first initialization voltage line VIL1. A first electrode of the fourth transistor T4 may be electrically connected to the third node N3, and a second electrode of the fourth transistor T4 may be electrically connected to a first initialization voltage line VIL1 that provides a first initialization voltage VINT1. The fourth transistor T4 may be referred to as a first initialization transistor. A gate of the fourth transistor T4 may receive a first initialization scan signal GI through an i-th third scan line GILi (hereinafter, referred to as the first initialization scan line). In case that the first initialization scan signal GI is supplied to the first initialization scan line GILi, the fourth transistor T4 may be turned on to supply the first initialization voltage VINT1 to the third node N3.

A fifth transistor T5 may be electrically connected between the compensation voltage line VCL and the second node N2. The first electrode of the fifth transistor T5 may receive a compensation voltage VCOMP through a compensation voltage line VCL, and the second electrode of the fifth transistor T5 may be electrically connected to the second node N2 and may be electrically connected to the first electrode of the first transistor T1. A gate of the fifth transistor T5 may receive a compensation scan signal GC through an i-th second scan line GCLi (hereinafter referred to as a compensation scan line). In case that the compensation scan signal GC is supplied to the compensation scan line GCLi, the fifth transistor T5 may be turned on to provide a compensation voltage VCOMP to the second node N2, and a threshold voltage of the first transistor T1 may be compensated for during a compensation period.

A sixth transistor T6 may be electrically connected between the first transistor T1 and the light emitting element LD. A gate of the sixth transistor T6 may receive a light emission signal EM through an i-th light emission line ESLi (hereinafter, referred to as light emission line). The first electrode of the sixth transistor T6 may be electrically connected to the cathode of the light emitting element LD through a fourth node N4, and the second electrode of the sixth transistor T6 may be electrically connected to the first electrode of the first transistor T1 through the second node N2. The sixth transistor T6 may be referred to as a first light emission control transistor. In case that the light emission signal EM is supplied to the light emission line ESLi, the sixth transistor T6 may be turned on to electrically connect the light emitting element LD to the first transistor T1.

A seventh transistor T7 may be electrically connected between the second power supply line VSL and the third node N3. A first electrode of the seventh transistor T7 may be electrically connected to a second electrode of the first transistor T1 through the third node N3, and the second electrode of the seventh transistor T7 may receive a second power supply voltage VSS through the second power supply line VSL. A gate of the seventh transistor T7 may be electrically connected to a light emission line ESLi. The seventh transistor T7 may be referred to as a second light emission control transistor. In case that a light emission signal EM is supplied to the light emission line ESLi, the seventh transistor T7 is turned on to electrically connect the second electrode of the first transistor T1 to the second power supply line VSL.

The sixth transistor T6 and the seventh transistor T7 may be illustrated as being electrically connected to the same light emission line ESLi and may be turned on through the same light emission signal EM, but this is illustrated as an example, and the sixth transistor T6 and the seventh transistor T7 may be turned on independently according to different signals that are distinguished from each other. In the pixel driving portion PDC according to an embodiment of the disclosure, any one of the sixth transistor T6 and the seventh transistor T7 may be omitted.

An eighth transistor T8 may be electrically connected between the second initialization voltage line VIL2 and the fourth node N4. For example, the eighth transistor T8 may include a gate that is electrically connected to the i-th fourth scan line GBLi (hereinafter, referred to as the second initialization scan line), a first electrode that is electrically connected to the second initialization voltage line VIL2, and a second electrode that is electrically connected to the fourth node N4. The eighth transistor T8 may be referred to as a second initialization transistor. The eighth transistor T8 may supply a second initialization voltage VINT2 to the fourth node N4 corresponding to the cathode of the light emitting element LD in response to the second initialization scan signal GB transmitted through the second initialization scan line GBLi. The cathode of the light emitting element LD may be initialized by the second initialization voltage VINT2.

Some of the second to eighth transistors T2, T3, T4, T5, T6, T7, and T8 may be turned on simultaneously through the same scan signal. For example, the eighth transistor T8 and the fifth transistor T5 may be turned on simultaneously through the same scan signal. For example, the eighth transistor T8 and the fifth transistor T5 may be operated by the same compensation scan signal GC. The eighth transistor T8 and the fifth transistor T5 may be turned on/off simultaneously by the same compensation scan signal GC. For example, the compensation scan line GCLi and the second initialization scan line GBLi may be provided substantially as a single scan line. Accordingly, the initialization of the cathode of the light emitting element LD and the compensation of threshold voltage of the first transistor T1 may be performed at the same timing. However, this is illustrated by way of example, and is not limited to any one embodiment.

According to the disclosure, the initialization of the cathode of the light emitting element LD and the compensation of the threshold voltage of the first transistor T1 may be performed by applying the same power supply voltage. For example, the compensation voltage line VCL and the second initialization voltage line VIL2 may be provided substantially as a single power supply voltage line. For example, the initialization of the cathode and the compensation of the driving transistor may be performed with a single power supply voltage so that the design of the driving unit may be simplified. However, this is illustrated by way of example, and is not limited to any one embodiment in an embodiment of the disclosure.

The first capacitor C1 may be disposed between the first node N1 and the third node N3. The first capacitor C1 may store a differential voltage between the first node N1 and the third node N3. The first capacitor C1 may be referred to as a storage capacitor.

The second capacitor C2 may be disposed between the third node N3 and the second power supply line VSL. For example, one electrode of the second capacitor C2 may be electrically connected to the second power supply line VSL supplied with the second power supply voltage VSS, and another electrode of the second capacitor C2 may be electrically connected to the third node N3. The second capacitor C2 may store a charge corresponding to a voltage difference between the second power supply voltage VSS and the third node N3. The second capacitor C2 may be referred to as a hold capacitor. The second capacitor C2 may have a storage capacity that is high compared to that of the first capacitor C1. Accordingly, the second capacitor C2 may minimize a change in a voltage of the third node N3 in response to a change in a voltage of the first node N1.

The light emitting element LD may be electrically connected to the pixel driving portion PDC through the fourth node N4. The light emitting element LD may include an anode that is electrically connected to the first power supply line VDL and a cathode that is opposite thereto. The light emitting element LD may be electrically connected to the pixel driving portion PDC through the cathode. For example, in the pixel PXij according to the disclosure, a connection node, at which the light emitting element LD and the pixel driving portion PDC are electrically connected to each other, may be the fourth node N4, and the fourth node N4 may correspond to a connection node between the first electrode of the sixth transistor T6 and the cathode of the light emitting element LD. Accordingly, the potential of the fourth node N4 may substantially correspond to the potential of the cathode of the light emitting element LD.

The anode of the light emitting element LD may be electrically connected to the first power supply line VDL, and the first power supply voltage VDD that is a constant voltage may be applied thereto, and the cathode may be electrically connected to the first transistor T1 through the sixth transistor T6. For example, in which the first to eighth transistors T1 to T8 are N-type transistors, the potential of the third node N3 corresponding to the source of the first transistor T1 that is a driving transistor may not be directly affected by the characteristics of the light emitting element LD. Accordingly, even though the light emitting element LD deteriorates, the influence on the transistors that constitutes the pixel driving portion PDC, particularly a gate-source voltage of the driving transistor, may be reduced. For example, an amount of a change in the driving current due to the deterioration of the light emitting element LD may be reduced so that an afterimage defect of the display panel due to the increased usage time may be reduced and a service life may be improved.

In another example, as illustrated in FIG. 2B, the pixel PXij-1 may include a pixel driving portion PDC-1 including two transistors T1 and T2 and one first capacitor C1. The pixel driving portion PDC-1 may be electrically connected to the light emitting element LD, the write scan line GWLi, the data line DLj, and the second power supply line VSL. The pixel driving portion PDC-1 illustrated in FIG. 2B may correspond to the pixel driving portion PDC illustrated in FIG. 2A, in which the third to eighth transistors T3 to T8 and the second capacitor C2 are omitted.

Each of the first and second transistors T1 and T2 may be of an N-type or a P-type. A case, in which each of the first and second transistors T1 and T2 is an N-type transistor, will be described as an example.

The first transistor T1 may include a gate that is electrically connected to a first node N1, a first electrode that is electrically connected to a second node N2, and a second electrode that is electrically connected to a third node N3. The second node N2 may be a node that is electrically connected to a first power supply line VDL, and the third node N3 may be a node that is electrically connected to a second power supply line VSL. The first transistor T1 may be electrically connected to a light emitting element LD through the second node N2, and to a second power supply line VSL through the third node N3. The first transistor T1 may be a driving transistor.

The second transistor T2 may include a gate that receives the write scan signal GW through the write scan line GWLi, a first electrode that is electrically connected to a data line DLj, and a second electrode that is electrically connected to the first node N1. The second transistor T2 may supply a data signal DATA to the first node N1 in response to a write scan signal GW transmitted through the write scan line GWLi.

The first capacitor C1 may include an electrode that is electrically connected to the first node N1 and an electrode that is electrically connected to a third node N3. The first capacitor C1 may store a data signal DATA that is transmitted to the first node N1.

The light emitting element LD may include an anode and a cathode. The anode of the light emitting element LD may be electrically connected to the first power supply line VDL, and the cathode thereof may be electrically connected to the pixel driving portion PDC-1 through the second node N2. The cathode of the light emitting element LD may be electrically connected to the first transistor T1. The light emitting element LD may emit light in response to an amount of current that flows in the first transistor T1 of the pixel driving portion PDC-1.

In which the first and second transistors T1 and T2 are N-type transistors, the second node N2, to which the cathode of the light emitting element LD and the pixel driving portion PDC-1 are electrically connected, may correspond to a drain of the first transistor T1. For example, a change in the gate-source voltage of the first transistor T1 due to the light emitting element LD may be prevented. Accordingly, an amount of a change in the driving current due to the deterioration of the light emitting element LD may be reduced so that the afterimage defect of the display panel due to the increased usage time may be reduced and the service life may be improved.

In another example, as illustrated in FIG. 2C, the pixel PXij-2 may include a pixel driving portion PDC-2 including six transistors T1 and T2, T3, T4a, T5a, and T6a and two capacitors C1 and C2.

The pixel driving portion PDC-2 may be electrically connected to the light emitting element LD, the write scan line GWLi, the reset scan line GRLi, the compensation scan line GCLi, the i-th first light emission line ESL1i (hereinafter, referred to as the first light emission line), the i-th second light emission line ESL2i (hereinafter, referred to as the second light emission line), the data line DLj, the first power supply line VDL, the second power supply line VSL, the third power supply line VRL, and the initialization voltage line VIL.

The pixel driving portion PDC-2 illustrated in FIG. 2C may be similar to a structure of the pixel driving portion PDC illustrated in FIG. 2A, in which the fourth transistor T4 and the fifth transistor T5 are omitted. Because an extent of the pixel driving portion PDC-2 illustrated in FIG. 2C is smaller than that of the pixel driving portion PDC-1 illustrated in FIG. 2A, a high resolution may be implemented more easily.

Each of the first to sixth transistors T1 and T2, T3, T4a, T5a, and T6a may be of an N-type or a P-type. A case, in which each of the first to sixth transistors T1 and T2, T3, T4a, T5a, and T6a is an N-type transistor, will be described by way of example.

The first transistor T1 may include a gate that is electrically connected to a first node N1, a first electrode that is electrically connected to a second node N2, and a second electrode that is electrically connected to a third node N3. The second node N2 may be a node that is electrically connected to a first power supply line VDL, and the third node N3 may be a node that is electrically connected to a second power supply line VSL. The first transistor T1 may be electrically connected to a light emitting element LD through the second node N2, and to a second power supply line VSL through the third node N3. The first transistor T1 may be a driving transistor.

The second transistor T2 may include a gate that receives the write scan signal GW through the write scan line GWLi, a first electrode that is electrically connected to a data line DLj, and a second electrode that is electrically connected to the first node N1. The second transistor T2 may supply a data signal DATA to the first node N1 in response to a write scan signal GW transmitted through the write scan line GWLi.

The third transistor T3 may be electrically connected between the first node N1 and the reference voltage line VRL. The first electrode of the third transistor T3 may receive ae reference voltage VREF through a reference voltage line VRL, and the second electrode of the third transistor T3 may be electrically connected to the first node N1. A gate of the third transistor T3 may receive a reset scan signal GR through the reset scan line GRLi. The third transistor T3 may be turned on in case that the reset scan signal GR is supplied to the reset scan line GRLi to provide the reference voltage VREF to the first node N1.

The fourth transistor T4a may be electrically connected between the first transistor T1 and the light emitting element LD. The gate of the fourth transistor T4a may receive the first light emission signal EM1 through the first light emission line ESL1i. The first electrode of the fourth transistor T4a may be electrically connected to the cathode of the light emitting element LD through the fourth node N4, and the second electrode of the fourth transistor T4a may be electrically connected to the first electrode of the first transistor T1 through the second node N2. The fourth transistor T4a may be referred to as a first light emission control transistor. In case that the first light emission signal EM1 is supplied to the first light emission line ESL1i, the fourth transistor T4a may be turned on to electrically connect the light emitting element LD to the first transistor T1.

The fifth transistor T5a may be electrically connected between the second power supply line VSL and the third node N3. The first electrode of the fifth transistor T5a may be electrically connected to the second electrode of the first transistor T1 through the third node N3, and the second electrode of the fifth transistor T5a may receive the second power supply voltage VSS through the second power supply line VSL. The gate of the fifth transistor T5a may be electrically connected to the second light emission line ESL2i. The fifth transistor T5a may be referred to as a second light emission control transistor. In case that the second light emission signal EM2 is supplied to the second light emission line ESL2i, the fifth transistor T5a is turned on to electrically connect the second electrode of the first transistor T1 to the second power supply line VSL.

The fourth transistor T4a and the fifth transistor T5a may be electrically connected to the first and second light emission lines ESL1i and ESL2i that are distinguished from each other, and may be turned on through the first and second light emission signals EM1 and EM2 that are distinguished from each other. For example, the fourth transistor T4a and the fifth transistor T5a may be turned on independently. However, this is only an example, and embodiments of the disclosure are not limited thereto. For example, the fourth transistor T4a and the fifth transistor T5a may be electrically connected to the same light emission line, and may be controlled by the same light emission signal. In the pixel driving portion PDC-2 according to an embodiment of the disclosure, any one of the fourth transistor T4a and the fifth transistor T5a may be omitted.

The sixth transistor T6a may be electrically connected between the initialization voltage line VIL and the fourth node N4. For example, the sixth transistor T6a may include a gate that is electrically connected to the compensation scan line GCLi, a first electrode that is electrically connected to the initialization voltage line VIL, and a second electrode that is electrically connected to the fourth node N4. The sixth transistor T6a may be referred to as an initialization transistor. The sixth transistor T6a may supply the initialization voltage VINT to the fourth node N4 corresponding to the cathode of the light emitting element LD in response to the compensation scan signal GC transmitted through the compensation scan line GCLi. The cathode of the light emitting element LD may be initialized by the initialization voltage VINT.

The first capacitor C1 may be disposed between the first node N1 and the third node N3. The first capacitor C1 may store a differential voltage between the first node N1 and the third node N3. The first capacitor C1 may be referred to as a storage capacitor.

The second capacitor C2 may be disposed between the third node N3 and the second power supply line VSL. For example, one electrode of the second capacitor C2 may be electrically connected to the second power supply line VSL supplied with the second power supply voltage VSS, and another electrode of the second capacitor C2 may be electrically connected to the third node N3. The second capacitor C2 may store a charge corresponding to a voltage difference between the second power supply voltage VSS and the third node N3. The second capacitor C2 may be referred to as a hold capacitor.

The light emitting element LD may include an anode and a cathode. The anode of the light emitting element LD is electrically connected to the first power supply line VDL, and the cathode thereof is electrically connected to the pixel driving portion PDC-2 through fourth node N4. The cathode of the light emitting element LD may be electrically connected to the first transistor T1 via the fourth transistor T4a. The light emitting element LD may emit light in response to an amount of the current that flows in the first transistor T1 of the pixel driving portion PDC-2.

In which the first to sixth transistors T1 and T2, T3, T4a, T5a, and T6a are N-type transistors, a potential of the third node N3 corresponding to the source of the first transistor T1 that is the driving transistor may not be directly affected by the characteristics of the light emitting element LD. Accordingly, even though the light emitting element LD deteriorates, the influence on the transistors that constitutes the pixel driving portion PDC-2, particularly the gate-source voltage of the driving transistor, may be reduced. For example, an amount of a change in the driving current due to the deterioration of the light emitting element LD may be reduced so that an afterimage defect of the display panel due to the increased usage time may be reduced and a service life may be improved.

FIGS. 2A, 2B, and 2C illustrate circuits for pixel driving portions PDC, PDC-1, and PDC-2 according to an embodiment of the disclosure, and the display panel according to an embodiment of the disclosure may be designed variously in terms of the number or the arrangement relationship of the transistors and the number or the arrangement relationship of the capacitors as long as the circuit is electrically connected to the cathode of the light emitting element LD, and embodiments of the disclosure are not limited to any one embodiment.

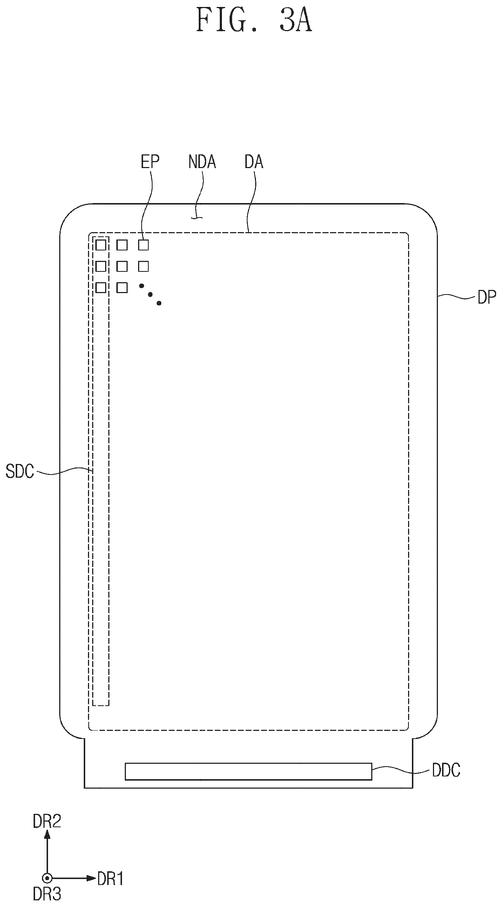

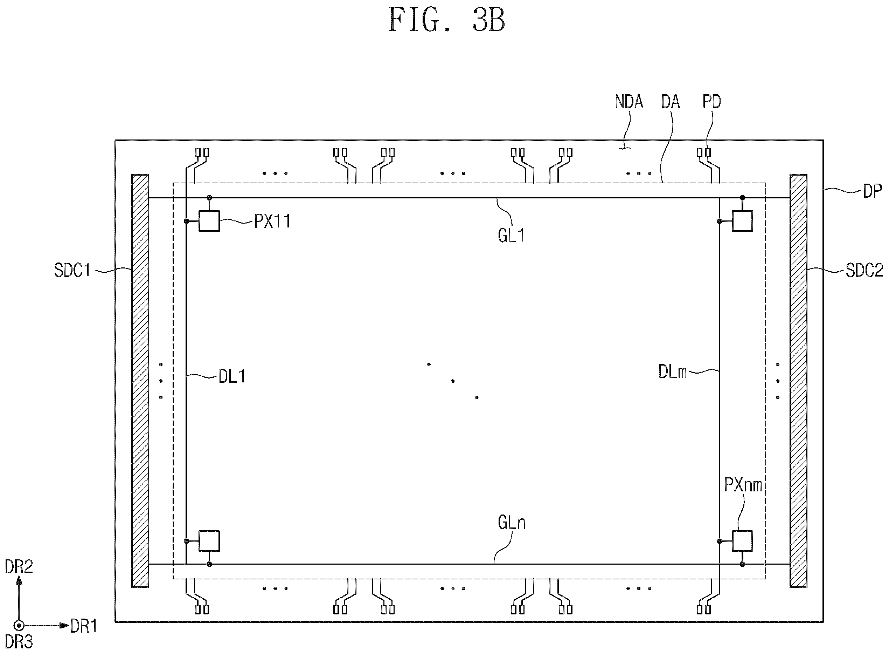

FIGS. 3A and 3B are schematic views illustrating a display panel according to an embodiment of the disclosure. In FIGS. 3A and 3B, some components may be omitted and illustrated. Hereinafter, the disclosure will be described with reference to FIGS. 3A and 3B.

Referring to FIG. 3A, a display panel DP of an embodiment may be divided into a display area DA and a peripheral area (or a non-display area) NDA. The display area DA may include multiple light emission portions EP.

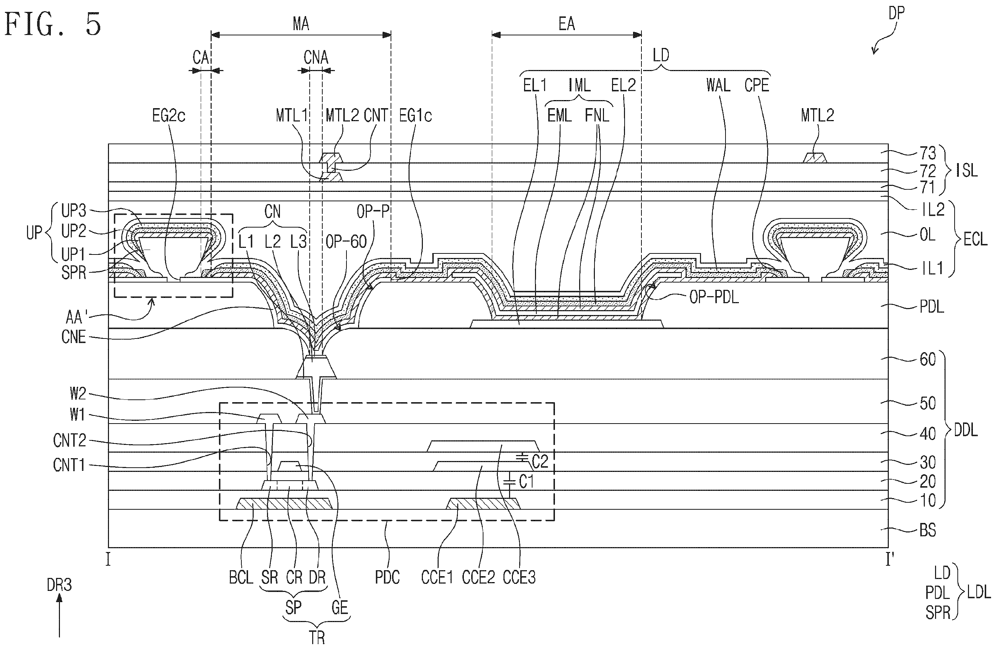

The light emission portions EP may be areas that are allowed to emit light by the pixels PXij (see FIG. 1). Each of the light emission portions EP may correspond to a light emission opening OP-PDL (see FIG. 5) that will be described below. The light emission opening OP-PDL may be referred to as an opening.

The peripheral area NDA may be disposed adjacent to the display area DA. It is illustrated that the peripheral area NDA has a shape that surrounds a periphery of the display area DA. However, this is illustrated by way of example, and the peripheral area NDA may be disposed on one side of the display area DA, or may be omitted, and embodiments of the disclosure are not limited to any one embodiment.

The scan driving controller SDC and the data driving controller DDC may be mounted on the display panel DP. The scan driving controller SDC may be disposed in the display area DA, and the data driving controller DDC may be disposed in the peripheral area NDA. The scan driving controller SDC may overlap at least some of the light emitting portions EP disposed in the display area DA in a plan view. As the scan driving controller SDC is disposed in the display area DA, the peripheral area NDA extent may be reduced compared to a conventional display panel, in which a scan driving controller is disposed in a peripheral area, and a display device having a thin bezel may be easily implemented.

Unlike the illustration of FIG. 3A, the scan driving controller SDC may be provided as two divided parts. The two scan driving controllers SDC may be disposed spaced apart from each other leftward and rightward with the center of the display area DA being interposed therebetween. Two or more scan driving controllers SDC may be provided, and embodiments of the disclosure are not limited to any one embodiment.

FIG. 3A illustrates an example of a display panel, and the data driving controller DDC may be disposed in the display area DA. Then, some of the light emission portions EP disposed in the display area DA may overlap the data driving controller DDC in a plan view.

The data driving controller DDC may be provided in the form of a separate driving chip that is independent from the display panel DP, and may be electrically connected to the display panel DP. However, this is described as an example, and the data driving controller DDC may be formed in the same process as that of the scan driving controller SDC to constitute the display panel DP, and embodiments of the disclosure are not limited to any one embodiment.

As illustrated in FIG. 3B, the display panel DP may have shape, in which a length corresponding to a first direction DR1 is greater than a length corresponding to a second direction DR2. In the display area DA, multiple pixels PX11 to PXnm disposed in "n" columns and "m" rows are illustrated as an example. The display panel DP may include multiple scan driving controllers SDC1 and SDC2. It is illustrated, by way of example, that the scan driving controllers SDC1 and SDC2 include a first scan driving controller SDC1 and a second scan driving controller SDC2 that are spaced apart from each other in the first direction DR1.

The first scan driving controller SDC1 may be electrically connected to some of the scan lines GL1 to GLn, and the second scan driving controller SDC2 may be electrically connected to others of the scan lines GL1 to GLn. For example, the first scan driving controller SDC1 may be electrically connected to odd-numbered scan lines, among the scan lines GL1 to GLn, and the second scan driving controller SDC2 may be electrically connected to even-numbered scan lines, among the scan lines GL1 to GLn.

In FIG. 3B, pads PD of data lines DL1 to DLm are illustrated for easy description. The pads PD may be defined at the ends of the data lines DL1 to DLm. The data lines DL1 to DLm may be electrically connected to the data driving controller DDC (see FIG. 3A) through the pads PD.

According to the disclosure, the pads PD may be arranged in separate positions that are spaced apart from the display area DA in the peripheral area NDA. For example, some of the pads PD may be disposed on an upper side, for example, on a side that is adjacent to the first scan line GL1, among the scan lines GL1 to GLn, and others of the pads PD may be disposed on a lower side, for example, on a side that is adjacent to the last scan line GLn, among the scan lines GL1 to GLn. The pads PD that may be electrically connected to the odd-numbered data lines, among the data lines DL1 to DLm, may be disposed on an upper side, and the pads PD that are electrically connected to the even-numbered data lines, among the data lines DL1 to DLm, may be disposed on a lower side.

Although not illustrated, the display panel DP may include multiple upper data driving elements that are electrically connected to the pads PD disposed on the upper side and/or multiple lower data driving elements that are electrically connected to the pads PD disposed on the lower side. However, this is described by way of example, and the display panel DP may include one upper data driving element that is electrically connected to the pads PD disposed on the upper side and/or one lower data driving element that is electrically connected to the pads PD disposed on the lower side. The pads PD according to an embodiment of the disclosure may be disposed on only one side of the display panel DP and may be electrically connected to a single data driving controller, and embodiments of the disclosure are not limited to any one embodiment.

As described above in FIG. 3A, in the display panel DP in FIG. 3B, a scan driving controller and/or a data driving controller may also be disposed in the display area DA, and accordingly, some of the light emission portions EP disposed in the display area DA may overlap the scan driving controller and/or the data driving controller in a plan view.

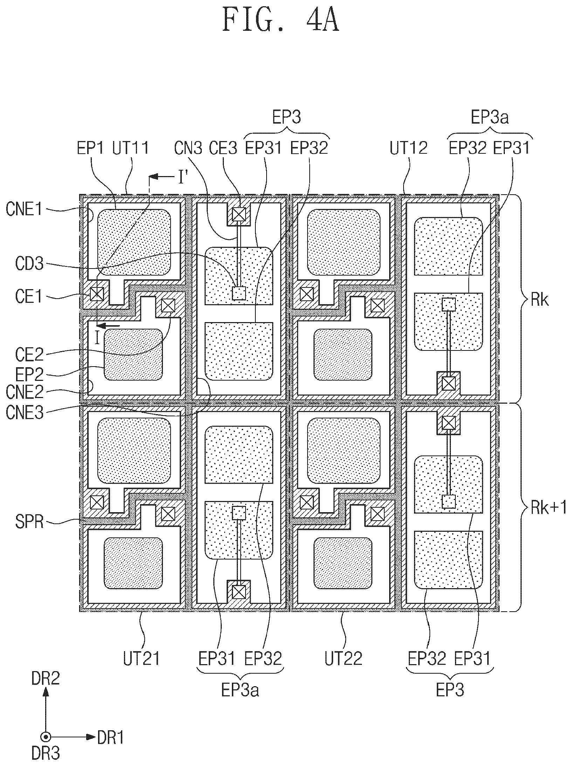

FIGS. 4A to 4D are enlarged schematic plan views of partial areas of a display panel according to an embodiment of the disclosure.

In FIG. 4A, light emission units UT11 and UT12, UT21, and UT22 of two rows and two columns are illustrated by way of example. Referring to FIG. 4A, the light emission portions of the first row Rk may include light emission portions that constitute the light emission unit UT11 of the first row and the first column and the light emission unit UT12 of the first row and the second column, and the light emission portions of the second row Rk+1 may include light emission portions that constitute the light emission unit UT21 of the second row and the first column and the light emission unit UT22 of the second row and the second column.

Each of the light emission portions EP1, EP2, and EP3 may correspond to the light emission opening OP-PDL (see FIG. 5) that will be described below. For example, each of the light emission portions EP1, EP2, and EP3 may be an area, in which light is emitted by the light emitting element described above. The light emission portions EP1, EP2, and EP3 may correspond to units including an image that is displayed on the display panel DP (see FIG. 1). For example, each of the light emission portions EP1, EP2, and EP3 may correspond to an area that is defined by the light emission opening OP-PDL described below, particularly, an area that is defined by a lower surface of the light emission opening OP-PDL.

The light emission portions EP1, EP2, and EP3 may include a first light emission portion EP1, a second light emission portion EP2, and a third light emission portion EP3. The first light emission portion EP1, the second light emission portion EP2, and the third light emission portion EP3 may emit lights of different colors. For example, the first light emission portion EP1 may emit red light, the second light emission portion EP2 may emit green light, and the third light emission portion EP3 may emit blue light, but a combination of the colors is not limited thereto. At least two of the first to third light emission portions EP1, EP2, and EP3 may emit light of the same color. For example, all of the first to third light emission portions EP1, EP2, and EP3 may emit blue light, or all of them may emit white light.

Among the first to third light emission portions EP1, EP2, and EP3, the third light emission portion EP3 that displays light emitted by the third light emitting element may include two sub-light emission portions EP31 and EP32 that are spaced apart from each other in the second direction DR2. However, this is illustrated by way of example, and the third light emission portion EP3 may be provided as a single pattern having an integral shape like the first and second light emission portions EP1 and EP2, or at least one of the first and second light emission portions EP1 and EP2 may include sub-light emission portions that are spaced apart from each other, and embodiments of the disclosure are not limited to any one embodiment.

The light emission portions of the first row Rk may include first to third light emission portions EP1, EP2, and EP3 that constitute the light emission unit UT11 of the first row and the first column and first to third light emission portions EP1, EP2, and EP3a that constitute the light emission unit UT12 of the first row and the second column, and the light emission portions of the second row Rk+1 may include first to third light emission portions EP1, EP2, and EP3a that constitute the light emission unit UT21 of the second row and the first column, and first to third light emission portions EP1, EP2, and EP3 that constitute the light emission unit UT22 of the second row and the second column.

The shapes of the light emission portions that constitute the light emission unit UT11 of the first row and the first column and the light emission portions that constitute the light emission unit UT22 of the second row and the second column may be substantially the same. The shapes of the light emission portions that constitute the light emission unit UT12 of the first row and the second column and the light emission portions that constitute the light emission unit UT21 of the second row and the first column may be substantially the same. The shapes of the light emission portions that constitute the light emission unit UT11 of the first row and the first column may be different from the shapes of the light emission portions that constitute the light emission unit UT12 of the first row and the second column. For example, some of the light emission portions of the first row Rk and some of the light emission portions of the second row Rk+1 may have symmetrical shapes.

The third light emission portion EP3a of the light emission unit UT21 of the second row and the first column and the third light emission portion EP3 of the light emission unit UT11 of the first row and the first column may have a shape and an arrangement form that are line-symmetrical to each other with respect to an axis that is parallel to the first direction DR1, and the third light emission portion EP3 of the light emission unit UT22 of the second row and the second column and the third light emission portion EP3a of the light emission unit UT12 of the first row and the second column may have a shape and an arrangement form that are line-symmetrical to each other with respect to an axis that is parallel to the first direction DR1. However, this is an example, and embodiments of the disclosure are not limited thereto.

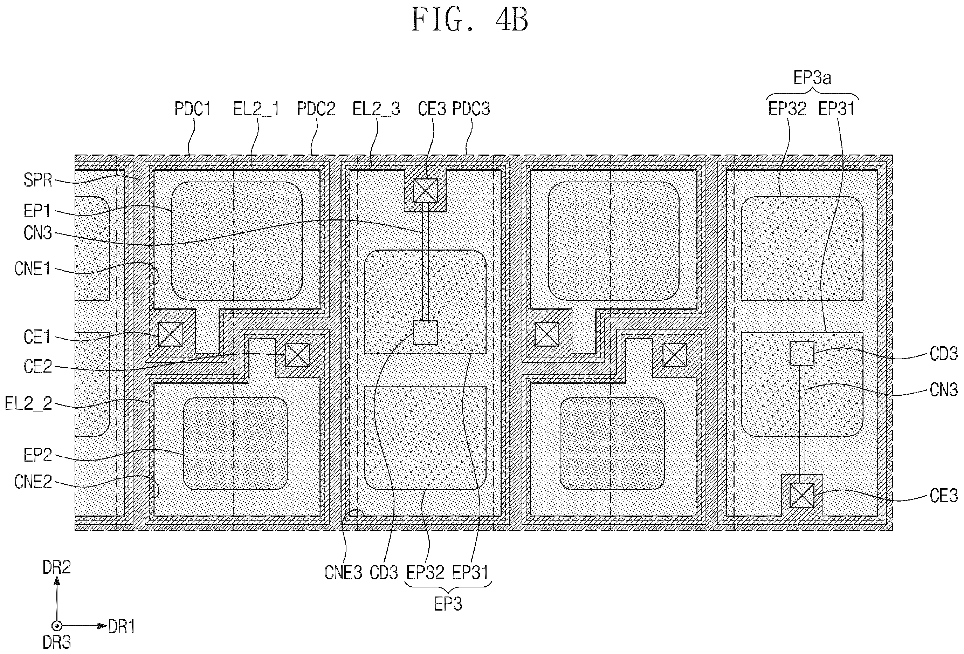

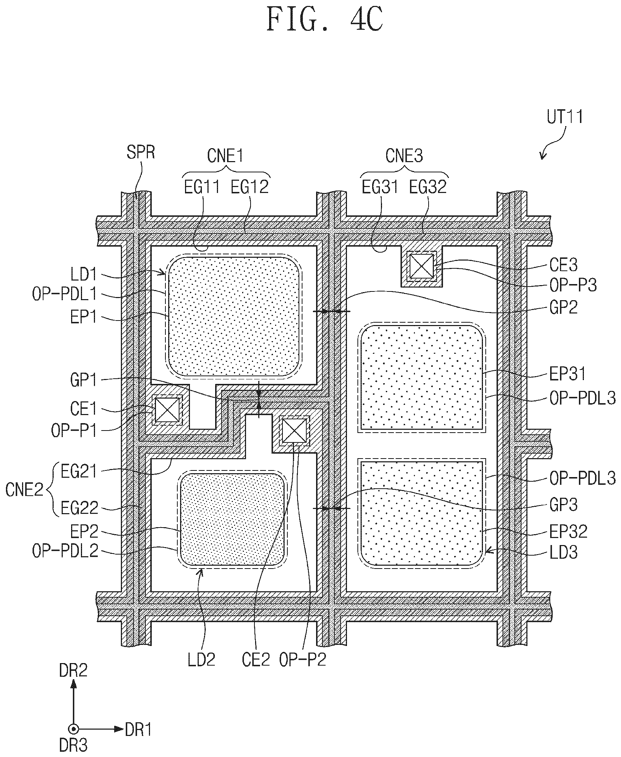

FIG. 4B illustrates light emission portions that are arranged in one row. For easy description, FIG. 4B illustrates multiple second electrodes EL2_1, EL2_2, and EL2_3, multiple pixel driving portions PDC1, PDC2, and PDC3, first to third connection electrodes CNE1, CNE2, and CNE3, and a separator SPR. FIG. 4C illustrates the separator SPR, multiple light emission portions EP1, EP2, and EP3 disposed in areas divided by the separator SPR, and multiple connection electrodes CNE1, CNE2, and CNE3, among the components of the display panel.

Referring to FIG. 4B and FIG. 4C, the second electrodes EL2_1, EL2_2, and EL2_3 may be separated from each other by the separator SPR to be electrically disconnected from each other. One light emission unit UT11 may include three light emission portions EP1, EP2, and EP3. Accordingly, the light emission unit UT11 may include three second electrodes EL2_1, EL2_2, and EL2_3 (hereinafter, referred to as first to third cathodes), three pixel driving portions PDC1, PDC2, and PDC3, and three connection electrodes CNE1, CNE2, and CNE3. However, this is illustrated by way of example, and the number and the arrangement of the light emission portions included in the light emission unit UT11 may be designed variously, and are not limited to any one embodiment.

The first to third pixel driving portions PDC1, PDC2, and PDC3 are electrically connected to the first to third light emitting elements LD1, LD2, and LD3 including the first to third light emission portions EP1, EP2, and EP3, respectively. In the disclosure, "connected" may include not only a case, in which they are physically connected to each other through a direct contact, but also a case, in which they are electrically connected to each other.

As depicted in FIG. 4B, each of the areas, in which the first to third pixel driving portions PDC1, PDC2, and PDC3 are defined in a plan view, may correspond to a unit, in which transistor and capacitor elements that constitute a circuit PDC (see FIG. 2A) for driving the light emitting element of a pixel are repeatedly arranged.

The first to third pixel driving portions PDC1, PDC2, and PDC3 may be sequentially disposed in the first direction DR1. The disposition positions of the first to third pixel driving portions PDC1, PDC2, and PDC3 may be designed independently regardless of the positions or shapes of the first to third light emission portions EP1, EP2, and EP3.

For example, the first to third pixel driving portions PDC1, PDC2, and PDC3 may be disposed in areas defined to be divided by the separators SPR, for example, may be disposed in positions that are different from the positions, in which the first to third cathodes EL2_1, EL2_2, and EL2_3 are disposed, or may be designed to have a shape and an extent that are different from those of the first to third cathodes EL2_1, EL2_2, and EL2_3. The first to third pixel driving portions PDC1, PDC2, and PDC3 may be disposed to overlap each other in the positions in a third direction DR3 (or thickness direction), in which the first to third light emission portions EP1, EP2, and EP3 exist, and may be designed to have areas defined to be divided by the separator SPR, for example, a shape having an extent that is similar to those of the first to third cathodes EL2_1, EL2_2, and EL2_3.

Each of the first to third pixel driving portions PDC1, PDC2, and PDC3 may be illustrated as having a rectangular shape, and each of the first to third light emission portions EP1, EP2, and EP3 may be arranged in a shape that is different from a smaller extent, and the first to third cathodes EL2_1, EL2_2, and EL2_3 are disposed in positions, in which they overlap the first to third light emission portions EP1, EP2, and EP3, but are illustrated as having an irregular shape.

Accordingly, as illustrated in FIG. 4B, the first pixel driving portion PDC1 may be disposed in a position, in which it overlaps (or partially overlaps) the first light emission portion EP1, the second light emission portion EP2, and other adjacent light emission portions. The second pixel driving portion PDC2 may be disposed in a position, in which it overlaps the first light emission portion EP1, the second light emission portion EP2, and the third cathode EL2_3. The third pixel driving portion PDC3 may be positioned in a position, in which it overlaps the third light emission portion EP3. This is merely an example, and the positions of the first to third pixel driving portions PDC1, PDC2, and PDC3 may be designed in various shapes and arrangements independently from the first to third light emission portions EP1, EP2, and EP3, and embodiments of the disclosure are not limited to any one embodiment.

The light emission unit UT11 may include the first to third connection electrodes CNE1, CNE2, and CNE3. The first connection electrode CNE1 may electrically connect the first light emitting element LD1 that forms the first light emission portion EP1 (or in which the first light emission portion EP1 is defined) and the first pixel driving portion PDC1, the second connection electrode CNE2 may electrically connect the second light emitting element LD2 that forms the second light emission portion EP2 and the second pixel driving portion PDC2, and the third connection electrode CNE3 may electrically connect the third light emitting element LD3 that forms the third light emission portion EP3 and the third pixel driving portion PDC3.

The first to third connection electrodes CNE1, CNE2, and CNE3 may electrically connect the first to third cathodes EL2_1, EL2_2, and EL2_3 and the first to third pixel driving portions PDC1, PDC2, and PDC3 in a one-to-one correspondence, respectively.

The first to third connection electrodes CNE1, CNE2, and CNE3 may be disposed on a pixel definition layer PDL (see FIG. 5) that will be described below. The first to third connection electrodes CNE1, CNE2, and CNE3 may have a ring shape that surrounds the corresponding first to third light emitting portions EP1, EP2, and EP3. In an embodiment of the disclosure, it is illustrated, by way of example, that each of the first to third connection electrodes CNE1, CNE2, and CNE3 has a ring shape of a closed line, but embodiments of the disclosure are not limited thereto. For example, at least some of the first to third connection electrodes CNE1, CNE2, and CNE3 may have an open ring shape, a portion of which is disconnected.

As the first to third connection electrodes CNE1, CNE2, and CNE3 have a ring shape, degrees of freedom of the positions, in which the first to third connection electrodes CNE1, CNE2, and CNE3 and the first to third pixel driving portions PDC1, PDC2, and PDC3 are electrically connected to each other, may be improved. For example, the first connection electrode CNE1 may be electrically connected to the first pixel driving portion PDC1 through the first connection element CE1, the second connection electrode CNE2 may be electrically connected to the second pixel driving portion PDC2 through the second connection element CE2, and the third connection electrode CNE3 may be electrically connected to the third pixel driving portion PDC3 through the connection line CN3. For example, connection lines that are additionally connected to the first and second connection electrodes CNE1 and CNE2 may be omitted.

One connection line CN3 may electrically connect the third pixel driving portion PDC3 to the third light emitting element LD3 that constitutes the third light emission portion EP3. The connection line CN3 may correspond to a node (see the fourth node N4 of FIG. 2A, the second node N2 of FIG. 2B, or the fourth node N4 of FIG. 2C), at which the light emitting element LD (see FIG. 2A) is electrically connected to the pixel driving portion PDC of FIG. 2A, PDC-1 of FIG. 2B, or PDC-2 of FIG. 2C.

The connection line CN3 may include a third connection element CE3 and a third driving connection element CD3. The third connection element CE3 may be provided on one side of the connection line CN3, and the third driving connection element CD3 may be provided on an opposite side of the connection line CN3.

The third driving connection element CD3 may be a part of the connection line CN3, which is electrically connected to the third pixel driving portion PDC3. The third driving connection element CD3 may be electrically connected to one electrode of a transistor that constitutes the third pixel driving portion PDC3. The third driving connection element CD3 may be electrically connected to a drain of the sixth transistor T6 illustrated in FIG. 2A, a drain of the first transistor T1 illustrated in FIG. 2B, or a drain of the fourth transistor T4a illustrated in FIG. 2C. Accordingly, a position of the third driving connection element CD3 may correspond to a position of a transistor that is physically connected to the connection line CN3 in the pixel driving part. The third connection element CE3 may be a part of the connection line CN3, which is electrically connected to the third light emitting element LD3. The third connection element CE3 may be electrically connected to the third connection electrode CNE3.

The first connection electrode CNE1 may include a first edge EG11 that surrounds at least a portion of the first light emission portion EP1, and a second edge EG12 that surrounds the first edge EG11. The second connection electrode CNE2 may include a first edge EG21 that surrounds at least a portion of the second light emission portion EP2, and a second edge EG22 that surrounds the first edge EG21. The third connection electrode CNE3 may include a first edge EG31 that surrounds at least a portion of the third light emission portion EP3, and a second edge EG32 that surrounds the first edge EG31.

The first to third connection electrodes CNE1, CNE2, and CNE3 may be arranged to be spaced apart from each other. For example, gaps GP1, GP2, and GP3 between adjacent ones of the first to third connection electrodes CNE1, CNE2, and CNE3 may overlap the separator SPR. For example, the first edges EG11, EG21, and EG31 of the first to third connection electrodes CNE1, CNE2, and CNE3 may not be covered by the separator SPR, and the second edges EG12, EG22, EG32 of the first to third connection electrodes CNE1, CNE2, and CNE3 may overlap the separator SPR. The second edges EG12, EG22, and EG32 of the first to third connection electrodes CNE1, CNE2, and CNE3 may be covered by the separator SPR.

The first to third connection elements CE1, CE2, and CE3 may be disposed in positions, at which they do not overlap the first to third light emission portions EP1, EP2, and EP3 in a plan view. For example, a pixel definition layer PDL may define the light emission opening OP-PDL (see FIG. 5), and the through-holes OP-P (see FIG. 5) that are spaced apart from the light emission opening OP-PDL.

The through-holes OP-P may include a first through-hole OP-P1, a second through-hole OP-P2, and a third through-hole OP-P3. The first to third connection elements CE1, CE2, and CE3 may be arranged to correspond to the first to third through-holes OP-P1, OP-P2, and OP-P3, respectively. The light emission opening OP-PDL may include a first light emission opening OP-PDL1, a second light emission opening OP-PDL2, and a third light emission opening OP-PDL3. The first to third light emission portions EP1, EP2, and EP3 may be defined to correspond to the first to third light emission openings OP-PDL1, OP-PDL2, and OP-PDL3, respectively. Accordingly, the first to third connection elements CE1, CE2, and CE3 may be disposed in positions that are spaced apart from the first to third light emission portions EP1, EP2, and EP3.

The first to third connection electrodes CNE1, CNE2, and CNE3 may be disposed on the pixel definition layer PDL (see FIG. 5). In a plan view, the first connection electrode CNE1 may surround the first light emission opening OP-PDL1, the second connection electrode CNE2 may surround the second light emission opening OP-PDL2, and the third connection electrode CNE3 may surround the third light emission openings OP-PDL3.

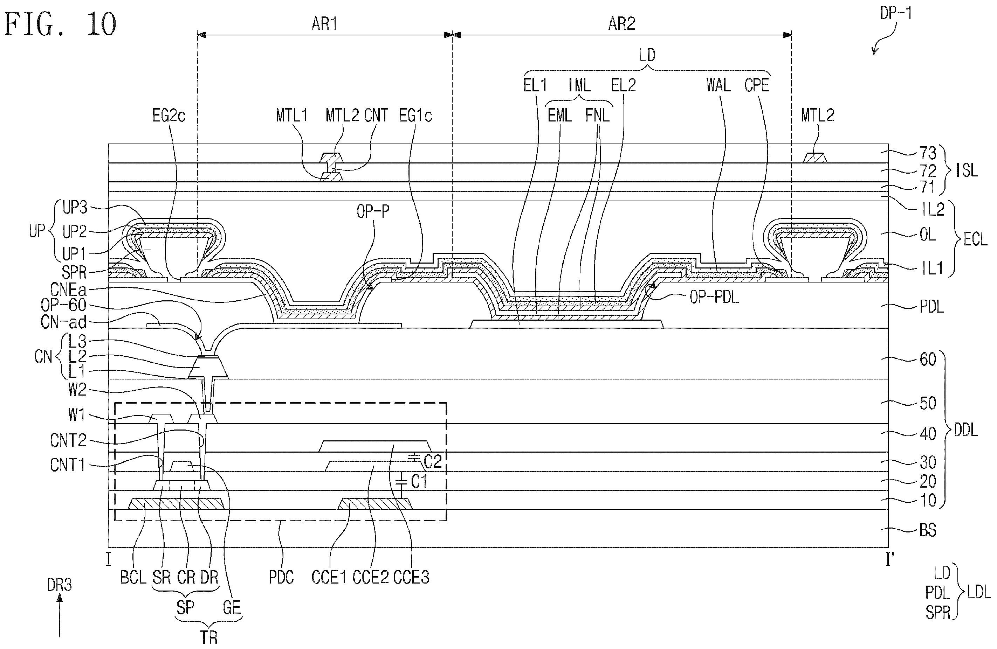

According to an embodiment of the disclosure, the driving connection element CD3 that is located in a position, in which the connection line CN3 is electrically connected to a transistor TR (see FIG. 5) of the third pixel driving portion PDC3, may be defined in a position, in which it does not overlap the third connection element CE3 in a plan view, and may be disposed in a position, in which it overlaps the third light emission portion EP3. For example, the connection line CN3 may correspond to the connection line CN-ad illustrated in FIG. 10, the driving connection element CD3 may correspond to a portion that contacts the intermediate connection electrode CN illustrated in FIG. 10, and the third connection element CE3 may correspond to a portion that contacts the connection electrode CNEa illustrated in FIG. 10. Because the third cathode EL2_3 and the third pixel driving portion PDC3 are electrically connected to each other through the connection line CN3, the constraints due to the position or shape of the third light emission portion EP3 in design of the third pixel driving portion PDC3 may be reduced, and a degree of freedom in the design may be improved.

The first to third cathodes EL2_1, EL2_2, and EL2_3 may be electrically connected to the first to third connection electrodes CNE1, CNE2, and CNE3. For example, the lower surfaces of the first to third cathodes EL2_1, EL2_2, and EL2_3 may be electrically connected to (or contact) the upper surfaces of the first to third connection electrodes CNE1, CNE2, and CNE3, respectively. Accordingly, a contact reliability (or a connection stability) of the first to third cathodes EL2_1, EL2_2, and EL2_3 and the first to third connection electrodes CNE1, CNE2, and CNE3 may be further improved.

The connection areas, in which the first to third cathodes EL2_1, EL2_2, and EL2_3 and the first to third connection electrodes CNE1, CNE2, and CNE3 are electrically connected to each other, may surround at least portions of the first to third light emission openings OP-PDL1, OP-PDL2, and OP-PDL3, respectively. The first to third cathodes EL2_1, EL2_2, and EL2_3 and the first to third connection electrodes CNE1, CNE2, and CNE3 may be electrically connected to each other in areas that are adjacent to the separator SPR, and the contact areas may be defined adjacent to the separator SPR. For example, the first to third cathodes EL2_1, EL2_2, and EL2_R and the first to third connection electrodes CNE1, CNE2, and CNE3 may not be electrically connected to each other at a specific point, but may be electrically connected to each other over a relatively wide area, for example, an area that is similar to the shapes of the first to third connection electrodes CNE1, CNE2, and CNE3. For example, an extent of the electrical connective contact may be increased whereby the electrical connection may proceed stably.

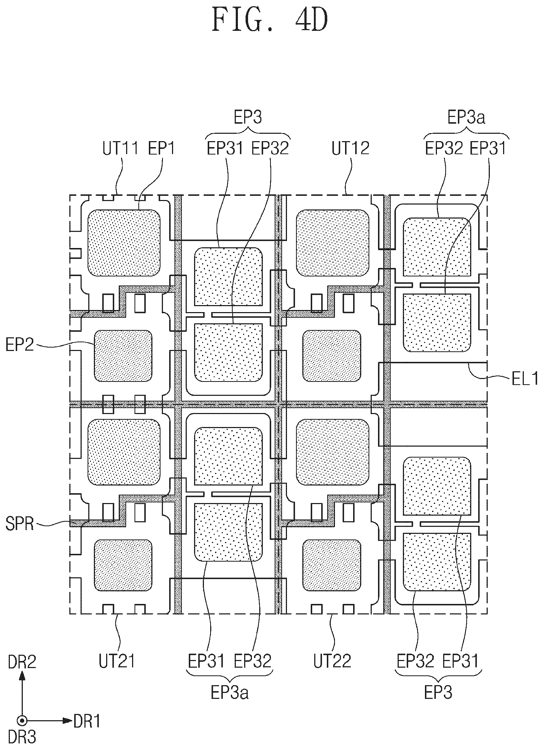

FIG. 4D illustrates the separator SPR, the light emission portions EP1, EP2, and EP3, and the first electrode EL1.

Referring to FIG. 4D, the first electrode EL1 (hereinafter, referred to as an anode) of the light emitting element LD (see FIG. 5) according to an embodiment of the disclosure may be provided in common to the first to third light emission portions EP1, EP2, and EP3. For example, the anode EL1 may be formed as a single layer that is integral with the entire display area DA, and accordingly, the anode EL1 may be disposed to overlap the separator SPR. The anodes EL1 of the light emitting elements LD may be formed as independent conductive patterns that are spaced apart from each other, and may be electrically connected to each other through another conductive layer, and accordingly, the anode EL1 may be disposed not to overlap the separator SPR.

As described above, the first power supply voltage VDD (see FIG. 2A) may be applied to the anode EL1, and a common voltage may be provided to all of the light emission portions. The anode EL1 may be electrically connected to the first power supply line VDL (see FIG. 2A) that provides the first power supply voltage VDD in the peripheral area NDA, or may be electrically connected to the first power supply line VDL (see FIG. 2A) in the display area DA, and embodiments of the disclosure are not limited to any one embodiment.

Multiple openings may be defined in the anode EL1 according to an embodiment, and the openings may pass through the anode EL1. The openings in the anode EL1 may be disposed in positions, in which they do not overlap light emission portions EP (see FIG. 3A), and may generally be defined in positions that they overlap the separator SPR. The openings may facilitate the discharge of gas generated from the organic layer disposed under the anode EL1, for example, a sixth insulation layer 60 (see FIG. 5) that will be described below. Accordingly, in the display panel manufacturing process, the gas of the organic layer disposed under the light emitting element may be sufficiently discharged, and after the manufacturing, the gas discharged from the organic layer may be reduced whereby a speed, at which the light emitting element deteriorates, may be reduced.

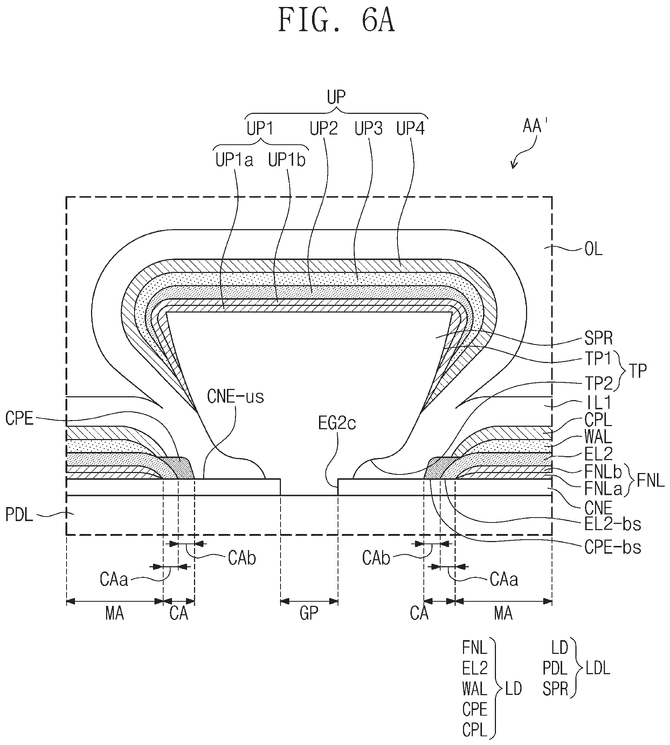

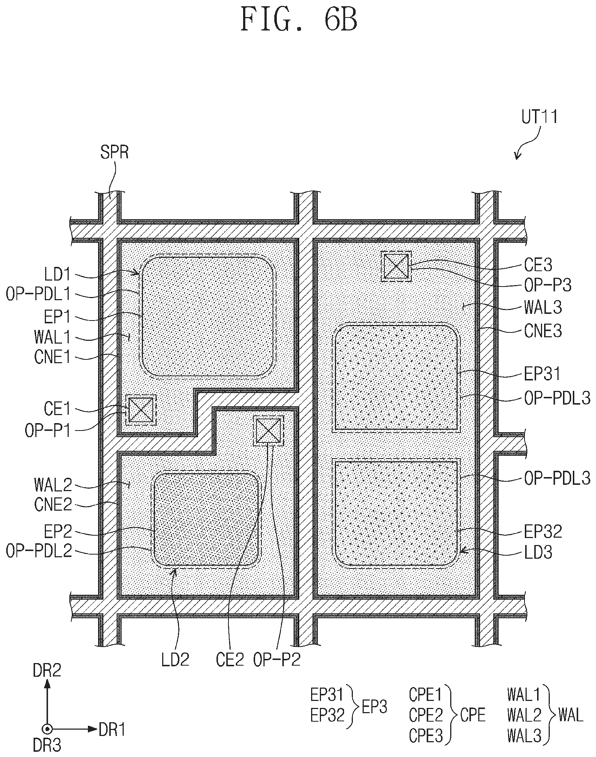

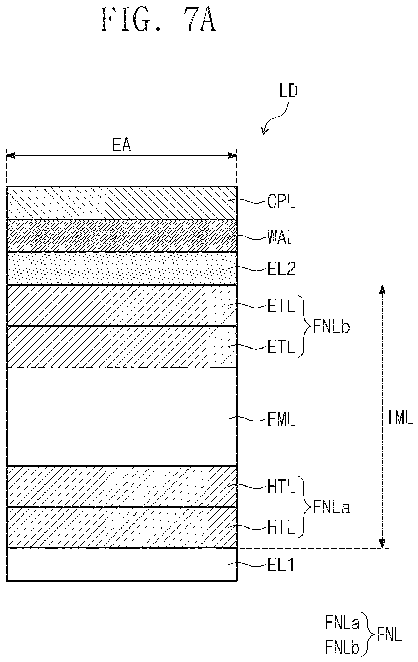

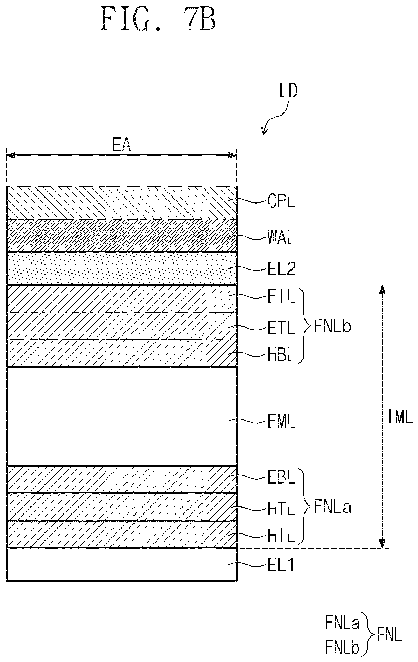

FIG. 5 is a schematic cross-sectional view of a display panel according to an embodiment of the disclosure. FIG. 6A is an enlarged schematic cross-sectional view illustrating a partial area of a display panel according to an embodiment of the disclosure. FIG. 6B is an enlarged schematic plan view of a partial area of a display panel according to an embodiment of the disclosure. FIGS. 7A and 7B are schematic cross-sectional views illustrating a light emitting element according to an embodiment of the disclosure. FIG. 5 illustrates a schematic cross-sectional view taken along line I-I' of FIG. 4A. FIG. 6A illustrates an enlarged schematic cross-sectional view of area AA' of FIG. 5. FIG. 6B illustrates an enlarged schematic plan view of an area, in which the light emission unit UT11 of the first row and the first column is disposed.

Referring to FIGS. 5 and 6a, the display panel DP of an embodiment may include a base layer BS, a driving element layer DDL, an intermediate connection electrode CN, a connection electrode CNE, a light emitting element layer LDL, an encapsulation layer ECL, and a sensing layer ISL. However, this is only an example, and in other embodiments, the display panel DP may not include a sensing layer ISL.

The driving element layer DDL may include multiple insulation layers 10, 20, 30, 40, 50, and 60 that are disposed on the base layer BS, and multiple conductive patterns and semiconductor patterns that are disposed between the insulation layers 10, 20, 30, 40, 50, and 60. The conductive patterns and semiconductor patterns may be disposed between the insulation layers 10, 20, 30, 40, 50, and 60 to constitute a pixel driving portion PDC. For easy description, FIG. 5 illustrates a cross-section of one of the areas, in which one light emission portion is disposed.

The base layer BS may be a member that provides a base surface, on which the pixel driving portion PDC is disposed. The base layer BS may be a rigid substrate or a flexible substrate that may be bent, folded, rolled, and the like. The base layer BS may be a glass substrate, a metal substrate, a polymer substrate, and the like. However, an embodiment of the disclosure is not limited thereto, and the base layer BS may be an inorganic layer, an organic layer, or a composite material layer.

The base layer BS may have a multi-layer structure. The base layer BS may include a first polymer resin layer, a silicon oxide (SiOₓ) layer that is disposed on the first polymer resin layer, an amorphous silicon (a-Si) layer that is disposed on the silicon oxide layer, and a second polymer resin layer that is disposed on the amorphous silicon layer. The silicon oxide layer and the amorphous silicon layer may be referred to as a base barrier layer.

The polymer resin layer may include a polyimide-based resin. The polymer resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the "~~-based" resin means one that may include a "~~" functional group.

The insulation layers, the conductive layers, and the semiconductor layers disposed on the base layer BS may be formed through a method, such as coating and deposition. Thereafter, through multiple photolithography processes, the insulation layer, the semiconductor layer, and the conductive layer may be selectively patterned so that holes may be formed in the insulation layer, or semiconductor patterns, conductive patterns, and signal lines may be formed.

The driving element layer DDL may include the first to sixth insulation layers 10, 20, 30, 40, 50, and 60 that are sequentially laminated on the base layer BS in the third direction DR3 and the pixel driving portion PDC. FIG. 5 illustrates one transistor TR and two capacitors C1 and C2 of the pixel driving portion PDC.

The transistor TR may corresponds to a transistor that is electrically connected to the light emitting element LD through the intermediate connection electrode CN and the connection electrode CNE, for example, a connection transistor that is electrically connected to a node (the fourth node N4 of FIG. 2A, the second node N2 of FIG. 2B, or the fourth node N4 of FIG. 2C) corresponding to the cathode of the light emitting element LD, and in detail, may correspond to the sixth transistor T6 of FIG. 2A, the first transistor T1 of FIG. 2B, or the fourth transistor T4a of FIG. 2C. Although not illustrated, other transistors that constitute the pixel driving portion PDC may have the same structure as that of the transistor TR (hereinafter, referred to as a connection transistor) illustrated in FIG. 5. However, this is described by way of example, and other transistors that constitute the pixel driving portion PDC may have a different structure from that of the connection transistor TR, and embodiments of the disclosure are not limited to any one embodiment.

A first insulation layer 10 may be placed on a base layer BS. The first insulation layer 10 may be an inorganic layer and/or an organic layer, and may have a single-layer or multi-layer structure. The first insulation layer 10 may include at least one of aluminum oxide, titanium oxide, silicon oxide, silicon nitride, silicon oxynitride, zirconium oxide, and hafnium oxide. It is illustrated that the first insulation layer 10 is a single-layer silicon oxide layer. The insulation layers described below may be inorganic layers and/or organic layers, and may have a single-layer or multi-layer structure. The inorganic layer may include at least one of the materials described above, but embodiments of the disclosure are not limited thereto.

The first insulation layer 10 may cover the lower conductive layer BCL. For example, the display panel DP may further include a lower conductive layer BCL that is disposed to overlap the connection transistor TR. The lower conductive layer BCL may block an electric potential caused due to a polarization phenomenon of the base layer BS from affecting the connection transistor TR. The lower conductive layer BCL may block light that is input to the connection transistor TR from a lower side. At least one of an inorganic barrier layer and a buffer layer may be further disposed between the lower conductive layer BCL and the base layer BS.

The lower conductive layer BCL may include a reflective metal. For example, the lower conductive layer BCL may include titanium (Ti), molybdenum (Mo), an alloy containing molybdenum (m), aluminum (Al), an alloy containing aluminum, aluminum nitride (ALn), tungsten (W), tungsten nitride (WN), and copper (Cu).

The lower conductive layer BCL may be electrically connected to the source of the connection transistor TR (or transistor) through a source electrode pattern W1. For example, the lower conductive layer BCL may be synchronized with a source of the transistor TR. However, this is illustrated by way of example, and the lower conductive layer BCL may be electrically connected to a gate of the transistor TR and may be synchronized with the gate. The lower conductive layer BCL may be electrically connected to another electrode and may independently receive a constant voltage or pulse signal. The lower conductive layer BCL may be provided in an isolated form from another conductive pattern. The lower conductive layer BCL according to an embodiment of the disclosure may be provided in various forms, and embodiments of the disclosure are not limited to any one embodiment.

The connection transistor TR may be disposed on the first insulation layer 10. The connection transistor TR may include a semiconductor pattern SP and a gate electrode GE. The semiconductor pattern SP may be disposed on the first insulation layer 10. The semiconductor pattern SP may include an oxide semiconductor. For example, the oxide semiconductor may include a transparent conductive oxide TCO, such as indium tin oxide (ITO), indium zinc oxide (IZO), indium gallium zinc oxide (IGZO), zinc oxide (ZnO), or indium oxide (In₂O₃). However, embodiments of the disclosure are not limited thereto, and the semiconductor pattern SP may include amorphous silicon, low-temperature crystalline silicon, or polycrystalline silicon.

The semiconductor pattern SP may include a source area SR, a drain area DR, and a channel area CR that are distinguished based on a degree of conductivity. The channel area CR may be a portion that overlaps the gate electrode GE in a plan view. The source area SR and the drain area DR may be portions that are spaced apart from each other with the channel area CR being interposed therebetween. In case that the semiconductor pattern SP is an oxide semiconductor, each of the source area SR and the drain area DR may be a reduced area. Accordingly, the source area SR and the drain area DR may have a relatively high content of a reduced metal, compared to the channel area CR. In another example, in case that the semiconductor pattern SP is polycrystalline silicon, each of the source area SR and the drain area DR may be an area that is doped at a high concentration.

The source area SR and the drain area DR may have a relatively high conductivity compared to the channel area CR. The source area SR may correspond to a source electrode of the connection transistor TR, and the drain area DR may correspond to a drain electrode of the connection transistor TR. As illustrated in FIG. 5, a separate source electrode pattern W1 and a separate drain electrode pattern W2 that are electrically connected to the source area SR and the drain area DR, respectively, may be further provided. The separate source electrode pattern W1 and the drain electrode pattern W2 may be formed integrally with one of the lines that constitute the pixel driving portion (see PDC of FIG. 2A, PDC-1 of FIG. 2B, or PDC-2 of FIG. 2C), respectively, and embodiments of the disclosure are not limited to any one embodiment.

The second insulation layer 20 may overlap multiple pixels in common, and may cover the semiconductor pattern SP. The second insulation layer 20 may be an inorganic layer and/or an organic layer, and may have a single-layer or multi-layer structure. The second insulation layer 20 may include at least one of aluminum oxide, titanium oxide, silicon oxide, silicon nitride, silicon oxynitride, zirconium oxide, and hafnium oxide. The second insulation layer 20 may be a single layer silicon oxide layer.

The gate electrode GE may be disposed on the second insulation layer 20. The gate electrode GE may correspond to a gate of the connection transistor TR. The gate electrode GE may be disposed on an upper side of the semiconductor pattern SP. However, this is illustrated by way of example, and the gate electrode GE may be disposed on a lower side of the semiconductor pattern SP, and embodiments of the disclosure are not limited to any one embodiment.

The gate electrode GE may include, titanium (Ti), silver (Ag), molybdenum (Mo), aluminum (Al), aluminum nitride (ALn), tungsten (W), tungsten nitride (WN), copper (Cu), or an alloy thereof, but embodiments of the disclosure are not particularly limited thereto.

The third insulation layer 30 may be disposed on the gate electrode GE. The third insulation layer 30 may be an inorganic layer and/or an organic layer, and may have a single-layer or multi-layer structure. The fourth insulation layer 40 may include at least one of aluminum oxide, titanium oxide, silicon oxide, silicon nitride, silicon oxynitride, zirconium oxide, and hafnium oxide.

Among multiple conductive patterns W1, W2, CCE1, CCE2, and CCE3, the first capacitor electrode CCE1 and the second capacitor electrode CCE2 may constitute the first capacitor C1. The first capacitor electrode CCE1 and the second capacitor electrode CCE2 may be spaced apart from each other with the first insulation layer 10 and the second insulation layer 20 being interposed therebetween.

The first capacitor electrode CCE1 and the lower conductive layer BCL may have an integral shape. The second capacitor electrode CCE2 and the gate electrode GE may have an integral shape.

A third capacitor electrode CCE3 may be disposed on the third insulation layer 30. The third capacitor electrode CCE3 may be spaced apart from the second capacitor electrode CCE2 with the third insulation layer 30 being interposed therebetween, and may overlap it in a plan view. The third capacitor electrode CCE3 may constitute the second capacitor electrode CCE2 and the second capacitor C2.

A fourth insulation layer 40 may be disposed on the third insulation layer 30 and/or the third capacitor electrode CCE3. The fourth insulation layer 40 may be an inorganic layer and/or an organic layer, and may have a single-layer or multi-layer structure. The fourth insulation layer 40 may include at least one of aluminum oxide, titanium oxide, silicon oxide, silicon nitride, silicon oxynitride, zirconium oxide, and hafnium oxide.

A source electrode pattern W1 and a drain electrode pattern W2 may be disposed on the fourth insulation layer 40. The source electrode pattern W1 may be electrically connected to a source area SR of a connection transistor TR through the first contact hole CNT1, and the source electrode pattern W1 and the source area SR of the semiconductor pattern SP may function as a source of the connection transistor TR. The drain electrode pattern W2 may be electrically connected to a drain area DR of the connection transistor TR through the second contact hole CNT2, and the drain electrode pattern W2 and the drain area DR of the semiconductor pattern SP may function as a drain of the connection transistor TR. A fifth insulation layer 50 may be disposed on the source electrode pattern W1 and the drain electrode pattern W2.

An intermediate connection electrode CN may be disposed on the fifth insulation layer 50. The intermediate connection electrode CN may electrically connect the pixel driving portion PDC to the light emitting element LD. For example, the intermediate connection electrode CN may electrically connect the connection transistor TR to the light emitting element. The intermediate connection electrode CN may be a connection node that connects the pixel driving portion PDC to the light emitting element LD. For example, the intermediate connection electrode CN may correspond to the fourth node N4 (see FIG. 2A) illustrated in FIG. 2A, may correspond to the second node N2 (see FIG. 2B) illustrated in FIG. 2B, or may correspond to the fourth node N4 (see FIG. 2C) illustrated in FIG. 2C.

A sixth insulation layer 60 may be disposed on the intermediate connection electrode CN. The sixth insulation layer 60 may be disposed on the fifth insulation layer 50 to cover at least a portion of the intermediate connection electrode CN. Each of the fifth insulation layer 50 and the sixth insulation layer 60 may be an organic layer. For example, each of the fifth insulation layer 50 and the sixth insulation layer 60 may include general purpose polymers, such as benzocyclobutene (BCB), polyimide, hexamethyldisiloxane (HMDSO), polymethylmethacrylate (PMMA), and polystyrene (PS), polymer derivatives having phenolic groups, acrylic polymers, imide polymers, aryl ether polymers, amide polymers, fluorinated polymers, p-xylene polymers, vinyl alcohol polymers, and blends thereof.

A through-hole OP-60 that exposes at least a part of an intermediate connection electrode CN may be provided in the sixth insulation layer 60. The intermediate connection electrode CN may be electrically connected to a connection electrode CNE through a portion that is exposed from the sixth insulation layer 60 to be electrically connected to the light emitting element LD. For example, the intermediate connection electrode CN may electrically connect the connection transistor TR to the light emitting element LD together with the connection electrode CNE. In the disclosure, an area, in which the intermediate connection electrode CN and the connection electrode CNE are electrically connected to each other, may be referred to as a connection area CNA. The connection area CNA may be defined by the through-hole OP-60. In the display panel DP according to an embodiment of the disclosure, the sixth insulation layer 60 may be omitted or provided in multiple forms, and embodiments of the disclosure are not limited to any one embodiment. In case that the sixth insulation layer 60 is omitted, the intermediate connection electrode CN may also be omitted.

The intermediate connection electrode CN may include a first layer L1, a second layer L2, and a third layer L3 that are sequentially laminated in the third direction DR3. The second layer L2 may include a different material from that of the first layer L1. The second layer L2 may include a different material from that of the third layer L3. The second layer L2 may have a thickness that is greater than that of the first layer L1. The second layer L2 may have a thickness that is greater than that of the third layer L3. The second layer L2 may include a material of a high conduction. The second layer L2 may include aluminum (Al).

A light emitting element layer LDL may be disposed on the driving element layer DDL. The light emitting element layer LDL may include the pixel definition layer PDL, the light emitting element LD, and the separator SPR.

The pixel definition layer PDL may be an organic layer. For example, the pixel definition layer PDL may include general purpose polymers, such as benzocyclobutene (BCB), polyimide, hexamethyldisiloxane (HMDSO), polymethylmethacrylate (PMMA), and polystyrene (PS), polymer derivatives having phenolic groups, acrylic polymers, imide polymers, aryl ether polymers, amide polymers, fluorinated polymers, p-xylene polymers, vinyl alcohol polymers, and blends thereof.

The pixel definition layer PDL may have a light-absorbing property, and, for example, may have a black color. For example, the pixel definition layer PDL may include a black coloring agent. The black coloring agent may include a black dye, or a black pigment. The black coloring agent may include carbon black, a metal such as chromium, or an oxide thereof. The pixel definition layer PDL may correspond to a light-shielding pattern having light-shielding properties.

An opening OP-PDL (hereinafter, referred to as light emission opening) that exposes at least a portion of the first electrode EL1 (or anode) that will be described below may be defined in the pixel definition layer PDL. Multiple light emission openings OP-PDL may be provided, and may be disposed to correspond to the light emitting elements, respectively. All components of the light emitting element LD may be disposed in the light emission opening OP-PDL to overlap each other, and may correspond to an area, in which the light emitted by the light emitting element LD is substantially displayed. Accordingly, a shape of the first light emission portion EP1 (see FIG. 4A) may substantially correspond to a shape of the light emission opening OP-PDL in a plan view. An area corresponding to the first light emission portion EP1, for example, an area that is defined by the light emission opening OP-PDL may be referred to as a light emission area EA.

The connection electrode CNE may be disposed on the pixel definition layer PDL. The connection electrode CNE may electrically connect the pixel driving portion PDC to the light emitting element LD. For example, the pixel driving portion PDC may be electrically connected to the light emitting element LD via the intermediate connection electrode CN and the connection electrode CNE. The connection electrode CNE may correspond to the first connection electrode CNE1 illustrated in FIG. 4A. The second connection electrode CNE2 (see FIG. 4A) and the third connection electrode CNE3 (see FIG. 4A) may also have structures that are similar to that of the connection electrode CNE.

The connection electrode CNE may include a first edge EG1c that is adjacent to a light emission opening OP-PDL, and a second edge EG2c that surrounds the first edge EG1c. The second electrode EL2 of the light emitting element LD may contact the connection electrode CNE in an area that is adjacent to the second edge EG2c.

The connection electrode CNE may include a transparent conductive oxide TCO, such as indium tin oxide (ITO), indium zinc oxide (IZO), indium gallium zinc oxide (IGZO), zinc oxide (ZnO), or indium oxide (In₂O₃). However, the material that constitutes the connection electrode CNE is not limited to the above example. For example, the connection electrode CNE may include a metal material.

A through-hole OP-P that is spaced apart from the light emission opening OP-PDL may be defined in the pixel definition layer PDL. Multiple through-holes OP-P may be provided, and may be disposed to correspond to the light emitting element, respectively. A size (or radius) of the through-hole OP-P defined in the pixel definition layer PDL may be greater than a size (or radius) of the through-hole OP-60 defined in the sixth insulation layer 60. The connection electrode CNE may be disposed in the through-hole OP-P and the through-hole OP-60, and may be electrically connected to an intermediate connection electrode CN.

The light emitting element LD may include the first electrode EL1 (or anode), an intermediate layer IML, a second electrode EL2, a low-adhesion layer WAL, and a capping electrode CPE.

The first electrode EL1 (or anode) may be a translucent, transparent, or reflective electrode. According to an embodiment of the disclosure, the first electrode EL1 (or anode) may include a reflective layer that is formed of silver (Ag), magnesium (Mg), aluminum (Al), platinum (Pt), palladium Pd), gold (Au), nickel (Ni), neodymium (Nd), iridium (Ir), chromium (Cr), or a compound thereof, and a transparent or semi-transparent electrode layer that is formed on the reflective layer. The transparent or translucent electrode layer may include at least one selected from the group consisting of indium tin oxide (ITO), indium zinc oxide (IZO), indium gallium zinc oxide (IGZO), zinc oxide (ZnO) or indium oxide (In₂O₃), and aluminum-doped zinc oxide (AZO). For example, the first electrode EL1 may include a lamination structure of ITO/Ag/ITO.

The first electrode EL1 (or anode) may be an anode of the light emitting element LD. For example, the first electrode EL1 may be electrically connected to a first power supply line VDL (see FIG. 2A), and may be applied with a first power supply voltage VDD (see FIG. 2A). The first electrode EL1 may be electrically connected to the first power supply line VDL in the display area DA (see FIG. 3A or FIG. 3B), or may be electrically connected to the first power supply line VDL in the peripheral area NDA. In the latter case, the first power supply line VDL may be disposed in the peripheral area NDA (see FIG. 3A or FIG. 3B), and the first electrode EL1 (or anode) may have a shape that extends to the peripheral area NDA.

In the cross-sectional view of FIG. 5, it is illustrated that the first electrode EL1 (or anode) overlaps the light emission opening OP-PDL and does not overlap the separator SPR, but as described above in FIG. 4D, the first electrodes EL1 (or anode) of the light emitting elements may have an integral shape and a mesh or lattice shape, in which openings are defined in a partial area. For example, in case that the same first power supply voltage VDD may be applied to each of the first electrodes EL1 (or anode) of multiple light emitting elements, the shape of the first electrode EL1 (or anode) may be provided variously and embodiments of the disclosure are not limited to any one embodiment.

The intermediate layer IML may be disposed between the first electrode EL1 and the second electrode EL2. The intermediate layer IML may include a light emission layer EML and a functional layer FNL. The light emitting element LD may include an intermediate layer IML of various structures, and embodiments of the disclosure are not limited thereto. For example, the functional layer FNL may be provided as multiple layers or as two or more layers that are spaced apart from each other with the light emission layer EML being interposed therebetween.

Referring to FIGS. 5 and 6A, the functional layer FNL may be disposed between the first electrode EL1 (or anode) and the second electrode EL2. The functional layer FNL may include a first intermediate functional layer FNLa that is disposed between the first electrode EL1 (or anode) and the light emission layer EML and a second intermediate functional layer FNLb that is disposed between the second electrode EL2 and the light emission layer EML. It is illustrated that the light emission layer EML is inserted into the functional layer FNL. For example, it may be understood that the light emission layer EML is disposed between the first intermediate functional layer FNLa and the second intermediate functional layer FNLb.

The functional layer FNL may control movement of charges between the first electrode EL1 (or anode) and the second electrode EL2. For example, the functional layer FNL may include a hole injection/transport material and/or an electron injection/transport material. The functional layer FNL may include at least one of an electron blocking layer, a hole transport layer, a hole injection layer, a hole blocking layer, an electron transport layer, an electron injection layer, and a charge generating layer.

The light emission layer EML may include an organic light emitting material. The light emission layer EML may include an inorganic light emitting material, or may be provided as a mixed layer of an organic light emitting material and an inorganic light emitting material. The light emission layers EML included in the respective adjacent light emission portions EP (see FIG. 3A) may include light emitting materials that display different colors. For example, the light emission layers EML included in the respective light emission portions EP may provide light of one of blue, red, and green. However, embodiments of the disclosure are not limited thereto, and the light emission layer EML disposed in all light emission portions EP may include a light emitting material that displays the same color. For example, the light emission layer EML may provide blue light or white light.

The second electrode EL2 may be disposed on the intermediate layer IML. The second electrode EL2 may be electrically connected to the connection electrode CNE as described above to be electrically connected to the pixel driving portion PDC. For example, the second electrode EL2 may be electrically connected to the connection transistor TR through the connection electrode CNE. The second electrode EL2 may include at least one selected from Ag, Mg, Cu, Al, Pt, Pd, Au, Ni, Nd, Ir, Cr, Li, Ca, LiF, Mo, Ti, W, In, Sn, and Zn, two or more compounds selected therefrom, two or more mixtures (for example, APC, AgMg, AgYb, or MgYB) of two or more selected therefrom, or an oxide thereof.

A low-adhesion layer (or weak adhesion layer) WAL may be disposed on the second electrode EL2. The low-adhesion layer WAL may be disposed (or directly disposed) on the second electrode EL2. The low-adhesion layer WAL may overlap the second electrode EL2 to a full extent. At least a portion of the low-adhesion layer WAL may be disposed to overlap the light emission opening OP-PDL of the pixel definition layer PDL or the light emission area EA.

A capping electrode CPE may contact a portion of the second electrode EL2 in an area that is spaced apart from the light emission opening OP-PDL of the pixel definition layer PDL or the light emission area EA. The capping electrode CPE may be disposed on the connection electrode CNE that is adjacent to a separator SPR. A portion of a connection electrode upper surface CNE-us may be exposed while not being covered by the intermediate layer IML, the second electrode EL2, and the low-adhesion layer WAL. The exposed portion of the exposed connection electrode upper surface CNE-us may be adjacent to the separator SPR. The capping electrode CPE may contact at least a portion of the connection electrode upper surface CNE-us, which is exposed from the intermediate layer IML, the second electrode EL2, and the low-adhesion layer WAL. A portion of the second electrode EL2, which is adjacent to the separator SPR, may be exposed while not being covered by the low-adhesion layer WAL. The capping electrode CPE may also contact a portion of the second electrode EL2, which is exposed from the low-adhesion layer WAL.

In the disclosure, the low-adhesion layer WAL may include a material having a weak adhesion force with the capping electrode CPE. The low-adhesion layer WAL may have low surface energy, and a metal growth may be suppressed on a surface of the low-adhesion layer WAL. Accordingly, in some embodiments, the capping electrode CPE may not be formed on the upper surface of the low-adhesion layer WAL, and thus, the capping electrode CPE may not be disposed on the low-adhesion layer WAL. Alternatively, in some embodiments, the capping electrode CPE may be formed on the upper surface of the low-adhesion layer WAL. For example, the capping electrode may be formed as a very thin layer on the upper surface of the lower adhesion layer WAL.

The low-adhesion layer WAL may include fluorocarbon compounds.

The capping electrode CPE may include at least one selected from Ag, Mg, Cu, Al, Pt, Pd, Au, Ni, Nd, Ir, Cr, Li, Ca, LiF, Mo, Ti, W, In, Sn, and Zn, two or more compounds selected therefrom (for example, APC, AgMg, AgYb, or MgYb), two or more mixtures of two or more selected therefrom, or an oxide thereof. For example, the capping electrode CPE may include a metal or an alloy including at least one of Ag, Mg, Pd, and Cu. The capping electrode CPE may include the same material as the second electrode EL2, but embodiments are not limited thereto.

The separator SPR may be disposed on a pixel definition layer PDL. The separator SPR may be disposed on the connection electrode CNE disposed on the pixel definition layer PDL and a gap GP between the connection electrode CNE and the adjacent connection electrode.

The second electrode EL2, the functional layer FNL, the low-adhesion layer WAL, and the capping electrode CPE may be formed by commonly performing deposition on multiple pixels through an open mask. Then, the second electrode EL2, the functional layer FNL, the low-adhesion layer WAL, and the capping electrode CPE may be divided by the separator SPR. As described above, the separator SPR may have a closed line shape for each of the light emission portions, and accordingly, the second electrode EL2, the functional layer FNL, the low-adhesion layer WAL, and the capping electrode CPE may have a divided shape for each of the light emission portions. For example, the second electrode EL2, the intermediate layer IML, the low-adhesion layer WAL, and the capping electrode CPE may be electrically independent for the adjacent pixels.

FIG. 6B illustrates the low-adhesion layer WAL and the capping electrode CPE having a divided shape for each of the light emission portions. As illustrated in FIG. 6B, one light emission unit UT11 may include three low-adhesion layers WAL1, WAL2, and WLA3 and three capping electrodes CPE1, CPE2, and CPE3. In one light emission unit UT11, a first low-adhesion layer WAL1 that overlaps the first light emission portion EP1 and the first connection element CE1, a second low-adhesion layer WAL2 that overlaps the second light emission portion EP2 and the second connection element CE2, and a third low-adhesion layer WAL3 that overlaps the third light emission portion EP3 and the third connection element CE3 may be disposed. In one light emission unit UT11, a first capping electrode CPE1 that surrounds the first low-adhesion layer WAL1, a second capping electrode CPE2 that surrounds the second low-adhesion layer WAL2, and a third capping electrode CPE3 that surrounds the third low-adhesion layer WAL3 may be disposed. For example, each of the first to third capping electrodes CPE1, CPE2, and CPE3 may have a ring shape that surrounds a corresponding light emission opening, among the first to third light emission openings OP-PDL1, OP-PDL2, and OP-PDL3 of a pixel definition layer PDL, and each of the first to third low-adhesion layers WAL1, WAL2, and WLA3 may be surrounded by a corresponding capping electrode, among the first to third capping electrodes CPE1, CPE2, and CPE3.

A description of the low-adhesion layer WAL and the capping electrode CPE, which will be made below, may be commonly applied to the first to third low-adhesion layers WAL1, WAL2, and WLA3 and the first to third capping electrodes CPE1, CPE2, and CPE3 illustrated in FIG. 6B.

Referring to FIGS. 5 to 6B, the low-adhesion layer WAL may overlap the light emission area EA and the connection area CNA. The capping electrode CPE may extend along an edge of the separator SPR in a plan view. The capping electrode CPE may have a shape that surrounds the low-adhesion layer WAL in a plan view. Although FIGS. 6A and 6B illustrate that a portion of the capping electrode CPE overlaps the separator SPR, embodiments are not limited thereto. The entire capping electrode CPE may overlap the separator SPR, or the entire capping electrode CPE may not overlap the separator SPR. The capping electrode CPE may not overlap the light emission area EA and the connection area CNA.

As illustrated in FIG. 6A, the light emitting element LD may further include a capping layer CPL. The capping layer CPL may be disposed on the low-adhesion layer WAL. The capping layer CPL may be formed by commonly performing deposition on multiple pixels through the open mask. Then, the capping layer CPL may be divided by the separator SPR. As described above, the separator SPR may have a closed line shape for each of the light emission portions, and accordingly, the capping layer CPL may have a divided shape for each of the light emission portions.

The capping layer CPL may be an organic layer or an inorganic layer. For example, in case that the capping layer CPL includes an inorganic material, the inorganic material may include an alkali metal compound, such as LiF, an alkaline earth metal compound, such as MgF₂, SiON, SiN_{X}, SiO_{y}, and the like. For example, in case that the capping layer CPL includes an organic material, the organic material may include α-NPD, NPB, TPD, m-MTDATA, Alq₃, CuPc, TPD15 (N4,N4,N4',N4'-tetra (biphenyl-4-yl) biphenyl-4,4'-diamine), TCTA 4,4',4"-Tris (carbazol-9-yl) triphenylamine, and the like, or may include an epoxy resin or an acrylate, such as a methacrylate. However, the material included in the capping layer CPL is not limited thereto.

The separator SPR may have an inverse tapered shape. For example, the separator SPR may have a shape, of which a width increases as it becomes more distant from an upper surface of the pixel definition layer PDL. The side surface TP of the separator SPR has a shape having an obtuse taper angle that is inclined from an upper surface of the pixel definition layer PDL. However, this is illustrated by way of example, and in case that the separator SPR may electrically disconnect the second electrode EL2 for each of the pixels, the taper angle of the separator SPR may be set variously, and for example, may have a double structure with different taper angles. The separator SPR may have a structure, such as a tip portion, and embodiments of the disclosure are not limited thereto.

As illustrated in FIGS. 5 and 6A, the separator SPR may have a double inverse taper shape. The side surface TP of the separator SPR may include a first side surface TP1 and a second side surface TP2 that have different taper angles. The taper angle defined by the first side surface TP1 of the separator SPR and the taper angle defined by the second side surface TP2 with respect to the upper surface of the pixel definition layer PDL may be different. Each of the taper angles may be an obtuse angle. For example, as depicted in FIG. 6A, the taper angle defined by the first side surface TP1 with respect to the upper surface of the pixel definition layer PDL may be smaller than the taper angle defined by the second side surface TP2 with respect to the upper surface of the pixel definition layer PDL. However, this is illustrated by way of example, and in case that the separator SPR may electrically disconnect the second electrode EL2 for each of the pixels, the taper angles may be set variously. The separator SPR may have a structure, such as a tip portion, and embodiments of the disclosure are not limited to any one embodiment.

The separator SPR may include an insulating material, and in particular, may include an organic insulating material. The separator SPR may include an inorganic insulating material or may include multiple layers of an organic insulating material and an inorganic insulating material, and may include a conductive material according to an embodiment. For example, as long as the second electrode EL2 may be electrically disconnected for each of the pixels, the separator SPR is not particularly limited for the type of material.

A dummy layer UP may be disposed on an upper portion of the separator SPR. The dummy layer UP may include a first dummy layer UP1 that is disposed on the separator SPR, a second dummy layer UP2 that is disposed on the first dummy layer UP1, and a third dummy layer UP3 that is disposed on the second dummy layer UP2. The first dummy layer UP1 may be formed through the same process as that of the intermediate layer IML, and may include the same material. The first dummy layer UP1 may include a (1-1)-th dummy layer UP1a and a (1-2)-th dummy layer UP1b. The (1-1)-th dummy layer UP1a may be formed by the same process as that of the first intermediate functional layer FNLa, and may include the same material. The (1-2)-th dummy layer UP1b may be formed by the same process as that of the second intermediate functional layer FNLb, and may include the same material. The second dummy layer UP2 may be formed by the same process as that of the second electrode EL2, and may include the same material. The third dummy layer UP3 may be formed by the same process as that of the low-adhesion layer WAL, and may include the same material. For example, the first dummy layer UP1, the second dummy layer UP2, and the third dummy layer UP3 may be simultaneously formed during a process of forming the functional layer FNL, the second electrode EL2, and the low-adhesion layer WAL. As illustrated in FIG. 6A, the dummy layer UP may be formed not only on an upper surface of the separator SPR but also at a portion of the side surface TP. The display panel DP may not include the dummy layer UP. The dummy layer UP may not contact the connection electrode CNE, the second electrode EL2, and the low-adhesion layer WAL. The second dummy layer UP2 included in the dummy layer UP may not contact the connection electrode CNE and the second electrode EL2.

The dummy layer UP may further include a fourth dummy layer UP4 that is disposed on the third dummy layer UP3. The fourth dummy layer UP4 may be formed by the same process as that of the capping layer CPL, and may include the same material. For example, the fourth dummy layer UP4 may be simultaneously formed with the process of the capping layer CPL.

The second electrode EL2 contacts the connection electrode CNE through a contact area CA. The contact area CA is provided adjacent to the separator SPR. The contact area CA may include a first contact area CAa and a second contact area CAb. In the first contact area CAa, an upper surface CNE-us of the connection electrode CNE may contact a lower surface EL2-bs of the second electrode EL2. In the second contact area CAb, an upper surface CNE-us of the connection electrode CNE may contact a lower surface CPE-bs of the capping electrode CPE. The contact area CA may be provided adjacent to the separator SPR, and at least a portion of the contact area CA may be disposed under a side surface TP of the separator SPR.

At least a portion of the connection electrode CNE may be disposed under the separator SPR. For example, the separator SPR may be disposed over the gap GP between the connection electrode CNE and the adjacent connection electrode that is adjacent to the connection electrode CNE, and the second edge EG2c of the connection electrode CNE may be covered by the separator SPR.

The display panel DP of an embodiment may include an intermediate area MA that is disposed between a light emission area EA, in which the light emitting element LD is disposed, and the contact area CA. The intermediate area MA may be an area, in which at least a portion of an intermediate layer IML is disposed. In the intermediate area MA, a functional layer FNL included in the intermediate layer IML may be disposed between the connection electrode CNE and the second electrode EL2. For example, in the intermediate area MA, the connection electrode CNE and the second electrode EL2 may be spaced apart from each other with the functional layer FNL being interposed therebetween.

The intermediate area MA may be adjacent to the contact area CA. The functional layer FNL disposed in the intermediate area MA may include the first intermediate functional layer FNLa and the second intermediate functional layer FNLb described above. The first intermediate functional layer FNLa may be disposed between the first electrode EL1 and the light emission layer EML in the light emission area EA, and the second intermediate functional layer FNLb may be disposed between the second electrode EL2 and the light emission layer EML in the light emission area EA.

In the display panel DP of an embodiment, the functional layer FNL and the second electrode EL2 may be formed through different deposition process methods. The second electrode EL2 may be formed by a deposition method capable of depositing a deposition material at a lower incident angle than the deposition method for forming the functional layer FNL. The functional layer FNL may be formed, for example, through a thermal evaporation method, and the second electrode EL2 may be covered through a sputtering method. Accordingly, in the process of forming the functional layer FNL, the material that forms the functional layer FNL may not enter a lower side of the side surface TP of the separator SPR, and thus, a portion of the connection electrode CNE may be exposed, and the second electrode EL2 may be formed closer to the separator SPR than the functional layer FNL, so that the second electrode EL2 may contact the exposed upper surface CNE-us of the connection electrode CNE. For example, the contact area CA, in which the second electrode EL2 and the connection electrode CNE contact each other, may be formed through a difference in the deposition process method in the processes of forming the functional layer FNL and the second electrode EL2.

The low-adhesion layer WAL and the capping electrode CPE may be formed through different deposition process methods. The capping electrode CPE may be formed by a deposition method capable of depositing a deposition material at a lower incident angle than that of a deposition method for forming the low-adhesion layer WAL. The low-adhesion layer WAL may be formed, for example, by a thermal evaporation method, and the capping electrode CPE may be formed by a sputtering method. The capping electrode CPE may be formed close to the separator SPR compared to the low-adhesion layer WAL, and may contact the second electrode EL2 exposed from the low-adhesion layer WAL. The capping electrode CPE may contact the upper surface CNE-us of the connection electrode, which is exposed from the second electrode EL2. Through the difference in the deposition process method in the low-adhesion layer WAL and the process of forming the capping electrode CPE, the capping electrode CPE may more easily contact the second electrode EL2 and the connection electrode CNE. However, the deposition method is not limited thereto, and both of the low-adhesion layer WAL and the capping electrode CPE may be formed by the thermal evaporation method.

As illustrated in FIG. 5, the connection area CNA, in which the connection electrode CNE is electrically connected to the intermediate connection electrode CN, may be disposed between the light emission area EA and the contact area CA. The connection area CNA may overlap the intermediate area MA. At least a portion of the intermediate layer IML may be disposed to overlap the connection area CNA. In the display panel DP of an embodiment, the functional layer FNL included in the intermediate layer IML may be disposed to overlap the connection area CNA.

According to an embodiment of the disclosure, the connection electrode CNE has a shape that surrounds at least a portion of the light emission area EA, at which the light emitting element LD is disposed. Accordingly, a degree of freedom of a position, in which the connection electrode CNE and the light emitting element LD are electrically connected to each other, and a degree of freedom of a position, in which the connection electrode CNE and the pixel driving portion PDC are electrically connected to each other, may be improved. The upper surface CNE-us of the connection electrode CNE may contact a lower surface EL2-bs of a second electrode EL2 through the contact area CA defined adjacent to a separator SPR. Accordingly, a contact reliability of the connection electrode CNE and the second electrode EL2 may be improved, and because a lower surface of the connection electrode CNE and an upper surface of the intermediate connection electrode CN contact each other, a contact reliability may be improved. In the display panel DP according to an embodiment, a size of the through-holes OP-P and OP-60 for connecting the connection electrode CNE and the intermediate connection electrode CN may be reduced or minimized through the described structure, and thus, an extent or a resolution of the light emission portion of the display panel DP may be easily increased.

According to an embodiment, a material that is deposited to form the capping electrode CPE has a weak adhesion force to the low-adhesion layer WAL so that the capping electrode CPE is not formed on the upper surface of the low-adhesion layer WAL, and the capping electrode CPE may be formed on the upper surface CNE-us of the connection electrode, which is exposed from the low-adhesion layer WAL. Accordingly, the capping electrode CPE may be electrically connected to the connection electrode CNE. In case that the capping electrode CPE is further formed on the connection electrode CNE compared to a case, in which only the second electrode EL2 is electrically connected to the connection electrode CNE, a thickness of the entire electrode electrically connected to the connection electrode CNE may be increased. By further forming the capping electrode CPE to increase a total thickness of the electrode electrically connected to the connection electrode CNE, an electrical connection stability between the second electrode EL2 and the connection electrode CNE may be prevented or reduced even though a portion of the second electrode EL2 is oxidized by external or internal outgas so that a contact reliability may be improved. Accordingly, even though a portion of the second electrode EL2 is oxidized, a degree of IR drop may be reduced so that a light emitting element with a decreased brightness may be prevented from occurring. Because a total thickness of the electrode electrically connected to the connection electrode CNE may be increased while the thickness of the second electrode EL2 in the light emission area EA is not increased, optical issues, such as changes in the resonance characteristics of the light emitting element LD, may not occur. For example, the contact reliability between the second electrode EL2 and the connection electrode CNE may be improved without any change in the light emission characteristics.

Referring back to FIG. 5, an encapsulation layer ECL may be disposed on the light emitting element layer LDL. The encapsulation layer ECL may cover the light emitting element LD, and may cover the separator SPR. The encapsulation layer ECL may include a first inorganic layer IL1, an organic layer OL, and a second inorganic layer IL2 that are sequentially laminated. As illustrated in FIG. 6A, the first inorganic layer IL1 may be disposed (or directly disposed) on the capping layer CPL. However embodiments of the disclosure are not limited thereto, and the encapsulation layer ECL may further include multiple inorganic layers and multiple organic layers. The encapsulation layer ECL may be a glass substrate.

The first and second inorganic layers IL1 and IL2 may protect the light emitting element LD from moisture and oxygen outside the display panel DP, and the organic layer OL may protect the light emitting element LD from foreign substances, such as particles that remain in the process of forming the first inorganic layer IL1. The first and second inorganic layers IL1 and IL2 may include a silicon nitride layer, a silicon oxynitride layer, a silicon oxide layer, a titanium oxide layer, or an aluminum oxide layer. The organic layer OL may include an acrylic organic layer, and a kind of the material is not limited to thereto.

The sensing layer ISL may sense an external input. The sensing layer ISL may be formed on the encapsulation layer ECL through a continuous process. Then, it may be expressed that the sensing layer ISL is disposed directly on the encapsulation layer ECL. The expression "directly disposed" may mean that no other components are disposed between the sensing layer ISL and the encapsulation layer ECL. For example, no separate adhesion member may be disposed between the sensing layer ISL and the encapsulation layer ECL. However, this is illustrated as an example, and in the display panel DP according to an embodiment of the disclosure, the sensing layer ISL may be formed separately and then may be coupled to the display panel DP through the adhesion member, and embodiments of the disclosure are not limited to any one embodiment.

The sensing layer ISL may include multiple conductive layers and multiple insulation layers. Multiple conductive layers may include a first sensing conductive layer MTL1 and a second sensing conductive layer MTL2, and multiple insulation layers may include first to third sensing insulation layers 71, 72, and 73. However, this is illustrated by way of example, and the numbers of the conductive layers and the insulation layers are not limited to any one embodiment.

Each of the first to third sensing insulation layers 71, 72, and 73 may have a single layer structure or a multi-layer structure, in which layers are laminated in the third direction DR3. The first to third sensing insulation layers 71, 72, and 73 may include an inorganic film. The inorganic film may include at least one of aluminum oxide, titanium oxide, silicon oxide, silicon nitride, silicon oxynitride, zirconium oxide, and hafnium oxide. The first to third sensing insulation layers 71, 72, and 73 may include an organic film. The organic film may include at least any one of an acrylic resin, a methacrylic resin, a polyisoprene, a vinyl resin, an epoxy resin, a urethane resin, a cellulose resin, a siloxane resin, a polyimide resin, a polyamide resin, and a perylene resin.

The first sensing conductive layer MTL1 may be disposed between the first sensing insulation layer 71 and the second sensing insulation layer 72, and the second sensing conductive layer MTL2 may be disposed between the second sensing insulation layer 72 and the third sensing insulation layer 73. A portion of the second sensing conductive layers MTL2 may be electrically connected to the first sensing conductive layer MTL1 through the contact hole CNT formed in the second sensing insulation layer 72. Each of the first sensing conductive layer MTL1 and the second sensing conductive layer MTL2 may have a single layer structure or a multi-layer structure, in which layers are laminated in the third direction DR3.

The sensing conductive layer having a single layer structure may include a metal layer or a transparent conductive layer. The metal layer may include molybdenum, silver, titanium, copper, aluminum, or an alloy thereof. The transparent conductive layer may include a transparent conductive oxide such as indium tin oxide (ITO), indium zinc oxide (IZO), zinc oxide (ZnO), or indium zinc tin oxide (IZTO). The transparent conductive layer may include a conductive polymer, such as PEDOT, a metal nanowire, and graphene.

The sensing conductive layer of the multi-layer structure may include metal layers. The metal layers may have a three-layer structure of, for example, titanium (Ti)/aluminum (Al)/titanium (Ti). The sensing conductive layer of the multi-layer structure may include at least one metal layer and at least one transparent conductive layer.

The first sensing conductive layer MTL1 and the second sensing conductive layer MTL2 may constitute a sensor that senses an external input in the sensing layer ISL. The sensor may be driven in a capacitive manner, and may be driven by any one of a mutual-capacitance method or a self-capacitance method. However, this is described by way of example, and the sensor may also be driven by a resistive method, an ultrasonic method, or an infrared method in addition to a capacitive method, and embodiments of the disclosure are not limited thereto.

Each of the first sensing conductive layer MTL1 and the second sensing conductive layer MTL2 may include transparent conductive oxide or may have a metal mesh shape that is formed of an opaque conductive material. The first sensing conductive layer MTL1 and the second sensing conductive layer MTL2 may have various materials and various shapes as long as a visibility of the image displayed by the display panel DP is not deteriorated, and embodiments of the disclosure are not limited to any one embodiment.

FIGS. 7A and 7B are schematic cross-sectional views illustrating a light emitting element according to an embodiment of the disclosure.

Referring to FIGS. 7A and 7B, the light emitting element LD according to an embodiment may include a first electrode EL1, a second electrode EL2 that faces the first electrode EL1, an intermediate layer IML that is disposed between the first electrode EL1 and the second electrode EL2, a low-adhesion layer WAL that is disposed on the second electrode EL2, and a capping layer CPL that is disposed on the low-adhesion layer WAL. The intermediate layer IML may include a functional layer FNL and a light emission layer EML, and the functional layer FNL may include a first intermediate functional layer FNLa and a second intermediate functional layer FNLb. The first intermediate functional layer FNLa may be referred to as a hole transport area, and the second intermediate functional layer FNLb may be referred to as an electron transport area.

The first intermediate functional layer FNLa may have a single layer formed of a single material, a single layer formed of multiple different materials, or a multi-layer structure having multiple layers formed of multiple different materials. The first intermediate functional layer FNLa may include at least one of a hole injection layer HIL, a hole transport layer HTL, a first buffer layer (not illustrated) or a first light emission assisting layer (not illustrated), and an electron blocking layer EBL.

For example, the first intermediate functional layer FNLa may have a single-layer structure of a hole injection layer HIL or a hole transport layer HTL, or may have a single-layer structure formed of a hole injection material and a hole transport material. The first intermediate functional layer FNLa may have a single-layer structure formed of multiple different materials, or may have a structure of a hole injection layer HIL/hole transport layer HTL, a hole injection layer HIL/hole transport layer HTL/first buffer layer (not illustrated), a hole injection layer HIL/buffer layer (not illustrated), a hole transport layer HTL/first buffer layer (not illustrated), or a hole injection layer HIL/hole transport layer HTL/electron blocking layer EBL that are sequentially laminated from the first electrode EL1, but embodiments are not limited thereto.

As described above, in addition to the hole injection layer HIL and the hole transport layer HTL, the first intermediate functional layer FNLa may further include at least one of the first buffer layer (not illustrated) and the electron blocking layer EBL, and the first buffer layer (not illustrated) may compensate for a resonance distance according to a wavelength of light emitted from the light emission layer EML to increase a light emission efficiency. A material that may be included in the hole transport area may be used as a material included in the first buffer layer (not illustrated). The electron blocking layer EBL may serve to prevent injection of electrons from an electron transport area to the hole transport area.

The first intermediate functional layer FNLa may be formed by using various methods, such as a vacuum deposition method, a spin coating method, a casting method, a Langmuir-Blodgett (LB) method, an inkjet printing method, a laser printing method, and a laser induced thermal imaging (LITI) method.

The second intermediate functional layer FNLb may include at least one of a hole blocking layer HBL, an electron transport layer ETL, an electron injection layer EIL, a second buffer layer (not illustrated), and a second light emission assisting layer (not illustrated), but embodiments are not limited thereto.

The second intermediate functional layer FNLb may have a single layer formed of a single material, a single layer formed of multiple different materials, or a multi-layer structure having multiple layers formed of multiple different materials. For example, the second intermediate functional layer FNLb may have a single-layer structure of an electron injection layer EIL or an electron transport layer ETL, or may have a single-layer structure formed of an electron injection material and an electron transport material.

The second intermediate functional layer FNLb may have a single layer structure formed of multiple different materials, or may have an electron transport layer ETL/electron injection layer EIL, a hole blocking layer HBL/electron transport layer ETL/electron injection layer EIL, a second light emission assisting layer (not illustrated)/electron transport layer ETL/electron injection layer EIL, or a second buffer layer (not illustrated)/electron transport layer ETL/electron injection layer EIL structure sequentially laminated from a light emission layer EML, but embodiments of the disclosure are not limited thereto.

As described above, in addition to the electron injection layer EIL and the electron transport layer ETL, the second intermediate functional layer FNLb may further include at least one of the second buffer layer (not illustrated) and the second light emission assisting layer (not illustrated), and the second light emission assisting layer (not illustrated) and/or the second buffer layer (not illustrated) may include a nitrogen-containing compound of an embodiment. The second light emission assisting layer (not illustrated) may serve to balance holes and electrons.

The second intermediate functional layer FNLb may be formed by using various methods, such as a vacuum deposition method, a spin coating method, a casting method, a Langmuir-Blodgett (LB) method, an inkjet printing method, a laser printing method, and a laser induced thermal imaging (LITI) method.

FIG. 7A illustrates a schematic cross-sectional view of the light emitting element LD of an embodiment, wherein the first intermediate functional layer FNLa includes a hole injection layer HIL and a hole transport layer HTL, and the second intermediate functional layer FNLb includes an electron injection layer EIL and an electron transport layer ETL. FIG. 7B illustrates a schematic cross-sectional view of the light emitting element LD of an embodiment, wherein the first intermediate functional layer FNLa includes a hole injection layer HIL, a hole transport layer HTL, and an electron blocking layer EBL, and the second intermediate functional layer FNLb includes an electron injection layer EIL, an electron transport layer ETL, and a hole blocking layer HBL.

As illustrated in FIGS. 6A, 7A, and 7B, a low-adhesion layer WAL may be formed by performing a deposition on a second electrode EL2, and a capping layer CPL may be formed by performing a deposition on the low-adhesion layer WAL. The capping electrode CPE (see FIG. 6A) is formed after forming the low-adhesion layer WAL and before forming the capping layer CPL, but because the capping electrode CPE (see FIG. 6A) includes a material having a weak adhesion force to the low-adhesion layer WAL, the capping electrode CPE (see FIG. 6A) may not be disposed on the low-adhesion layer WAL. For example, the capping electrode CPE (see FIG. 6A) may not be disposed in the light emission area EA, and accordingly, the capping layer CPL may be disposed directly on the low-adhesion layer WAL in the light emission area EA.

The capping layer CPL may be formed by performing a deposition on the low-adhesion layer WAL and the capping electrode CPE (see FIG. 6A). For example, the capping layer CPL may cover the low-adhesion layer WAL to a full extent, and may cover a portion of the capping electrode CPE (see FIG. 6A). However, the configuration, in which the capping layer CPL is in contact, is not limited thereto. For example, the capping layer CPL may cover the entire capping electrode CPE (see FIG. 6A), or may not contact the capping electrode CPE (see FIG. 6A).

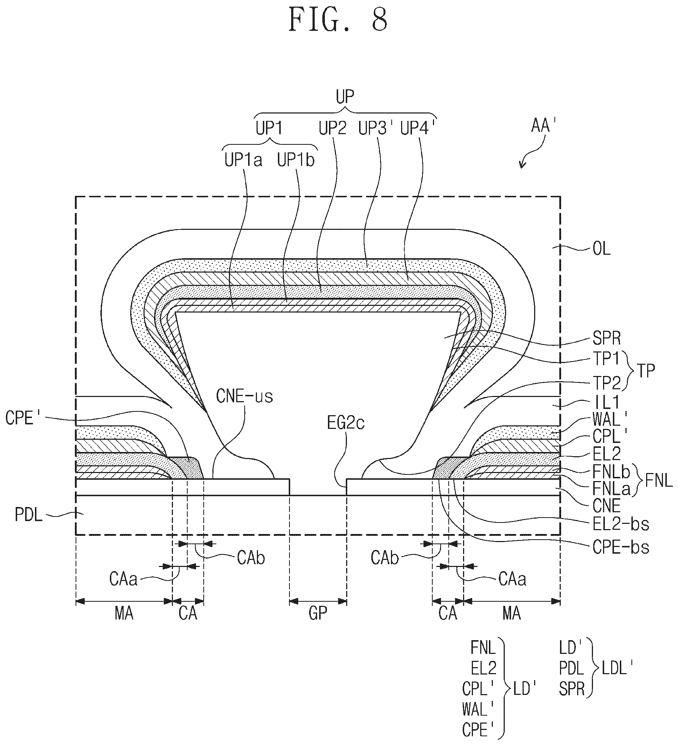

FIG. 8 is an enlarged schematic cross-sectional view illustrating a partial area of a display panel according to an embodiment of the disclosure. The same/similar reference numerals are used for configurations that are the same as/similar to those described in FIGS. 5 to 7B, and a repeated description thereof will be omitted, and differences will be mainly described.

Referring FIG. 8, the light emitting element layer LDL' may include the pixel definition layer PDL, the light emitting element LD', and the separator SPR. The light emitting element LD' may include a first electrode EL1, an intermediate layer IML, a second electrode EL2, a capping layer CPL', a low-adhesion layer WAL', and a capping electrode CPE'.

The capping layer CPL' may be disposed (or disposed directly) on the second electrode EL2, and the low-adhesion layer WAL' may be disposed (or disposed directly) on the capping layer CPL'. The capping layer CPL' may overlap the second electrode EL2 to a full extent.

The capping layer CPL' may be formed on the second electrode EL2 and the low-adhesion layer WAL' may be formed on the capping layer CPL', and then the capping electrode CPE' may be formed. The capping electrode CPE' may be disposed on the connection electrode CNE that is adjacent to a separator SPR. A portion of the connection electrode upper surface CNE-us may be exposed while not being covered by the intermediate layer IML, the second electrode EL2, the capping layer CPL', and the low-adhesion layer WAL'. The capping electrode CPE' may contact at least a portion of the connection electrode upper surface CNE-us, which is exposed from the intermediate layer IML, the second electrode EL2, the capping layer CPL', and the low-adhesion layer WAL'. A portion of the second electrode EL2, which is adjacent to the separator SPR, may be exposed while not being covered by the capping layer CPL' and the low-adhesion layer WAL'. The capping electrode CPE' may also contact a portion of the second electrode EL2, which is exposed from the low-adhesion layer WAL'. The capping layer CPL' may be spaced apart from the capping electrode CPE'.

In the disclosure, the low-adhesion layer WAL' may include a material having a weak adhesion force with the capping electrode CPE'. The low-adhesion layer WAL' may have low surface energy, and a metal growth may be suppressed on a surface of the low-adhesion layer WAL'. Accordingly, the capping electrode CPE' is not formed on the upper surface of the low-adhesion layer WAL', and thus, the capping electrode CPE' may not be disposed on the low-adhesion layer WAL'. In some embodiments, the capping electrode CPE' may be formed to be very thin on the upper surface of the low-adhesion layer WAL'.

A material that is deposited to form the capping electrode CPE' may have a weak adhesion force to the low-adhesion layer WAL' so that the capping electrode CPE' is not formed on the upper surface of the low-adhesion layer WAL', and the capping electrode CPE' may be formed on the upper surface CNE-us of the connection electrode, which is exposed from the capping layer CPL' and the low-adhesion layer WAL'. Accordingly, the capping electrode CPE' may be electrically connected to the connection electrode CNE.

The low-adhesion layer WAL and the capping electrode CPE may be formed through different deposition process methods. The capping electrode CPE may be formed by a deposition method capable of depositing a deposition material at a lower incident angle than that of a deposition method for forming the low-adhesion layer WAL. The low-adhesion layer WAL may be formed, for example, by a thermal evaporation method, and the capping electrode CPE may be formed by a sputtering method. The capping electrode CPE may be formed close to the separator SPR compared to the low-adhesion layer WAL, and may contact the second electrode EL2 exposed from the capping layer CPL' and the low-adhesion layer WAL'. The capping electrode CPE' may contact the upper surface CNE-us of the connection electrode, which is exposed from the second electrode EL2. Through the difference in the deposition process method in the low-adhesion layer WAL' and the process of forming the capping electrode CPE', the capping electrode CPE' may more easily contact the second electrode EL2' and the connection electrode CNE'. However, the deposition method is not limited thereto, and both of the low-adhesion layer WAL and the capping electrode CPE may be formed by the thermal evaporation method.

A dummy layer UP may be disposed on an upper portion of the separator SPR. The dummy layer UP may include a first dummy layer UP1 that is disposed on the separator SPR, a second dummy layer UP2 that is disposed on the first dummy layer UP1, a third dummy layer UP3' that is disposed on the second dummy layer UP2, and a fourth dummy layer UP4' that is disposed on the third dummy layer UP3'. The third dummy layer UP3' may be formed by the same process as that of the capping layer CPL', and may include the same material. The fourth dummy layer UP4' may be formed by the same process as that of the low-adhesion layer WAL', and may include the same material. For example, the first dummy layer UP1, the second dummy layer UP2, the third dummy layer UP3', and the fourth dummy layer UP4' may be simultaneously formed during a process of forming the functional layer FNL, the second electrode EL2, the capping layer CPL', and the low-adhesion layer WAL'.

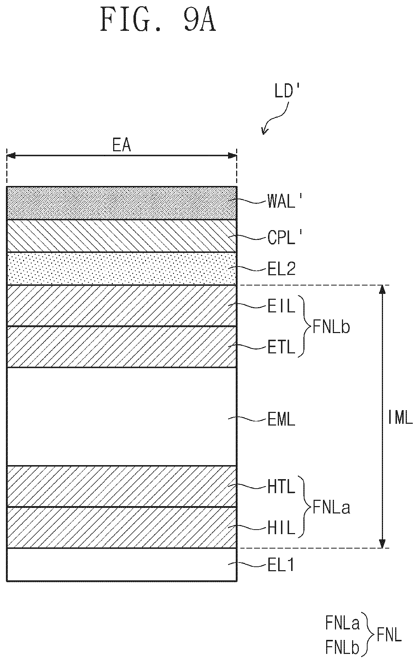

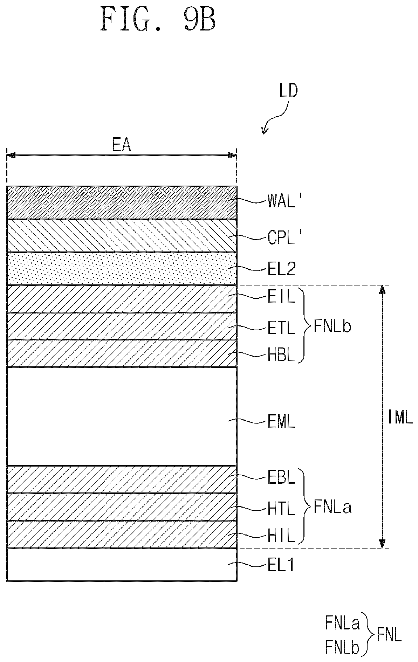

FIGS. 9A and 9B are schematic cross-sectional views illustrating a light emitting element according to an embodiment of the disclosure. The same/similar reference numerals are used for configurations that are the same as/similar to those described in FIGS. 5 to 7B, and a repeated description thereof will be omitted, and differences will be mainly described.

Referring to FIGS. 9A and 9B, a light emitting element LD' according to an embodiment may include a first electrode EL1, a second electrode EL2 that faces the first electrode EL1, an intermediate layer IML that is disposed between the first electrode EL1 and the second electrode EL2, a capping layer CPL' that is disposed on the second electrode EL2, and a low-adhesion layer WAL' that is disposed on the capping layer CPL'. The intermediate layer IML may include a functional layer FNL and a light emission layer EML, and the functional layer FNL may include a first intermediate functional layer FNLa and a second intermediate functional layer FNLb. The first intermediate functional layer FNLa may be referred to as a hole transport area, and the second intermediate functional layer FNLb may be referred to as an electron transport area.

FIG. 9A illustrates a schematic cross-sectional view of the light emitting element LD' of an embodiment, wherein the first intermediate functional layer FNLa includes a hole injection layer HIL and a hole transport layer HTL, and the second intermediate functional layer FNLb includes an electron injection layer EIL and an electron transport layer ETL. FIG. 9B illustrates a schematic cross-sectional view of the light emitting element LD' of an embodiment, wherein the first intermediate functional layer FNLa includes a hole injection layer HIL, a hole transport layer HTL, and an electron blocking layer EBL, and the second intermediate functional layer FNLb includes an electron transport area including an electron injection layer EIL, an electron transport layer ETL, and a hole blocking layer HBL.

As illustrated in FIGS. 8, 9A, and 9B, a capping layer CPL' may be formed by performing a deposition on a second electrode EL2, and a low-adhesion layer WAL' may be formed by performing a deposition on the capping layer CPL'. The capping electrode CPE' may be formed after the capping layer CPL' and the low-adhesion layer WAL' are formed, but because the capping electrode CPE' (see FIG. 8) includes a material having a weak adhesion force to the low-adhesion layer WAL', the capping electrode CPE' (see FIG. 8) may not be disposed on the low-adhesion layer WAL'. For example, the capping electrode CPE' (see FIG. 8) may not be disposed in the light emission area EA.

FIG. 10 is a schematic cross-sectional view of a display panel according to an embodiment of the disclosure. FIG. 10 illustrates a schematic cross-sectional view taken along line I-I' of FIG. 4A. In a description of FIG. 10, the same/similar reference numerals are used for configurations that are the same as/similar to those described in FIGS. 5 to 7B, and a repeated description thereof will be omitted, and differences will be mainly described.

Referring to FIG. 10, the display panel DP-1 may further include a connection line CN-ad disposed between the sixth insulation layer 60 and the pixel definition layer PDL. The connection line CN-ad may be electrically connected to the intermediate connection electrode CN through a through-hole OP-60 that exposes at least a portion of the intermediate connection electrode CN.

The connection line CN-ad may be disposed at the same layer as the first electrode EL1. For example, the connection line CN-ad may have the same material and the same layer structure as those of the first electrode EL1. The connection line CN-ad may be formed by the same process as that of the first electrode EL1. However, this is only an example, and embodiments of the disclosure are not limited thereto. For example, the connection line CN-ad may include a different material from the first electrode EL1, and may be formed by a different process.

A through-hole OP-PDL may be defined in the pixel definition layer PDL. The through-hole OP-PDL and the through-hole OP-60 may not overlap each other, but embodiments of the disclosure are not particularly limited thereto. For example, the through-hole OP-PDL and the through-hole OP-60 may overlap each other. The connection electrode CNEa may be disposed in the through-hole OP-PDL. The connection electrode CNEa may be electrically connected to a portion of the connection line CN-ad, which is exposed by the through-hole OP-Pa.

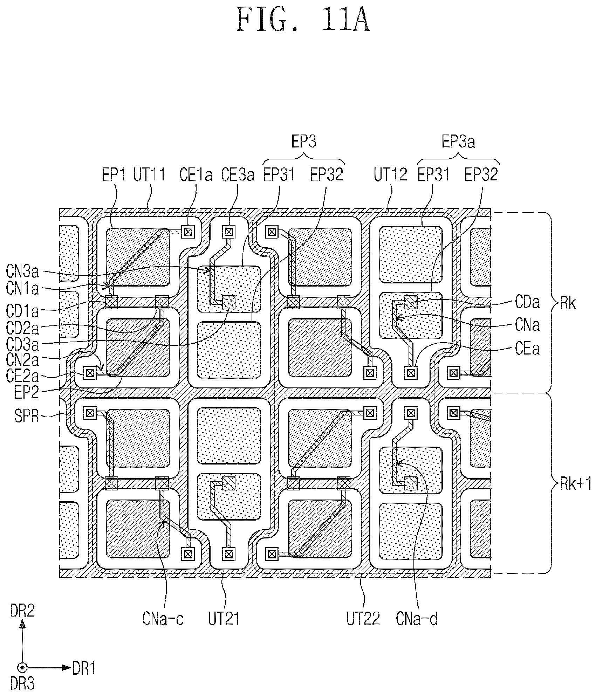

FIGS. 11A to 11D are enlarged schematic plan views of partial areas of a display panel according to an embodiment of the disclosure.

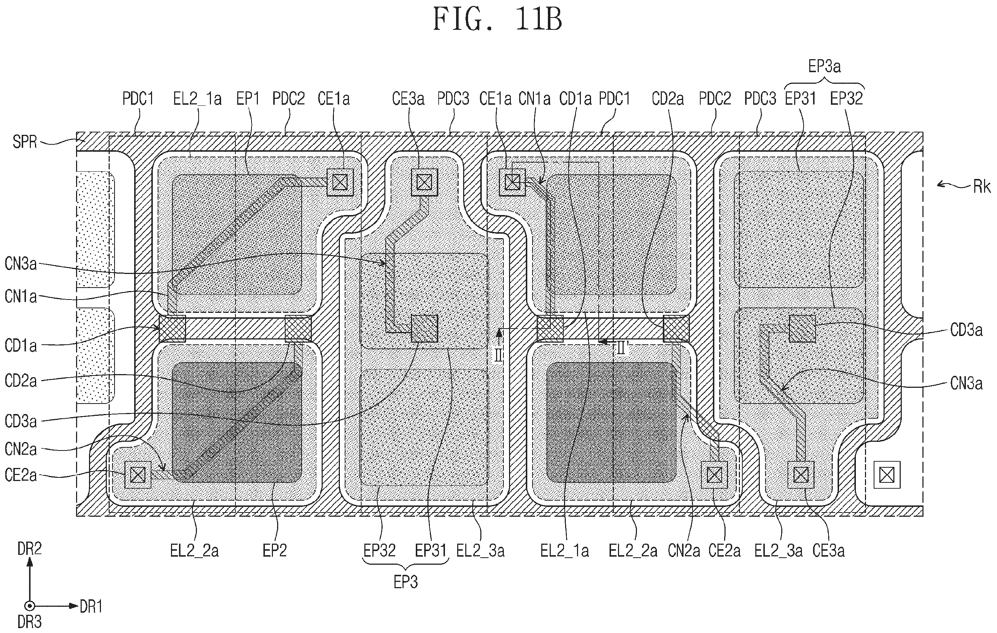

In FIG. 11A, light emission units UT11 and UT12, UT21, and UT22 of two rows and two columns are illustrated by way of example. FIG. 11B illustrates light emission portions that are arranged in one row. For easy description, FIG. 11B illustrates multiple second electrodes EL2_1a, EL2_2a, and EL2_3a, multiple pixel driving portions PDC1, PDC2, and PDC3, first to third connection electrodes CNE1, CNE2, and CNE3, and a separator SPR.

The second electrodes EL2_1a and EL2_2a, and EL2_3a may be electrically disconnected from each other by the separator SPR. One light emission unit UT11 may include three light emission portions EP1, EP2, and EP3. Accordingly, the light emission unit UT11 may include three second electrodes EL2_1a and EL2_2a and EL2_3a (hereinafter, referred to as first to third cathodes), and three pixel driving portions PDC1, PDC2, and PDC3. However, this is illustrated by way of example, and the number and the arrangement of the light emission portions included in the light emission unit UT1 1 may be designed variously, and embodiments of the disclosure are not limited thereto. The light emission unit UT11 may not include the connection electrodes CNE1, CNE2, and CNE3 described above in FIGS. 4B and 4C.

Multiple connection lines CNa may be provided, and may be disposed to be spaced apart from each other. One connection line CNa may electrically connect any one of the pixel driving portions PDC1, PDC2, and PDC3 to a light emitting element corresponding thereto. The connection line CNa may correspond to a node (see the fourth node N4 of FIG. 2A or the second node N2 of FIG. 2B), in which the light emitting element LD (see FIG. 2A) is electrically connected to the pixel driving controller (PDC of FIG. 2A or PDC-1 of FIG. 2B).

The connection line CNa may include a first connection element (or a light emission connection element) CEa and a second connection element (or a driving connection element) CDa. A light emission connection element CEa may be provided on one side of the connection line CN3, and a driving connection element CDa may be provided on an opposite side of the connection line CNa.

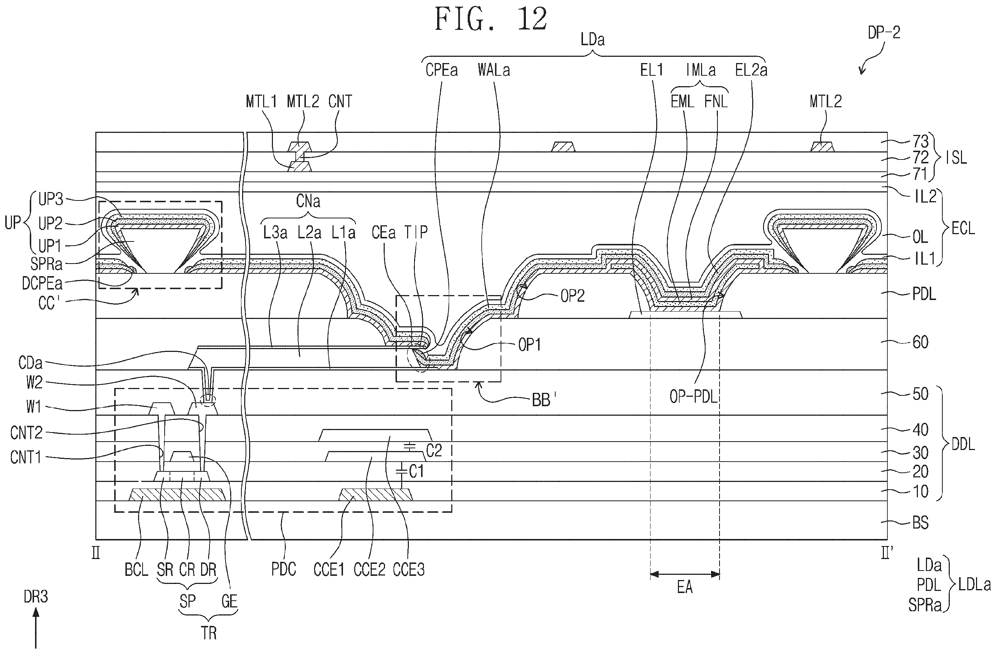

The driving connection element CDa may be a part of the connection line CNa, which is electrically connected to the pixel driving portion PDC1, PDC2, and PDC3. The driving connection element CDa may be electrically connected to one electrode of a transistor that constitutes the pixel driving portion PDC1, PDC2, and PDC3. The driving connection element CDa may be electrically connected to a drain of the sixth transistor T6 illustrated in FIG. 2A or a drain of the first transistor T1 illustrated in FIG. 2B. Accordingly, a position of the driving connection element CDa may correspond to a position of the transistor (see transistor TR of FIG. 12) that is physically and electrically connected to the connection line CNa, among the pixel driving portions. The light emission connection element CEa may be a part of the connection line CNa, which is electrically connected to the light emitting element. The light emission connection element CEa may be electrically connected to the second electrode EL2a (see FIG. 12) (or the cathode) of the light emitting element.

One light emission unit UT11 may include first to third connection lines CN1a, CN2a, and CN3a. The first connection line CN1a may connect a light emitting element that forms the first light emission portion EP1 and the first pixel driving portion PDC1, the second connection line CN2a may connect a light emitting element that forms the second light emission portion EP2 and the second pixel driving portion PDC2, and a third connection line CN3a may connect a light emitting element that forms the third light emission portion EP3 and the third pixel driving portion PDC3.

The first to third connection lines CN1a, CN2a, and CN3a may connect the first to third cathodes EL2_1a, EL2_2a and EL2_3a and the first to third pixel driving portions PDC1, PDC2, and PDC3, respectively. The first connection line CN1a may include a first driving connection element CD1a that is electrically connected to the first pixel driving portion PDC 1 and a first light emission connection element CE1a that is electrically connected to the first cathode EL2_1a. The second connection line CN2a may include a second driving connection element CD2a that is electrically connected to the second pixel driving portion PDC2 and a second light emission connection element CE2a that is electrically connected to the second cathode EL2_2a. The third connection line CN3a may include a third driving connection element CD3a that is electrically connected to the third pixel driving portion PDC3 and a third light emission connection element CE3a that is electrically connected to the third cathode EL2_3a.

The first to third driving connection elements CD1a, CD2a, and CD3a may be aligned in the first direction DR1. As described above, the first to third driving connection elements CD1a, CD2a, and CD3a may correspond to positions of connection transistors that constitute the first to third pixel driving portions PDC1, PDC2, and PDC3, respectively. The connection transistor may be a transistor including a connection node, at which a pixel driving portion and a light emitting element are electrically connected to each other, as one electrode in one pixel, and, for example, may correspond to the sixth transistor T6 of FIG. 2A or the first transistor T1 of FIG. 2B. According to the disclosure, a shape, a position, and an arrangement of the pixel driving portions of all pixels may be simply configured and designed regardless of a shape, a size, or a light emission color of the light emitting portion.

The first to third light emission connection elements CE1a, CE2a, and CE3a may be disposed at positions, in which they do not overlap the light emission portions EP1, EP2, and EP3 in a plan view. As described below, each of the light emission connection elements CE1a, CE2a, and CE3a of the connection line CNa is a portion, to which a light emitting element LDa (see FIG. 12) is electrically connected and a portion, in which a tip portion TIP (see FIG. 12) is defined, and thus, may be provided at a position that it does not overlap the light emission opening OP-PDL (see FIG. 5). For example, the light emission connection elements CE1a, CE2a, and CE3a may be disposed in positions, in which they are spaced apart from the light emission portions EP1, EP2, and EP3 in the cathodes EL2_1a, EL2_2a and EL2_3a, respectively, and the cathodes EL2_1a, EL2_2a and EL2_3a may include partial areas that protrude from the light emission portions EP1, EP2, and EP3 in a plan view, to be electrically connected to the connection lines CN1a, CN2a, and CN3a in the positions, in which the light emission connection elements CE1a, CE2a, and CE3a are disposed.

For example, the first cathode EL2_1a may include a protrusion having a shape that protrudes from the first light emission portion EP1 in a position, in which it does not overlap the first light emission portion EP1 to be electrically connected to the first connection line CN1a in a position, in which the first light emission connection element CE1a is disposed, and the first light emission connection element CE1a may be provided in the protrusion.

The first pixel driving portion PDC1, particularly the first driving connection element CD1a corresponding to a position, in which the first connection line CN1a is electrically connected to the transistor TR (see FIG. 12), may be defined in a position, in which it does not overlap the first light emission portion EP1 in a plan view. According to an embodiment, because the first connection line CN1a is disposed in the first light emission portion EP1, the spaced first cathode EL2_1a and the first pixel driving portion PDC1 may be easily electrically connected to each other.

The third pixel driving portion PDC3, particularly, the third driving connection element CD3a corresponding to a position, in which the third connection line CN3a is electrically connected to the transistor TR (see FIG. 12) may be defined in a position, in which it does not overlap the third light emission connection element CE3a in a plan view, and may be disposed in a position, in which it overlaps the third light emission portion EP3. According to an embodiment, because the third cathode EL2_3a and the third pixel driving portion PDC3 are electrically connected to each other through the third connection line CN3a, the constraints due to the position or shape of the third light emission portion EP3 in design of the third pixel driving portion PDC3 may be reduced, and a degree of freedom in the design may be improved.

Referring back to FIG. 11A, the light emission portions of the second row Rk+1 may include light emission portions having a shape and an arrangement, in which the light emission units UT11 and UT12 of the first row are line-symmetrical with respect to an axis parallel to the first direction DR1 or the second direction DR2. Then, due to the characteristics of the shape and the arrangement of the light emission units UT11 and UT12 of the first row, the light emission units UT21 and UT22 of the second row may include light emission portions, in which the light emission units UT11 and UT12 of the first row are substantially shifted in the first direction DR1 or the second direction DR2. For example, the light emission unit UT21 of the second row and the first column may include light emission portions having the same shape as that of the light emission unit UT12 of the first row and the second column, and the light emission unit UT22 of the second row and the second column may include light emission portions having the same shape as that of the light emission unit UT11 of the first row and the first column.

Accordingly, a shape and an arrangement of the connection lines CNa-c disposed in the light emission unit UT21 of the second row and the first column may be the same as those of the connection lines CN1b, CN2b, and CN3b disposed in the light emission unit UT12 of the first row and the second column. Similarly, a shape and an arrangement of the connection lines CNa-d disposed in the light emission unit UT22 of the second row and the second column may be the same as those of the connection lines CN1a, CN2a, and CN3a disposed in the light emission unit UT11 of the first row and the first column.

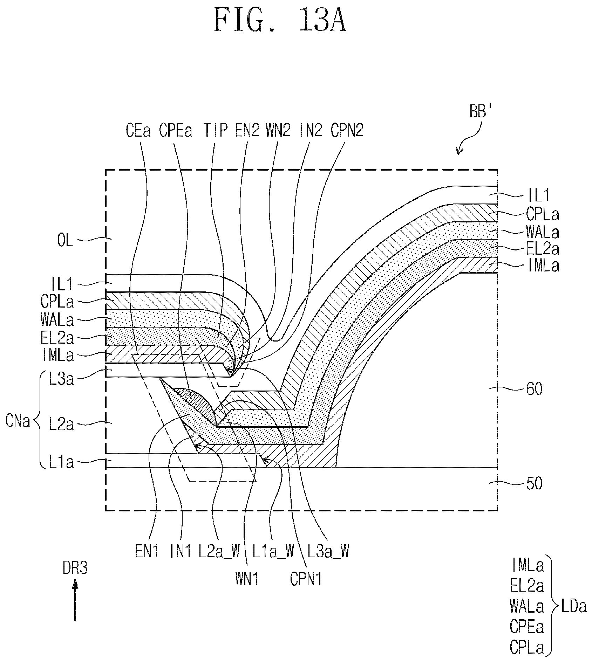

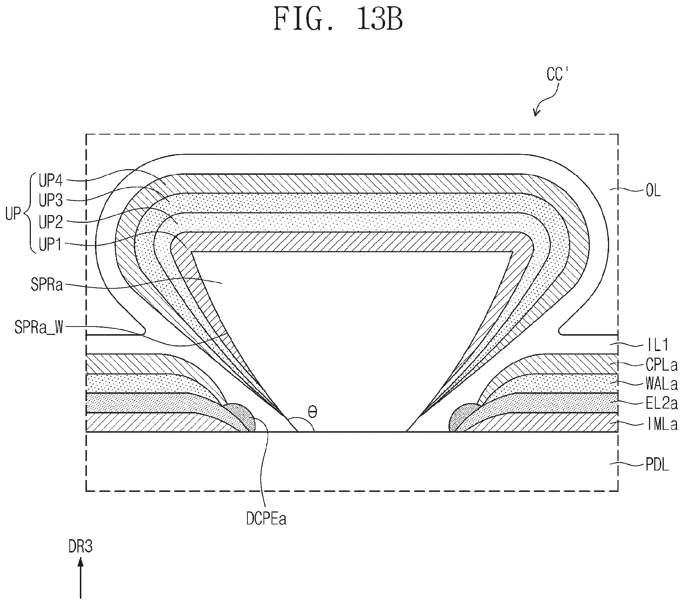

FIG. 12 is a schematic cross-sectional view of a display panel according to an embodiment. FIG. 13A is an enlarged schematic cross-sectional view of a partial area of a display panel according to an embodiment. FIG. 13B is an enlarged schematic cross-sectional view of a partial area of a display panel according to an embodiment. FIG. 12 illustrates a schematic cross-sectional view taken along line II-II' of FIG. 11B. FIG. FIG. 13A illustrates an enlarged schematic cross-sectional view of area BB' of FIG. 12, and FIG. 13B illustrates an enlarged schematic cross-sectional view of area CC' of FIG. 12.

Referring to FIG. 12, the display panel DP-2 may include a base layer BS, a driving element layer DDL, a connection line CNa, a light emitting element layer LDLa, an encapsulation layer ECL, and a sensing layer ISL. However, this is only an example, and the display panel DP-2 may not include the sensing layer ISL.

The connection line CNa may be disposed on the fifth insulation layer 50. The connection line CNa may electrically connect the pixel driving portion PDC to the light emitting element LDa. For example, the connection line CNa may electrically connect the connection transistor TR to the light emitting element LDa. The connection line CNa may be a connection node that connects the pixel driving portion PDC to the light emitting element LDa. For example, the connection line CNa may correspond to the fourth node N4 (see FIG. 2A) illustrated in FIG. 2A or may correspond to the second node N2 (see FIG. 2B) illustrated in FIG. 2B. This is described by way of example, and in case that the connection line CNa may be electrically connected to the light emitting element LDa, it may be defined as a connection node with various elements, among the elements that constitute the pixel driving portion PDC based on a design of the pixel driving portion PDC, and embodiments of the disclosure are not limited thereto. The sixth insulation layer 60 may be disposed on the fifth insulation layer 50 to cover a portion of the connection line CNa.

The sixth insulation layer 60 may include a first opening OP1 that exposes at least a portion of the connection line CNa. The connection line CNa may be electrically connected to the light emitting element LDa through a portion exposed from the sixth insulation layer 60. For example, the connection line CNa may electrically connect the connection transistor TR and the light emitting element LDa. A detailed description thereof will be made below. In the display panel DP-2 according to an embodiment of the disclosure, the sixth insulation layer 60 may be omitted or multiple sixth insulation layers 60 may be provided, and embodiments of the disclosure are not limited thereto.

A light emitting element layer LDLa may be disposed on the driving element layer DDL. The light emitting element layer LDLa may include a pixel definition layer PDL, a light emitting element LDa, and a separator SPRa. The light emitting element LDa may include a first electrode EL1, an intermediate layer IMLa, a second electrode EL2a, a low-adhesion layer WALa, and a capping electrode CPEa.

The second electrode EL2a may be electrically connected to the connection line CNa to be electrically connected to the pixel driving portion PDC. For example, the second electrode EL2a may be electrically connected to the connection transistor TR through the connection line CNa.

As described above, the connection line CNa may include a driving connection element CDa and a light emission connection element CEa. The driving connection element CDa may be a part of the connection line CNa, which is electrically connected to the pixel driving portion PDC, and may be a part that is substantially electrically connected to the connection transistor TR. The driving connection element CDa may be electrically connected to the drain area DR of the semiconductor pattern SP through the drain electrode pattern W2 by passing through the fifth insulation layer 50. The light emission connection element CEa may be a part of the connection line CNa, which is electrically connected to the light emitting element LDa. The light emission connection element CEa may be defined in an area that is exposed from the sixth insulation layer 60, and may be a part, to which the second electrode EL2a is electrically connected. Then, a tip portion TIP may be defined in the light emission connection element CEa.

The light emission connection element CEa of the connection line CNa will be described for example with reference to FIGS. 12 and 13A. As illustrated in FIGS. 12 and 13A, the connection line CNa may have a three-layer structure. The connection line CNa may include a first layer L1a, a second layer L2a, and a third layer L3a that are sequentially laminated in the third direction DR3. The second layer L2a may include a material that is different from that of the first layer L1a. The second layer L2a may include a material that is different from that of the third layer L3a. The second layer L2a may have a thickness that is greater than that of the first layer L1a. The second layer L2a may have a thickness that is greater than the third layer L3a. The second layer L2a may include a material of a high conduction. The second layer L2a may include aluminum (Al).

The first layer L1a may include a material having a lower etching rate than that of the second layer L2a. For example, the second layer L2a may include materials having a high etching selectivity for the first layer L1a. The first layer L1a may include titanium (Ti), and the second layer L2a may include aluminum (Al). For example, a side surface L1a_W of the first layer L1a may be defined on an outer side of a side surface L2a_W of the second layer L2a. For example, the light emission connection element CEa of the connection line CNa may have a shape, in which the side surface L1a_W of the first layer L1a protrudes outward from the side surface L2a_W of the second layer L2a. For example, the light emission connection element CEa of the connection line CNa may have a shape, in which the side surface L2a_W of the second layer L2a is recessed inward from the side surface L1a_W of the first layer L1a.

The third layer L3a may include a material having a lower etching rate than that of the second layer L2a. For example, the third layer L3a and the second layer L2a may include materials having high etching selectivities for each other. The third layer L3a may include titanium (Ti), and the second layer L2a may include aluminum (Al). For example, a side surface L3a_W of the third layer L3a may be defined on an outer side of a side surface L2a_W of the second layer L2a. For example, the light emission connection element CEa of the connection line CNa may have a shape, in which the side surface L3a_W of the third layer L3a protrudes outward from the side surface L2a_W of the second layer L2a. For example, the light emission connection element CEa of the connection line CNa may have an undercut shape or an overhang structure, and the tip portion TIP of the light emission connection element CEa may be defined by a portion of the third layer L3a, which protrudes compared to the second layer L2a.

The sixth insulation layer 60 and the pixel definition layer PDL may expose at least a part of the tip portion TIP and at least a portion of the second side surface L2a_W. A first opening OP1 that exposes one side of the connection line CNa may be defined in the sixth insulation layer 60, and a second opening OP2 that overlaps the first opening OP1 may be defined in the pixel definition layer PDL. The planar extent of the second opening OP2 may be greater than the planar extent of the first opening OP1. However, embodiments of the disclosure are not limited thereto, and the planar extent of the second opening OP2 may be smaller than or equal to the planar extent of the first opening OP1 as long as it may expose at least a portion of the tip portion TIP and at least a portion of the second side surface L2a_W.

The intermediate layer IMLa may be disposed on the pixel definition layer PDL. The intermediate layer IMLa may also be disposed in a partial area of the sixth insulation layer 60, which is exposed by the second opening OP2 of the pixel definition layer PDL. The intermediate layer IMLa may also be disposed in a partial area of the connection line CNa, which is exposed by the first opening OP1 of the sixth insulation layer 60. As illustrated in FIG. 13A, the intermediate layer IMLa may include one end IN1 that is disposed along the upper surface of the fifth insulation layer 50 and an opposite end IN2 that is disposed along the upper surface of the connection line CNa and the tip portion TIP. For example, in a cross-sectional view, the intermediate layer IMLa may have a shape that is partially disconnected with respect to the tip portion TIP in an area, in which the light emission connection element CEa is defined. However, in a plan view, the intermediate layer IMLa may have an integral shape that is entirely connected in an area (see FIG. 11A) defined as a closed line by the separator SPRa.

A second electrode EL2a may be disposed on the intermediate layer IMLa. The second electrode EL2a may also be disposed on a partial area of the sixth insulation layer 60, which is exposed by the second opening OP2 of the pixel definition layer PDL. The second electrode EL2a may also be disposed on a partial area of the connection line CNa, which is exposed by the first opening OP1 of the sixth insulation layer 60. As illustrated in FIG. 13A, the second electrode EL2a may include one end EN1 of the second electrode EL2a, which is disposed along an upper surface of the fifth insulation layer 50, and an opposite end EN2, which is disposed along the connection line CNa and an upper surface of the tip portion TIP. For example, in a cross-sectional view, the second electrode EL2a may have a shape that is partially disconnected with respect to the tip portion TIP in an area, in which the light emission connection element CEa is defined. However, in a plan view, the second electrode EL2a may have an integral shape that is entirely connected in the area (see FIG. 11A) that is defined as a closed curve by the separator SPR.

One end EN1 of the second electrode EL2a may be disposed along the side surface L2a_W of the second layer L2a, and may contact the side surface L2a_W of the second layer L2a. For example, in an area that is adjacent to the tip portion TIP, the second electrode EL2a may contact the side surface L2a_W of the second layer L2a. In detail, through a difference between the deposition angles of the second electrode EL2a and the intermediate layer IMLa, the second electrode EL2a may be formed to contact the side surface L2a_W of the second layer L2a, which is exposed from the intermediate layer IMLa by the tip portion TIP. For example, the second electrode EL2a may be electrically connected to the connection line CNa without a separate patterning process for the intermediate layer IMLa, and accordingly, the light emitting element LDa may be electrically connected to the pixel driving portion PDC through the connection line CNa.

It is illustrated that an opposite end IN2 of the intermediate layer IMLa and an opposite end EN2 of the second electrode EL2a cover the side surface L3 a_W of the third layer L3a, but this is illustrated by way of example, and at least a portion of the side surface L3a_W of the third layer L3a may be exposed from the opposite end IN2 of the intermediate layer IMLa and/or the opposite end EN2 of the second electrode EL2a.

The low-adhesion layer WALa is disposed on the second electrode EL2a. The low-adhesion layer WALa may be disposed directly on the second electrode EL2a. The low-adhesion layer WALa may overlap the second electrode EL2a to the full extent.

The low-adhesion layer WALa may also be disposed on a partial area of the sixth insulation layer 60, which is exposed by the second opening OP2 of the pixel definition layer PDL. The low-adhesion layer WALa may also be disposed on a partial area of the connection line CNa, which is exposed by the first opening OP1 of the sixth insulation layer 60. As illustrated in FIG. 13A, the low-adhesion layer WALa may include one end WN1 of the low-adhesion layer WALa, which is disposed along an upper surface of the fifth insulation layer 50, and an opposite end WN2, which is disposed along the connection line CNa and an upper surface of the tip portion TIP. For example, in a cross-sectional view, the low-adhesion layer WALa may have a shape that is partially disconnected with respect to the tip portion TIP in an area, in which the light emission connection element CEa is defined. However, in a plan view, the low-adhesion layer WALa may have an integral shape that is entirely connected in an area (see FIG. 11A) defined as a closed curve by the separator SPR.

The capping electrode CPEa may be disposed in an area, in which the light emission connection element CEa is defined. In an area that is adjacent to the tip portion TIP or an area that is adjacent to the side surface L2a_W of the second layer L2a, a portion of the second electrode EL2a may be exposed while not being covered by the low-adhesion layer WALa. In an area that is adjacent to the tip portion TIP or an area that is adjacent to the side surface L2a_W of the second layer L2a, the capping electrode CPEa may contact at least a portion of the second electrode EL2a, which is exposed from the low-adhesion layer WALa.

In the disclosure, the low-adhesion layer WALa may include a material having a weak adhesion force to the capping electrode CPEa. The low-adhesion layer WALa may have low surface energy, and a metal growth may be suppressed on the surface of the low-adhesion layer WALa. Accordingly, the capping electrode CPEa may not be formed on the upper surface of the low-adhesion layer WALa, and thus, the capping electrode CPEa may not be disposed on the low-adhesion layer WALa. Alternatively, the capping electrode CPEa may be formed on the upper surface of the low-adhesion layer WALa as a very thin film.

The capping electrode CPEa may be formed on the second electrode EL2a exposed from the low-adhesion layer WALa. Accordingly, the capping electrode CPEa may be electrically connected to the second electrode EL2a. Compared to a case, in which only the second electrode EL2a is electrically connected to the second layer L2a of the connection line CNa, a thickness of the entire electrode electrically connected to the connection line CNa may be increased in case that the capping electrode CPEa is further formed on the second electrode EL2a. As a total thickness of the electrode electrically connected to the connection line CNa is increased by further forming the capping electrode CPEa, an electrical connection stability between the second electrode EL2a and the connection line CNa may be prevented or reduced even though a portion of the second electrode EL2a is oxidized by external or internal outgas whereby the contact reliability may be improved. Accordingly, even though a portion of the second electrode EL2a is oxidized, a degree of an IR drop may be reduced, and thus, a light emitting element with a decreased brightness may be prevented from occurring. Because a total thickness of the electrodes electrically connected to the connection line may be increased while not increasing a thickness of the second electrode EL2a in the light emission area EA, optical issues, such as changes in the resonance characteristics of the light emitting element LDa may not occur. For example, the contact reliability between the second electrode EL2a and the connection line CNa may be improved without changing the light emitting characteristics.

The low-adhesion layer WALa and the capping electrode CPEa may be formed through different deposition processes. The capping electrode CPEa may be formed through a deposition method of depositing a deposition material at a lower incident angle, compared to the deposition method of forming the low-adhesion layer WALa. The low-adhesion layer WALa, for example, may be formed through a thermal evaporation method, and the capping electrode CPEa may be formed through a sputtering method. The capping electrode CPEa may be formed adjacent to the second layer L2a of the connection line CNa, compared to the low-adhesion layer WALa, to contact the second electrode EL2a exposed from the low-adhesion layer WALa. Due to a difference in the deposition process methods in the processes of forming the low-adhesion layer WALa and the capping electrode CPEa, the capping electrode CPEa may contact the second electrode EL2a more easily. However, the deposition method is not limited thereto, and both of the low-adhesion layer WAL and the capping electrode CPE may be formed by a thermal evaporation method.

As illustrated in FIG. 13A, the light emitting element LDa may further include a capping layer CPLa. The capping layer CPLa may be disposed on the low-adhesion layer WALa. The capping layer CPLa may also be disposed on a partial area of the sixth insulation layer 60, which is exposed by the second opening OP2 of the pixel definition layer PDL. The capping layer CPLa may also be disposed on a partial area of the connection line CNa, which is exposed by the first opening OP1 of the sixth insulation layer 60. As illustrated in FIG. 13A, the capping layer CPLa may include one end CPN1 of the capping layer CPLa, which his disposed along an upper surface of the fifth insulation layer 50, and an opposite end CPN2, which is disposed along an upper surface of the connection line CNa and the tip portion TIP. For example, when viewed in cross section, the capping layer CPLa may have a shape that is partially disconnected with respect to the tip portion TIP in an area, in which the light emission connection element CEa is defined. However, in a plan view, the capping layer CPLa may have an integral shape that is entirely connected in an area (see FIG. 11A) defined as a closed curve by the separator SPRa.

The capping layer CPLa may be formed by performing a deposition on the low-adhesion layer WALa and the capping electrode CPEa. For example, the capping layer CPLa may cover the low-adhesion layer WALa to the full extent, and may cover a portion of the capping electrode CPEa. However, the configuration, in which the capping layer CPLa is in contact, is not limited thereto.

The separator SPRa will be described, for example, with reference to FIGS. 12 and 13B. As illustrated in FIG. 13B, the connection electrode may not be disposed under the separator SPRa, and the lower surface of the separator SPRa may all contact the pixel definition layer PDL. The separator SPRa may have an inverse taper shape. For example, the angle "θ" (hereinafter, referred to as the taper angle) formed by the side surface SPRa_W of the separator SPRa with respect to the upper surface of the pixel definition layer PDL may be an obtuse angle. However, this is illustrated by way of example, and in case that the separator SPRa may electrically disconnect the second electrode EL2a for each of the pixels, the taper angle "θ" may be set variously. The separator SPRa may have the same structure as that of the tip portion TIP, and embodiments of the disclosure are not limited thereto.

Even though there is no separate patterning process for the second electrode EL2a or the intermediate layer IMLa, the second electrode EL2a or the intermediate layer IMLa may be divided for each of the pixels by not forming the second electrode EL2a or the intermediate layer IMLa on the side surface SPRa_W of the separator SPRa or by forming it thinly. In addition, in case that the second electrode EL2a or the intermediate layer IMLa may be electrically disconnected between adjacent pixels, a shape of the separator SPRa may be modified in various ways, and embodiments of the disclosure are not limited thereto.

Even without a separate patterning process, the low-adhesion layer WALa and the capping layer CPLa may be divided for each pixel by not forming the second electrode EL2a or the intermediate layer IMLa on the side surface SPRa_W of the separator SPRa or by forming it thinly.

A dummy capping electrode DCPEa may be disposed on the pixel definition layer PDL that is adjacent to the separator SPRa. In the area that is adjacent to the separator SPRa, the dummy capping electrode DCPEa may contact at least a portion of the second electrode EL2a, which is that is exposed and not covered by the low-adhesion layer WALa, the intermediate layer IMLa, the second electrode EL2a, and a portion of the upper surface of the pixel definition layer PDL, which is exposed and not covered by the low-adhesion layer WALa. The dummy capping electrode DCPEa may be formed by the same process as that of the capping electrode CPEa, and may include the same material. For example, the dummy capping electrode DCPEa may be simultaneously formed with the process of forming the capping electrode CPEa.

A dummy layer UP may be arranged on the separator SPRa. The dummy layer UP may include a first dummy layer UP1 that is disposed on a separator SPRa, a second dummy layer UP2 that is disposed on the first dummy layer UP1, and a third dummy layer UP3 that is disposed on the second dummy layer UP2. The first dummy layer UP1 may be formed by the same process as that of the intermediate layer IMLa (for example, the functional layer FNL), and may include the same material. The second dummy layer UP2 may be formed by the same process as that of the second electrode EL2a, and may include the same material. The third dummy layer UP3 may be formed by the same process as that of the low-adhesion layer WALa, and may include the same material. For example, the first dummy layer UP1, the second dummy layer UP2, and the third dummy layer UP3 may be simultaneously formed in a process of forming the functional layer FNL, the second electrode EL2a, and the low-adhesion layer WALa.

The dummy layer UP may further include a fourth dummy layer UP4 that is disposed on the third dummy layer UP3. The fourth dummy layer UP4 may be formed through the same process as that of the capping layer CPLa, and may include the same material. For example, the fourth dummy layer UP4 may be simultaneously formed in a process of forming the capping layer CPLa.

Referring to FIGS. 12 to 13B, the light emitting element LDa may have a structure corresponding to FIG. 7A or FIG. 7B by way of example.

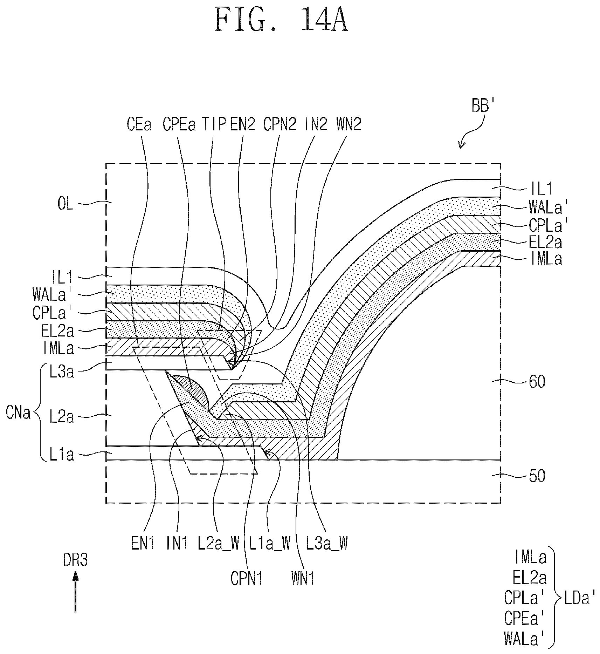

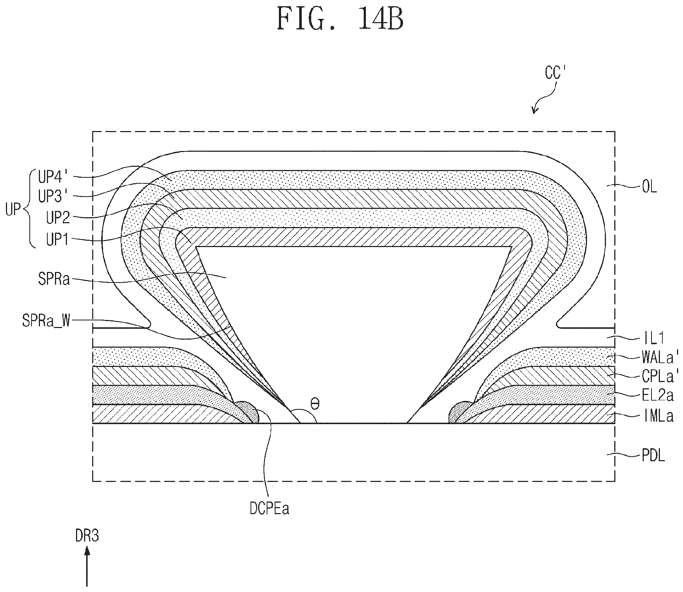

FIG. 14A is an enlarged schematic cross-sectional view illustrating a partial area of the display panel according to an embodiment of the disclosure. FIG. 14B is an enlarged schematic cross-sectional view illustrating a partial area of a display panel according to an embodiment of the disclosure. FIG. 13A illustrates an enlarged schematic cross-sectional view of area BB' of FIG. 12, and FIG. 13B illustrates an enlarged schematic cross-sectional view of area CC' of FIG. 12. In a description of FIGS. 14A and 14B, the same/similar reference numerals are used for the same/similar components as those described in FIGS. 12 to 13B, and a repeated description thereof will be omitted, and differences will be mainly described.

Referring to FIGS. 14A and 14B, a light emitting element layer LDLa (see FIG. 12) according to an embodiment may include a pixel definition layer PDL, a light emitting element LDa', and a separator SPRa. The light emitting element LDa' may include a first electrode EL1 (see FIG. 12), an intermediate layer IMLa, a second electrode EL2a, a capping layer CPLa', a low-adhesion layer WALa', and a capping electrode CPEa'.

The capping layer CPLa' may be disposed directly on the second electrode EL2a, and the low-adhesion layer WALa' may be disposed directly on the capping layer CPLa'. The capping layer CPLa' may overlap the second electrode EL2a to the full extent.

The capping layer CPLa' may be formed on the second electrode EL2a, and the low-adhesion layer WALa' may be formed on the capping layer CPLa', and then the capping electrode CPEa' may be formed. The capping electrode CPEa' may be disposed in an area, in which a light emission connection element CEa is defined. In an area that is adjacent to the side surface L2a_W of the second layer L2a, a portion of the second electrode EL2a may be exposed while not being covered by the capping layer CPLa' and the low-adhesion layer WALa'. In an area that is adjacent to the side surface L2a_W of the second layer L2a, the capping electrode CPEa' may contact at least a portion of the second electrode EL2a, which is exposed from the capping layer CPLa' and the low-adhesion layer WALa'.

In the disclosure, the low-adhesion layer WALa' may include a material having a weak adhesion force to the capping electrode CPEa'. The low-adhesion layer WALa' may have low surface energy, and a metal growth may be suppressed on the surface of the low-adhesion layer WALa'. Accordingly, the capping electrode CPEa' may not be formed on the upper surface of the low-adhesion layer WALa', and thus, the capping electrode CPEa may not be disposed on the low-adhesion layer WALa'. The capping electrode CPEa' may be formed on the upper surface of the low-adhesion layer WALa' as a very thin film. The capping electrode CPEa' may not formed on the upper surface of the low-adhesion layer WALa', and the capping electrode CPEa' may be formed on the second electrode EL2a exposed from the low-adhesion layer WALa'. Accordingly, the capping electrode CPEa' may be electrically connected to the connection line CNa.

A dummy layer UP may be arranged on the separator SPRa. The dummy layer UP may include a first dummy layer UP1 that is disposed on a separator SPRa, a second dummy layer UP2 that is disposed on the first dummy layer UP1, a third dummy layer UP3' that is disposed on the second dummy layer UP2, and a fourth dummy layer UP4' that is disposed on the third dummy layer UP3'. The fourth dummy layer UP3' may be formed through the same process as that of the capping layer CPLa', and may include the same material. The fourth dummy layer UP4' may be formed by the same process as that of the low-adhesion layer WALa', and may include the same material. For example, the first dummy layer UP1, the second dummy layer UP2, the third dummy layer UP3a', and the fourth dummy layer UP4a' may be simultaneously formed in a process of forming the functional layer FNL, the second electrode EL2a, the capping layer CPLa', and the low-adhesion layer WALa'.

Referring to FIGS. 12 to 13B, the light emitting element LDa may have a structure corresponding to FIG. 9A or FIG. 9B by way of example.

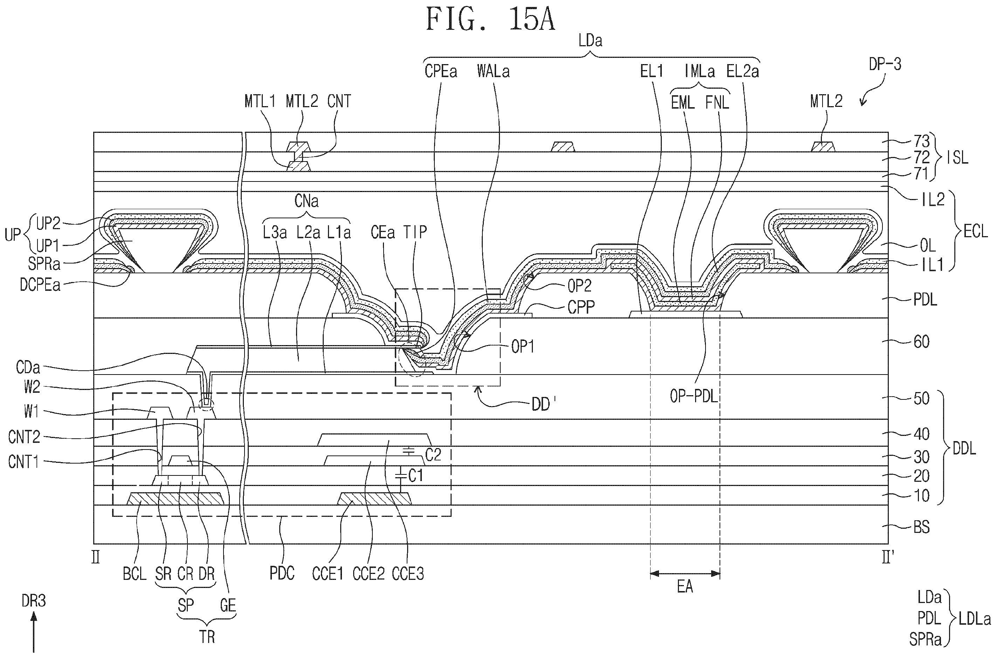

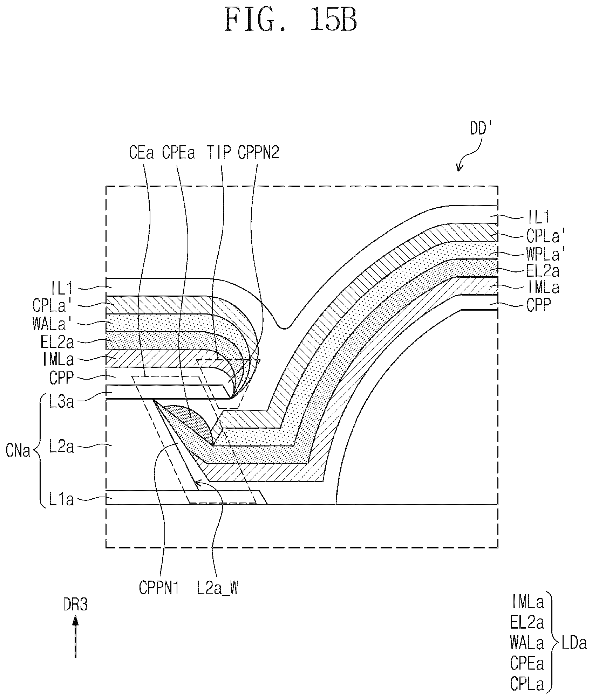

FIG. 15A is a schematic cross-sectional view of a display panel according to an embodiment of the disclosure. FIG. 15B is a schematic cross-sectional view illustrating an enlarged partial area of a display panel according to an embodiment of the disclosure. FIG. 15A illustrates a schematic cross-sectional view taken along line II-II' of FIG. 11B. FIG. 15B illustrates an enlarged schematic cross-sectional view of area DD' of FIG. 15A. In a description of FIGS. 15A and 15B, the same/similar reference numerals are used for components that are the same as/similar to those described in FIGS. 12 to 13B, and a repeated description thereof will be omitted, and differences will be mainly described.

The display panel DP-3 illustrated in FIGS. 15A and 15B may further include a capping pattern CPP, compared to the display panel DP-2 illustrated in FIG. 12. The capping pattern CPP may be disposed on the sixth insulation layer 60. The capping pattern CPP may also be disposed on a partial area of the connection line CNa, which is exposed by the first opening OP1 of the sixth insulation layer 60. The capping pattern CPP may be disposed to overlap the connection line CNa, and may be disposed to overlap the light emission connection element CEa and/or the tip portion TIP.

In a cross-sectional view, the capping pattern CPP may have a shape, in which the light emission connection element CEa is partially disconnected with respect to the tip portion TIP in an area, in which the light emission connection element CEa is defined. However, in a plan view, the capping pattern CPP may have an integral shape that is entirely connected in an area (see FIG. 11A) defined as a closed line by the separator SPRa. One end CPPN1 of the partially disconnected capping pattern CPP may contact the side surface L2a_W of the second layer L2a of the connection line CNa, and an opposite end CPPN2 of the capping pattern CPP may be disposed on the upper part of the third layer L3a of the connection line CNa to cover the tip portion TIP.

The capping pattern CPP may include a conductive material. Accordingly, the second electrode EL2a may be electrically connected to the connection line CNa through the capping pattern CPP. For example, in an area that is adjacent to the tip portion TIP, the capping pattern CPP may contact the side surface L2a_W of the second layer L2a of the connection line CNa, and then the second electrode EL2a may contact the capping pattern CPP so that they are all electrically connected to each other. The capping pattern CPP may be disposed on an outer side of the second layer L2a of the connection line CNa, and the second electrode EL2a may be electrically connected to the second layer L2a even only in case that it is electrically connected to the capping pattern CPP instead of the side surface L2a_W of the second layer L2a, so that the connection line CNa and the second electrode E2a may be electrically connected to each other more easily. In addition, in an area that is adjacent to the tip portion TIP, the capping electrode CPEa may contact the second electrode E2a whereby a contact reliability between the second electrode EL2a and the connection line CNa may be improved without any change in the luminescence characteristics.

The capping pattern CPP may include a material having a reactivity that is lower than that of the second layer L2a of the connection line CNa. For example, the capping pattern CPP may include copper (Cu), silver (Ag), transparent conductive oxide, and the like. Because the side surface L2a_W of the second layer L2a of the connection line CNa is protected by the capping pattern CPPa having a relatively low reactivity, the material included in the second layer L2a may be prevented from being oxidized. It is also possible to prevent a phenomenon, in which the silver (Ag) component included in the first electrode EL1 layer is reduced during the etching process for patterning the first electrode EL1 and remains as a particle that causes defects.

The capping pattern CPP may be formed through the same process as that of the first electrode EL1, and may include the same material as that of the first electrode EL1. However, this is described by way of example, and the capping pattern CPP may be formed through a different process from those of the first electrode EL1 and may include a different material, and embodiments of the disclosure are not limited thereto.

Referring to FIGS. 15A and to 15B, the light emitting element LDa may have a structure corresponding to FIG. 7A or FIG. 7B by way of example. However, embodiment are not limited thereto, and the light emitting element LDa may have a structure corresponding to, for example, FIG. 9A or FIG. 9B, in which case, the capping layer CPLa' may be disposed between the second electrode EL2a and the low-adhesion layer WPLa'.

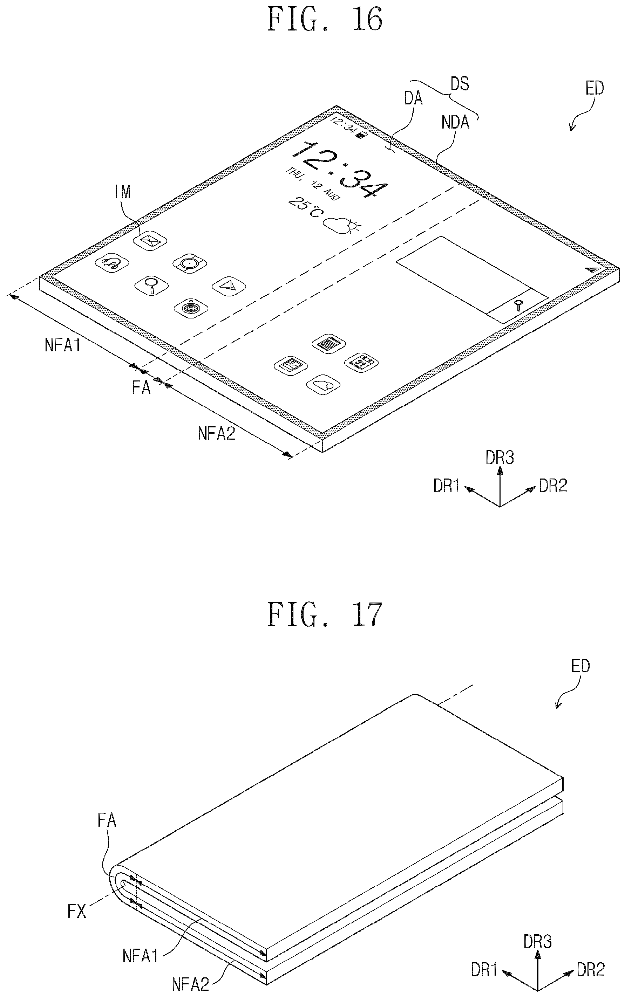

FIG. 16 is a schematic perspective view of an electronic device according to an embodiment of the disclosure. FIG. 17 is a schematic view illustrating a folded state of the electronic device illustrated in FIG. 16.

Referring to FIG. 16, an electronic device ED according to an embodiment of the disclosure may have a rectangular shape having short sides extending in a first direction DR1 and long sides extending in a second direction DR2 intersecting the first direction DR1. However, embodiments of the disclosure are not limited thereto, and the electronic device ED may have various shapes such as a circular shape and a polygonal shape. The electronic device ED may be flexible.

The electronic device ED may include a folding area FA and multiple non-folding areas NFA1 and NFA2. The non-folding areas NFA1 and NFA2 may include the first non-folding area NFA1 and the second non-folding area NFA2. The folding area FA may be disposed between the first non-folding area NFA1 and the second non-folding area NFA2. The folding area FA, the first non-folding area NFA1, and the second non-folding area NFA2 may be arranged in the first direction DR1.

One folding area FA and two non-folding areas NFA1 and NFA2 are illustrated, but, in another embodiment, the numbers of folding areas FA and the non-folding areas NFA1 and NFA2 may not be limited thereto. For example, the electronic device ED may include more than two non-folding areas and multiple folding areas arranged between the non-folding areas.

An upper surface of the electronic device ED may be defined as a display surface DS, and the display surface DS may have the plane defined by the first direction DR1 and the second direction DR2. Images IM generated by the electronic device ED may be provided to a user through the display surface DS.

The display surface DS may include a display area DA and a non-display area NDA around the display area DA. The display area DA displays an image, and the non-display area NDA does not display the image. The non-display area NDA may surround the display area DA and may define an edge of the electronic device ED printed in a predetermined color.

Referring to FIG. 17, the electronic device ED may be a foldable electronic device ED that is folded or unfolded. For example, the folding area FA may be bent with respect to a folding axis FX parallel to the second direction DR2, and thus the electronic device ED may be folded. The folding axis FX may be defined as a long axis parallel to the long sides of the electronic device ED. In case that the electronic device ED is folded, the first non-folding area NFA1 and the second non-folding area NFA2 may face each other, and the electronic device ED may be in-folded so that the display surface DS is not exposed to the outside. However, embodiment of the disclosure are not limited thereto. For example, although not illustrated, the electronic device ED may be out-folded so that the display surface DS is exposed to the outside about the folding axis FX. Further, although not illustrated, the electronic device ED may be in-folded and out-folded at the same time.

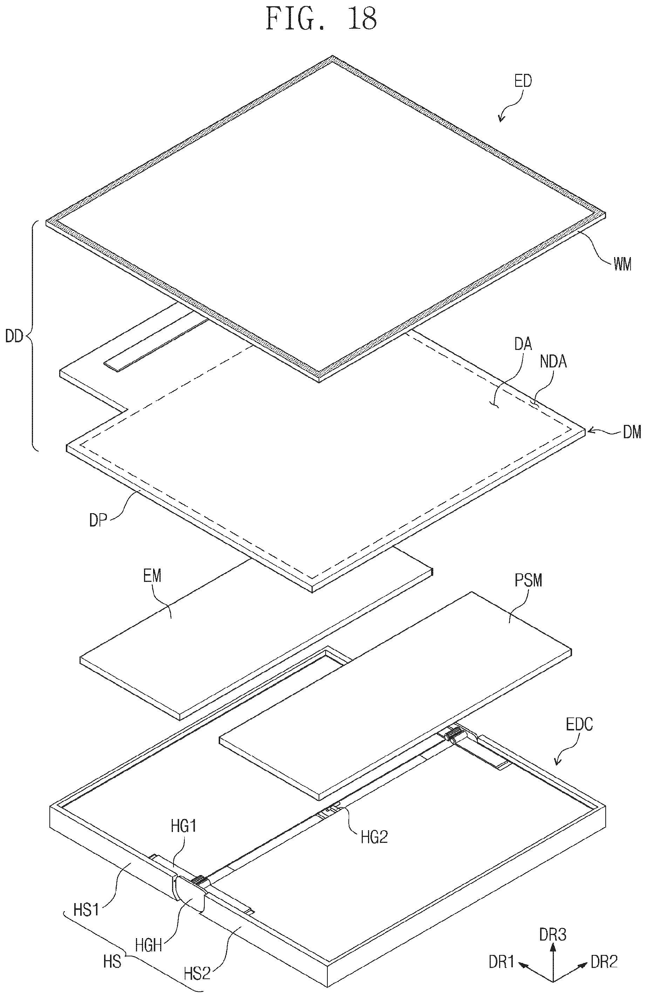

FIG. 18 is an exploded schematic perspective view of the electronic device illustrated in FIG. 16.

Referring to FIG. 18, the electronic device ED may include a display device DD, an electronic module EM, a power supply module PSM, and a hinge module EDC. Although not illustrated, the electronic device ED may further include a mechanical structure (e.g., a hinge) for controlling a folding operation of the display device DD.

The display device DD may generate an image and sense an external input. The display device DD may include a window module WM and a display module DM. The window module WM may provide a front surface of the electronic device ED. The window module WM may be disposed on the display module DM to protect the display module DM. The window module WM may transmit a light generated by the display module DM and provide the light to the user.

The display module DM may include a display panel DP. FIG. 18 illustrates only the display panel DP among laminated structures of the display module DM, but substantially, the display module DM may further include multiple components arranged on an upper side and a lower side of the display panel DP. The display panel DP may include a display area DA and a non-display area NDA corresponding to the display area DA and the non-display area NDA of FIG. 16 of the electronic device ED.

The display module DM may include a data driving controller DDC disposed on the non-display area NDA of the display panel DP. The data driving controller DDC may be directly manufactured in the form of a circuit chip and mounted on the non-display area NDA. However, embodiments of the disclosure are not limited thereto, and the data driving controller DDC may be mounted on a flexible circuit board electrically connected to the display panel DP.

The electronic module EM and the power supply module PSM may be arranged inside the hinge module EDC. Illustratively, FIG. 3 illustrates a state in which the electronic module EM and the power supply module PSM are exposed to the outside from the hinge module EDC. Although not illustrated, the electronic module EM and the power supply module PSM may be electrically connected to each other through a separate flexible circuit board. The electronic module EM may control an operation of the display device DD. The power supply module PSM may supply power to the electronic module EM.

The hinge module EDC may accommodate the display device DD, the electronic module EM, and the power supply module PSM. The hinge module EDC may include two first and second housings HS1 and HS2 for folding the display device DD. The first and second housings HS1 and HS2 may extend in the second direction DR2 and may be arranged in the first direction DR1.

The hinge module EDC may include a housing assembly HS. The housing assembly HS may include the first housing HS1 and the second housing HS2 spaced apart from each other in the first direction DR1 and a hinge housing HGH disposed between the first housing HS1 and the second housing HS2. The hinge module EDC may further include hinges HG1 and HG2 for connecting the first and second housings HS1 and HS2, multiple main plates, and multiple moving plates.

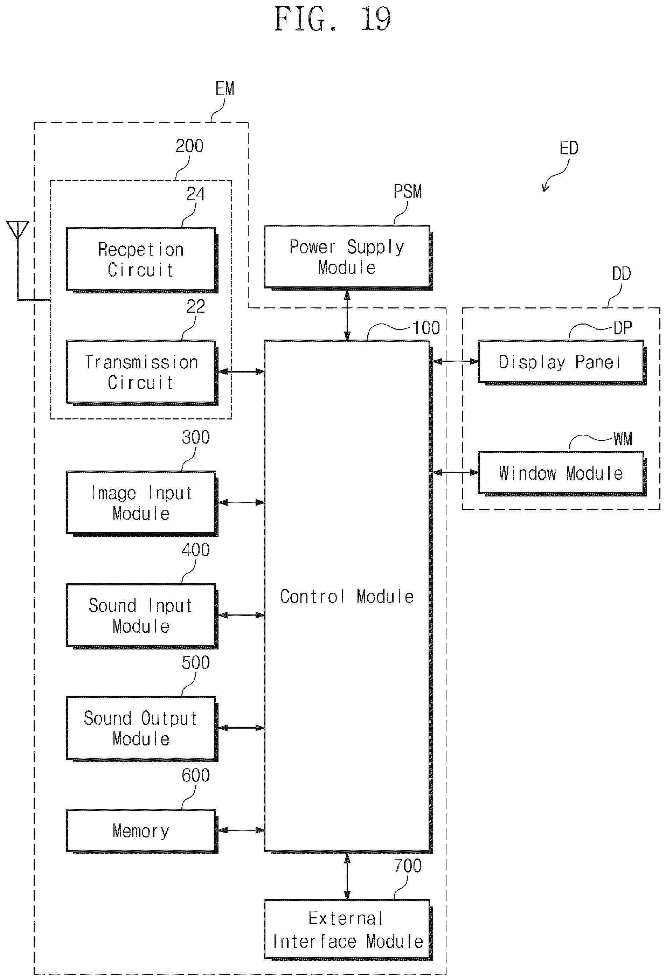

FIG. 19 is a schematic block diagram of the electronic device illustrated in FIG. 18.

Referring to FIG. 19, the electronic device ED may include the electronic module EM, the power supply module PSM, and the display device DD. The electronic module EM may include a control module 100, a wireless communication module 200, an image input module 300, a sound input module 400, a sound output module 500, a memory 600, an external interface module 700, and the like. The modules may be mounted on a circuit board or may be electrically connected through a flexible circuit board. The electronic module EM may be electrically connected to the power supply module PSM.

The control module 100 may control an overall operation of the electronic device ED. For example, the control module 100 may activate or deactivate the display device DD which includes a display panel DP and a window module WM in accordance with a user input. For example, the display panel DP and the window module WM may be electrically connected to the control module 100. The control module 100 may control the image input module 300, the sound input module 400, the sound output module 500, and the like in accordance with the user input. The control module 100 may include at least one microprocessor.

The wireless communication module 200 may transmit/receive a wireless signal to/from another terminal using a Bluetooth line or a Wi-Fi line. The wireless communication module 200 may transmit/receive a voice signal using a general communication line. The wireless communication module 200 may include a transmission circuit 22 for modulating and transmitting a signal to be transmitted, and a reception circuit 24 for demodulating a received signal.

The image input module 300 may process an image signal and convert the image signal into image data that may be displayed on the display device DD. The sound input module 400 may receive an external sound signal through a microphone in a recording mode or a voice recognition mode and convert the received external sound signal into electrical voice data. The sound output module 500 may convert sound data received from the wireless communication module 200 or sound data stored in the memory 600 and output the converted sound data to the outside.

The external interface module 700 may serve as an interface electrically connected to an external charger, a wired/wireless data port, and a card socket (e.g., a memory card, a subscriber identity module (SIM)/user interface model (UIM) card).

The power supply module PSM may supply power required for an overall operation of the electronic device ED. The power supply module PSM may include a general battery device.

The electronic device ED may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

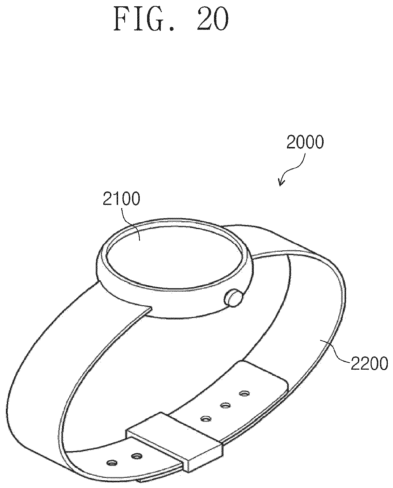

Referring to FIG. 20, the electronic device ED of FIG. 19 may be applied to a smart watch 2000 including a display unit 2100 and a strap unit 2200.

The smart watch 2000 may be a wearable electronic device. For example, the smart watch 2000 may have a structure in which the strap unit 2200 is mounted on a user's wrist. Here, electronic device ED may be applied to the display unit 2100, and image data including time information may be provided to a user.

As discussed, embodiments, can provide a display panel comprising: a driving element layer including a pixel driving portion; a first electrode disposed on the driving element layer; a pixel definition layer disposed on the driving element layer, and including an opening exposing at least a portion of the first electrode; an intermediate layer disposed on the first electrode, and including at least one light emission layer; a second electrode disposed on the intermediate layer; a low-adhesion layer disposed on the second electrode; a capping electrode disposed on the second electrode; and a separator disposed on the pixel definition layer, wherein at least a portion of the low-adhesion layer overlaps the opening of the pixel definition layer, and the capping electrode contacts a portion of the second electrode in an area spaced apart from the opening of the pixel definition layer.

The low-adhesion layer may include a material having a weak adhesion force with the capping electrode.

The low-adhesion layer may have low surface energy, and a metal growth may be suppressed on a surface of the low-adhesion layer.

The low-adhesion layer may includes a material on which metal growth is suppressed during a deposition process when compared to a metal layer. For example, the capping electrode may be formed by sputtering, and during the sputtering process, the material of the low-adhesion layer may be such that deposition of the capping electrode on the low-adhesion layer is suppressed or prevented.

The low-adhesion layer and the capping electrode may be formed through different deposition process methods. For example, the capping electrode may be formed by a deposition method capable of depositing a deposition material at a lower incident angle than that of a deposition method for forming the low-adhesion layer. The low-adhesion layer may be formed, for example, by a thermal evaporation method, and the capping electrode may be formed by a sputtering method.

In some embodiments, the capping electrode may not be formed on the upper surface of the low-adhesion layer, and thus, the capping electrode may not be disposed on the low-adhesion layer.

Alternatively, in some embodiments, the capping electrode may be formed on the upper surface of the low-adhesion layer. For example, the capping electrode may be formed as a very thin layer on the upper surface of the low-adhesion layer.

Embodiments, can provide a display panel comprising: a driving element layer including a pixel driving portion; and a light emitting element disposed on the driving element layer, wherein the light emitting element includes: a first electrode disposed on the driving element layer, and disposed at least in a light emission area; an intermediate layer disposed on the first electrode, at least including a light emission layer, and in which the light emission layer is disposed at least in the light emission area; a second electrode disposed on the intermediate layer, and disposed in the light emission area; a low-adhesion layer disposed on the second electrode, and disposed at least in the light emission area; and a capping electrode disposed on the second electrode, the capping electrode contacts a portion of the second electrode in an area spaced apart from the light emission area.

Embodiments can provide an electronic device comprising: a display panel folded or unfolded with respect to a folding axis extending in a first direction; an electronic module overlapping the display panel; and a housing accommodating the display panel, wherein the display panel is according to any one of the above discussed embodiments.

According to the above, the light emitting element and the pixel driving portion may stably contact each other to improve the contact reliability.

In the display panel of an embodiment, the cathode of the light emitting element and the connection electrode that is electrically connected to the pixel driving portion contact each other in an area that is adjacent to the separator provided for division of the pixels so that the contact reliability may be improved through electrical connection in a relatively wide area. In addition, because the capping electrode contacts the connection electrode together with the cathode in an area that is adjacent to the separator, pixel defects that cause a decrease in brightness may be reduced or prevented.

In the display panel of an embodiment, the cathode of the light emitting element may contract in an area that is adjacent to the tip portion of the connection line, which is electrically connected to the pixel driving part. Because the capping electrode contacts the cathode in an area that is adjacent to the tip portion of the connection line (or an area, in which the cathode is electrically connected to the connection line), pixel defects that cause a decrease in brightness may be reduced or prevented.

Although the disclosure has been described with reference to the embodiments, it will be appreciated by an ordinary skilled in the art, to which the disclosure pertains, that the disclosure may be modified and changed in the scope of the appended claims without departing from the technical field of the disclosure. Therefore, the technical scope of the disclosure should not be limited to the detailed description of the specification, but should be determined by the claims.

## Claims

1. A display panel comprising:
a driving element layer including a pixel driving portion;
a first electrode disposed on the driving element layer;
a pixel definition layer disposed on the driving element layer, and including an opening exposing at least a portion of the first electrode;
an intermediate layer disposed on the first electrode, and including at least one light emission layer;
a second electrode disposed on the intermediate layer;
a low-adhesion layer disposed on the second electrode;
a capping electrode disposed on the second electrode; and
a separator disposed on the pixel definition layer,
wherein at least a portion of the low-adhesion layer overlaps the opening of the pixel definition layer, and
the capping electrode contacts a portion of the second electrode in an area spaced apart from the opening of the pixel definition layer.

2. The display panel of claim 1, wherein the capping electrode is not disposed on an upper surface of the low-adhesion layer.

3. The display panel of claim 1 or 2, wherein the low-adhesion layer includes a fluorocarbon compound.

4. The display panel of any one of claims 1 to 3, wherein the capping electrode and the second electrode include a same material.

5. The display panel of any one of claims 1 to 4, wherein the capping electrode includes a metal or an alloy including at least one of silver, Ag, magnesium, Mg, palladium, Pd, and copper, Cu.

6. The display panel of any one of claims 1 to 5, further comprising:
a capping layer disposed on the low-adhesion layer,
wherein the capping layer covers at least a portion of the capping electrode.

7. The display panel of any one of claims 1 to 5, further comprising:
a capping layer disposed between the second electrode and the low-adhesion layer,
wherein the capping layer is spaced apart from the capping electrode.

8. The display panel of any one of claims 1 to 7, further comprising:
a connection electrode disposed on the pixel definition layer, and electrically connected to the pixel driving portion and the second electrode,
wherein in a contact area being adjacent to the separator, each of the second electrode and the capping electrode contacts an upper surface of the connection electrode;

9. The display panel of claim 8, wherein the connection electrode has a ring shape surrounding the opening of the pixel definition layer, and the contact area surrounds at least a portion of the opening of the pixel definition layer; optionally wherein the capping electrode has a ring shape surrounding the opening of the pixel definition layer, and the low-adhesion layer is surrounded by the capping electrode; and/or
wherein the connection electrode includes a plurality of connection electrodes, gaps between adjacent ones of the plurality of connection electrodes overlap the separator; and/or
wherein a through-hole spaced apart from the opening is defined in the pixel definition layer, and the connection electrode is electrically connected to the pixel driving portion through the through-hole.

10. The display panel of any one of claims 1 to 9, further comprising:
a connection line disposed between the driving element layer and the pixel definition layer, and electrically connected to the pixel driving portion and the second electrode,
wherein the connection line includes a first layer, a second layer disposed on the first layer, and a third layer disposed on the second layer, and
a portion of the third layer protrudes from the second layer to define a tip portion;
optionally wherein in an area being adjacent to the tip portion, the second electrode contacts a side surface of the second layer, and the capping electrode contacts the second electrode;
optionally further comprising: a capping pattern covering a side surface of the second layer in an area being adjacent to the tip portion, wherein in an area being adjacent to the tip portion, the second electrode contacts the capping pattern, and the capping electrode contacts the second electrode.

11. The display panel of any one of claims 1 to 10, wherein the intermediate layer further includes a functional layer including a first intermediate functional layer disposed on the first electrode, and a second intermediate functional layer disposed on the light emission layer, and
the light emission layer is disposed between the first intermediate functional layer and the second intermediate functional layer;
optionally further comprising: a first dummy layer disposed on the separator, separator, the first dummy layer and the functional layer including a same material; a second dummy layer disposed on the first dummy layer, the second dummy layer and the second electrode including a same material; and a third dummy layer disposed on the second dummy layer, the third dummy layer and the low-adhesion layer including a same material.

12. A display panel comprising:
a driving element layer including a pixel driving portion; and
a light emitting element disposed on the driving element layer,
wherein the light emitting element includes:
a first electrode disposed on the driving element layer, and disposed at least in a light emission area;
an intermediate layer disposed on the first electrode, at least including a light emission layer, and in which the light emission layer is disposed at least in the light emission area;
a second electrode disposed on the intermediate layer, and disposed in the light emission area;
a low-adhesion layer disposed on the second electrode, and disposed at least in the light emission area; and
a capping electrode disposed on the second electrode,
the capping electrode contacts a portion of the second electrode in an area spaced apart from the light emission area.

13. The display panel of claim 12, further comprising: a pixel definition layer disposed on the driving element layer, and in which an opening exposing at least a portion of the first electrode is defined; a connection electrode disposed on the pixel definition layer, electrically connected to the pixel driving portion and the second electrode, and including a first edge surrounding the light emission area and a second edge surrounding the first edge; and a separator disposed on the pixel definition layer, and overlapping the second edge of the connection electrode, wherein in a contact area being adjacent to the separator, each of the second electrode and the capping electrode contacts an upper surface of the connection electrode; or
further comprising: a pixel definition layer disposed on the driving element layer, and in which an opening exposing at least a portion of the first electrode is defined; a connection line disposed between the driving element layer and the pixel definition layer, and electrically connected to the pixel driving portion and the second electrode; and a separator disposed on the pixel definition layer, wherein the connection line includes a first layer, a second layer disposed on the first layer, and a third layer disposed on the second layer, wherein a portion of the third layer protrudes from the second layer to define a tip portion, and in an area being adjacent to the tip portion, the second electrode contacts a side surface of the second layer, and the capping electrode contacts the second electrode.

14. An electronic device comprising:
a display panel folded or unfolded with respect to a folding axis extending in a first direction;
an electronic module overlapping the display panel; and
a housing accommodating the display panel,
wherein the display panel is according to any one of claims 1 to 13.

15. The electronic device of claim 14, wherein the electronic device is at least one of: a smart watch; a mobile phone; a smartphone; a portable computer; a tablet personal computer, PC; a watch phone; an automotive display; a smart glass; a portable multimedia player, PMP; a navigation system; an ultra-mobile computer, UMPC; a head mounted display, HMD, device; a virtual reality, VR, device; a mixed reality, MR, device; and an augmented reality, AR, device.
